# EUROPÄISCHE PATENTSCHRIFT

(11) **EP 0 890 242 B1**
(45) Veröffentlichungstag und Bekanntmachung des Hinweises auf die Patenterteilung: **02.07.2003**
(21) Anmeldenummer: 96939842.9
(22) Anmeldetag: 19.11.1996
(51) Int. Cl.: H04L 12/40, H04L 12/26, B60R 16/02

(54) **VERFAHREN ZUR BESTIMMUNG VON POTENTIALVERSCHIEBUNGEN ZWISCHEN ELEKTRONIKMODULEN IN EINEM DRAHTBUSNETZ ODER DER ÜBEREINSTIMMUNGSGÜTE IHRER KOMMUNIKATIONSBETRIEBSPEGEL, UND VORRICHTUNG ZUR DURCHFÜHRUNG DES VERFAHRENS**
PROCESS FOR DETERMINING POTENTIAL SHIFTS BETWEEN ELECTRONIC MODULES IN A WIRE BUS NETWORK
PROCEDE POUR DETERMINER DES DECALAGES DE POTENTIEL ENTRE MODULES ELECTRONIQUES D'UN RESEAU A BUS FILAIRE

(30) Priorität: 26.03.1996 DE 19611944
(43) Veröffentlichungstag der Anmeldung: 13.01.1999
(73) Patentinhaber: DaimlerChrysler AG, 70567 Stuttgart (DE)
(72) Erfinder: HANF, Peter, D-73035 Göppingen (DE); MINUTH, Jürgen, D-73054 Eislingen (DE); SETZER, Jürgen, D-75428 Illingen (DE); REEB, Max, D-73066 Uhingen (DE)
(86) Internationale Anmeldenummer: EP9605088
(87) Internationale Veröffentlichungsnummer: WO97036399

(56) Entgegenhaltungen:
- WO-A-90/08437
- WO-A-90/09713
- DE-A- 4 327 035
- DE-C- 4 342 036

## Beschreibung

Die Erfindung bezieht sich auf ein Verfahren zur Bestimmung von Potentialverschiebungen zwischen Elektronikmodulen in einem Drahtbusnetz oder der Übereinstimmungsgüte ihrer Kommunikationsbetriebspegel im Netzverbund, sowie auf eine Vorrichtung zur Durchführung des Verfahrens.

Es gewinnen zunehmend Steuerungstechniken an Bedeutung, die sich auf einen einfachen Draht-Bus als Kommunikationsmedium stützen. Bekannt gewordene Beispiele hierfür sind Busnetze nach J1850- oder-CAN-Standard, die sich auf ein zweidrähtiges Busmedium stützen. Dabei kommuniziert eine Vielzahl von elektronischen Steuergeräten über zwei normalerweise gegenphasig dominant getasteten Leiteradern miteinander.

In diesem Zusammenhang beschreibt die **WO 90/08437** eine Ankopplung eines mindestens ein Sende- und/oder ein Empfangsteil aufweisenden Teilnehmers eines lokalen Netzwerks insbesondere eines Kraftfahrzeugs an einen derartigen Datenbus mit zwei Busleitungen. Diese Ankopplung ist so ausgebildet, daß an den Eingangsklemmen eines Teilnehmers Potentiale auftreten, anhand derer auch bei einem Kurzschluß einer der Busleitungen gegen Masse, gegen die Batteriespannung oder gegen die andere Busleitung bzw. bei Unterbrechung einer der Busleitungen mit Sicherheit die auf dem Datenbus vorhandenen Daten erkannt werden können.

Die **WO 90/09713** beschreibt eine Netzwerkschnittstelle eines Computer-Netzwerks, insbesondere für ein Kraftfahrzeug, mit mindestens zwei Busleitungen, wobei sich das Netzwerk durch eine den Busleitungen und einer Bezugsspannung zugeordnete Fehlererkennungsschaltung auszeichnet, welche bei einer Unterbrechung oder bei einem Kurzschluß einer der beiden Busleitungen nach Masse oder gegen eine Versorgungsspannung des Computer-Netz-werks ein auf der anderen, intakten Busleitung eintreffendes Signal auswertet und zur Aktivierung der Netzwerkschnittstelle ein Wake-up-Signal abgibt.

Die **DE 42 27 035 A1** beschreibt eine Anordnung zur bidirektionalen Datenübertragung auf einem Zweidraht-Bus-System, welche bei Auftreten einer Vielzahl von Leitungsstörungen im Eindraht-Betriebsmodus funktioniert und dabei Verlustleistungen auch bei Kurzschluß einer Datenleitung gegen eine hohe Batteriespannung verhindert.

Die **DE 43 42 036 C1** beschreibt ein Datenbussystem mit einem seriellen, mit komplementären Logiksignalen betriebenen Datenbus, wobei das System mehrere über die Busleitungen miteinander kommunizierende Teilnehmer jeweils mit busankoppelnden Endstufen aufweist. Bestandteil der Endstufe jedes Busteilnehmers ist ein Busabschlußnetzwerk, wobei dieses bei mindestens einer Endstufe niederohmig, aktiv, schaltbar und intern umschaltbar ausgebildet ist, während das Busabschlußnetzwerk bei minestens einer weiteren Endstufe passiv und niederohmig ausgebildet ist, während es bei allen übrigen Endstufen passiv und hochohmig ausgebildet ist.

Bekannt wurden auch Busnetze, die eine einzige Leitungsader über einer in der Regel auch als Stromversorgungsleiter dienenden Sammelschiene oder Sammelfläche als Busmedium nutzen. Die Kommunikation geschieht in jedem Falle durch Sende-/Empfangsmittel - sog. Bus-Transceiver - die als wesentlicher Bestandteil eines jeden Gerätes dasselbe jeweils physikalisch an das Busmedium ankoppeln. Diese Transceiver zum Senden und Empfangen der Datenbotschaften wandeln letztere vom Logikpegel innerhalb des betreffenden Busteilnehmers in Signalpegel auf der bzw. den Busader/n um und umgekehrt.

Bezüglich verschiedener, im Rahmen der vorliegenden Erfindung relevanter Merkmale eines geeigneten Bus-Transceivers wird ausdrücklich auf die **DE 196 11 944 A1** verwiesen, auf deren Inhalt hier vollumfänglich Bezug genommen wird.

Die Busteilnehmer erfüllen ihre (z.B. Steuerungs-)Aufgabe durchweg mittels eines mehr oder weniger leistungsfähigen Microcontrollers. Für die Kommunikation über den Bus ist eine Protokoll-Funktionen vorgesehen, die bei für derlei Anwendungen spezialisierten Microcontrollern schon monolithisch mitintegriert sein kann.

Im Interesse eines hohen Störabstandes werden bei Systemen in störungskritischer Umgebung bevorzugt zweidrähtige Busmedien verwendet, da eindrähtige über einer Bezugsleiterfläche empfindlicher gegen elektromagnetische Störein- und abstrahlung sind und schon deshalb bei nur geringer Datenrate verwendbar sind. Andererseits können Zweidrahtbusnetze bei geeigneter Beschaffenheit ihrer Transceiver auch im vorgenannten Eindraht-Betriebsmode - d.h. eine Busader gegenüber einem netzweit verfügbaren Bezugspegel - ggfs. mit geringerer Datenrate (not-) betrieben werden. In solchen Netzwerken geschieht die normale Kommunikation überwiegend durch gegenphasige Umtastung der beiden Leitungsaderpotentiale von einem rezessiven auf einen dominanten Signalpegel. Durch diese Maßnahme und durch insgesamt relativ niedrige Signalpegel absolut gesehen kann die Störstrahlung entsprechender Busnetze relativ niedrig gehalten werden auch dann, wenn sie unabgeschirmt vorgesehen und mit sehr kurzen Busbitzeiten betrieben werden. Die Verwendbarkeit einer ungeschirmten zweiadrigen Leitung als Busmedium ist bei vielen Anwendungen die Voraussetzung sowohl für Kostengünstigkeit als auch ausreichende Systemverfügbarkeit unter rauhen Betriebsbedingungen. Letzteres ist ohne weiteres verständlich wenn man bedenkt, daß in einem abgeschirmten Bussystem schon Übertragungsstörungen auftreten können, wenn das Abschirmnetz einen Fehler aufweist, d.h wenn an den zur Signalübertragung eigentlich dienenden Busadern und deren Vernetzung noch gar kein Fehler vorliegt. Einem nicht auf eine Abschirmung gestützten Zweidraht-Bussystem fehlt zwangsläufig diese Fehlermöglichkeit. Auch in Eindrahtnetzen geschieht die Kommunikation in der Regel durch Umtastung der Busader von einem rezessiven auf einen dominanten Signalpegel gegenüber der Bezugsleiterfläche. Die Erfindung ist bezüglich ein- und zweidrähtigen Busnetzen gleichermaßen nützlich.

Durch besondere Schaltungsmaßnahmen müssen sowohl bei eindrähtigen als auch zweidrähtigen Bussystemen die oben genannten Signalpegel innerhalb gewisser Toleranzfenster gehalten werden, damit eine störungsfreie Signalübertragung zwischen den Bus-Transceivern möglich ist.

Diesbezüglich wird in der Regel ausgenutzt, daß sowohl der Microcontroller als auch die Busprotokollfunktion eine innerhalb enger Grenzen zu haltende Betriebsspannung erfordern, die in der Regel mittels eines vom Steuergerät mitumfaßten Spannungsreglers aus einem übergeordneten Potential abgeleitet wird. Von dieser relativ genauen Betriebsspannung ist dann der (eine der beiden) im Sendefalle dominante(n) Quellenpegel, von dem aus der (jeweiligen) Busader auf rezessivem Pegel Daten gewissermaßen "aufgetastet" werden, bestimmt.

Beispielsweise ist in einem Zweidraht-Busnetz nach CAN-Standard der derzeit spezifizierte dominante High-Pegel von 5 Volt abgeleitet aus der über lange Zeit gängigen Versorgungsspannung von 5 Volt für integrierte Schaltkreisfunktionen in Steuergeräten, die in jedem Gerät ohnehin mittels elektronischer Regelungsmittel relativ genau konstant zu halten ist.

Die Transceiver sind so ausgeführt, daß sie die entsprechenden Pegelwandlungen der Datenbotschaften auch dann fehlerfrei durchführen, wenn die Bezugspegel der Transceiver gegeneinander gewisse zulässige, aber einen maximalen Wert jeweils nicht übersteigende Potentialdifferenzen gegeneinander haben.

Übertragungsprobleme treten in einem vorgenannten Ein- oder Zweidraht-Busnetz zwangsläufig auf, wenn die Übereinstimmung (innerhalb spezifizierter Toleranzbänder) des/der sendemäßig auf der Busader/den Busadern dominant sich einstellenden Buspegel/s und/oder des/der empfangsmäßig darauf abgestimmt wirksamen Diskriminationspegel/s zur Wahrheitsbewertung von Signalflanken und -zuständen im Busmedium leidet bzw. sich so weit verschlechtert, daß die o.e. maximalen Werte überschritten werden. Eine ausreichende Übereinstimmung der genannten Pegel erscheint insoweit zugleich als wesentliches Maß einer definierbaren Busgüte, in die freilich auch noch andere Aspekte wie z.B. die Flankenanstiegsübereinstimmung zwischen Sender und Empfänger (Slewrate Compliance), das Überschwingungsdämpfungsmaß etc. einfließen.

Ein Spezialfall von vorgenannten Buspegelstörungen sind lokal teilnehmerinduzierte Potentialstörungen. Solche treten auf, wenn ein Versorgungspotential aller Busteilnehmer von einer gemeinsamen, d.h. räumlich ausgedehnten Stromschiene oder -fläche bezogen wird, innerhalb dieser jedoch ein fehlerhafter Spannungsabfall auftritt, so daß das betroffene Versorgungspotential - vom Busmedium aus gesehen - gar nicht mehr für alle Busteilnehmer gleich ist.

Im beispielhaften Falle eines Steuergerätes in einem Verkehrsmittel, bei dem die gesamte Karosse bekanntlich als Verteilungsleiterfläche ("Masse") dient, kann derlei durch einen fehlerhaften Längsspannungsabfall in dieser Fläche oder eine fehlerhafte Masseverbindung eines Steuergerätes als Busteilnehmer sein, welche unter Beaufschiagung mit dem normalen Massestrom des betreffenden Gerätes einen zu großen Spannungsabfall und insoweit eine Anhebung des Massebezugspotentials des betroffenen Gerätes gegenüber den Massepotentialen übriger Geräte im Busnetz bewirkt. Infolgedessen kann ein solches Steuergerät dann über den Bus gar nicht mehr ansprechbar sein, weil durch die Massefußpunkt-Fehlerspannung das Diskriminationspegelfenster seines an sich fehlerfreien Bus-Empfängers gegenüber anderen zu weit angehoben sein kann. Für die Wartungs- und Instandsetzungspraxis entsprechender Busnetze ist insoweit sehr wichtig, das Vorliegen entsprechender Potentialverschiebungen erkennen und diese bestimmen zu können.

Es ist daher Aufgabe der Erfindung, ein Verfahren zur Bestimmung von Potentialverschiebungen zwischen Elektronikmodulen in einem Drahtbusnetz oder der Übereinstimmungsgüte ihrer Kommunikationsbetriebspegel im Netzverbund anzugeben. Weiter ist es Aufgabe der Erfindung, eine Vorrichtung zur Durchführung des Verfahrens vorzuschlagen.

Die erste Aufgabe wird durch ein Verfahren gemäß Anspruch 1 gelöst.

Verfahrensgemäß wird in wenigstens einem Busteilnehmer (Prüfteilnehmer), bei dem es sich um einen normalerweise am Bus liegenden oder aber um einen nur temporär an den Bus angeschlossenen Teilnehmer wie z.B. ein Prüfgerät im Werkstattsinne handeln kann, sendeseits ein Spannungsversatz - im folgenden als Offsetspannung bezeichnet - zu wenigstens einem der beiden dominanten, normalen Quellenpegel addiert und vom Prüfteilnehmer in diesem Zustand eine Prüf-Botschaft ins Busnetz gesendet. Dabei wird der Quellenpegel in vorbestimmter Weise verändert.

Je nachdem, ob der (wenigstens) eine (der beiden) dominante(n) Quellenpegel durch die jeweils einstellbare Offsetspannung abgesenkt oder angehoben wird, verliert oder gewinnt der (bezugs-)potentialfehlerhafte Busteilnehmer seine Empfangsfähigkeit.

Bei schrittweise monotoner Veränderung besagter Offsetspannung kann der (bezugs-)potentialfehlerhafte Busteilnehmer im ersten Falle als erster von allen Busteilnehmern die Prüf-Botschaft nicht mehr (richtig) empfangen und folglich auch nicht mehr als fehlerfrei quittieren, und im zweiten Falle als erster von allen Busteilnehmern (richtig) empfangen und quittieren. Die übrigen Busteilnehmer werden dabei in einen/m nicht sendefähigen Status (RECEIVE ONLY) versetzt bzw. gehalten.

Um denjenigen Busteilnehmer, bei dem busnetzweit die größte bezugspotentialverfälschende Fehlerspannung auswirksam ist, zu lokalisieren, wird also verfahrensgemäß in einem (stimulierenden) Busteilnehmer z.B. ein dominantes H-Potential ausgehend von einem höheren Wert verringert, bis einer der Busteilnehmer den (stimulierenden) Prüfteilnehmer nicht mehr empfangen kann. Bei dem die Empfangsfähigkeit verlierenden Busteilnehmer handelt es sich dann um denjenigen, der aktuell den größten Bezugsspannungsfehler im Netz aufweist. Oder es wird z.B. wenigstens ein dominantes L-Potential ausgehend von einem gegenüber seinem normalen Wert überhöhten Wert verringert, bis ein Busteilnehmer den (stimulierenden) Busteilnehmer empfangen kann. Bei diesem Empfangsfähigkeit erlangenden Teilnehmer handelt es sich dann bereits um denjenigen, der den größten Bezugsspannungsfehler im Netz aufweist.

Durch diese verfahrensgemäße Maßnahme kann also nicht nur der fehlerspannungsbeeinträchtigte Busteilnehmer, sondern aus der bei dessen verschwindender bzw. einsetzender Empfangsfähigkeit erreichte Offsetspannung ein Maß für die Größe des bei diesem Busteilnehmer vorliegenden Bezugsspannungsfehlers gefunden werden.

Vorteilhafte Weiterbildungen sind gemäß Lehre der abhängigen Ansprüche 2 bis 16 möglich.

Die zweite Aufgabe der Erfindung wird durch eine Vorrichtung mit Mitteln zur Durchführung der Schritte eines Verfahrens nach Anspruch 1 gemäß Anspruch 17 gelöst.

Demnach ist die Vorrichtung zur Bestimmung von Potentialverschiebungen zwischen Elektronikmodulen in einem Drahtbusnetz oder der Übereinstimmungsgüte ihrer Kommunikationsbetriebspegel im Netzverbund geeignet. Dabei besteht das Busmedium aus wenigstens einem Draht und die Elektronikmodule sind galvanisch mit dem Busmedium und ferner über eine Potentialschiene untereinander verbunden, wobei diese Potentialschiene im Falle eindrähtiger Betriebsweise des Busmediums als Bezugspotentialschiene für die Buskommunikation dient, und wobei jedes Elektronikmodul einen Mikroprozessor oder Microcontroller sowie Mittel zur Verwirklichung einer Sende- und Empfangskopplung des Mikroprozessors oder Microcontrollers an das Busmedium umfasst.

Erfindungsgemäß umfasst die Vorrichtung als Bestandteil der Transceiver-Mittel Mittel zur Sperrung der Sendemittel bei Empfangsbetrieb sowie mit dem Mikroprozessor oder Microcontroller in Verbindung stehende und mit den Transceiver-Mitteln verbundene oder verbindbare, kooperative Potentialsteuermittel und mit diesen in Bezug auf Teile der Sende- und/oder Empfangsmittel der Transceiver-Mittel zahlenmäßig wenigstens eine steuerbare Spannungsquelle verwirklicht, die zahlenmäßig wenigstens einen im Sendefall dominanten Quellenpegel und/oder zahlenmäßig wenigstens einen im Empfangsfall diskriminanten Signalpegel zu beeinflussen erlaubt.
- Gemäß Anspruch 18 sind die Potentialsteuermittel von einem Mikroprozessor oder Microcontroller digital ansteuerbar.
- Gemäß Anspruch 19 sind die Potentialsteuermittel so beschaffen, daß beim Senden wenigstens ein Quellenpegel, der den dominanten Zustand auf dem betreffenden Busdraht bestimmt, monoton wenigstens in- und/oder dekrementell verschoben werden kann.
- Gemäß Anspruch 20 sind bei Beeinflußbarkeit von zwei im Sendefalle dominanten Quellenpegeln beide voneinander unabhängig einstellbar oder veränderbar.
- Gemäß Anspruch 21 sind zwei im Sendefalle dominante Quellenpegel so einstellbar oder verschiebbar, daß dabei der Abstand beider Pegel im wesentlichen beibehalten bleibt.
- Gemäß Anspruch 22 weist die Vorrichtung einen signaldedizierten Anschluß als Bezugspotentialschiene wenigstens der Empfangsmittel der Transceiver-Funktion auf.
- Gemäß Anspruch 23 umfaßt die Vorrichtung einen besonderen Anschluß als Bezugspotentialschiene wenigstens der Mittel zur Einstellung oder Veränderung beim Senden wenigstens einer der beiden dominarten Quellenpegel.
- Gemäß Anspruch 24 weist die Vorrichtung einen besonderen Anschluß auf, über welchen die Potentialsteuermittel mit einem Bezugspotential im Umfeld des die Transceiver-Funktion tragenden Elektronikmoduls wirkverbindbar sind.
- Gemäß Anspruch 25 umfaßt die Vorrichtung in dem Pfad besagter Wirkverbindung Schutzmittel gegen Überspannung und/oder Falschpolung und/oder hochfrequente Signaleinspeisung.
- Gemäß Anspruch 26 realisiert die Vorrichtung eine in den bezugspotentialnahen Versorgungsanschluß der Sendemittel eingeschleifte, einstellbare Offset-Spannungsquelle und stromversorgt die Sendemittel mit einer konstanten Spannung.
- Gemäß Anspruch 27 sind den konstantspannungsversorgten Sendemitteln wenigstens analog wirkende Teile der Empfangsmittel stromversorgungsmäßig parallel geschaltet und besagte Offset-Spannungsquelle ist somit auch empfangsseitig wirksam.
- Gemäß Anspruch 28 realisiert die Vorrichtung eine in den bezugspotentialnahen Versorgungsanschluß der den Busdraht BUS_L ansteuernden Schaltendstufe der Sendemittel eingeschleifte erste einstellbare Offset-Spannungsquelle und eine in einen potentialmäßig entgegengesetzten Versorgungsanschluß der den Busdraht BUS_H ansteuernden Schaltendstufe der Sendemittel eingeschleifte zweite einstellbare Offset-Spannungsquelle.
- Gemäß Anspruch 29 realisiert die Vorrichtung eine in den bezugspotentialnahen Versorgungsanschluß der den Busdraht BUS_L ansteuernden Schaltendstufe der Sendemittel eingeschleifte erste einstellbare Offset-Spannungsquelle und eine in einen potentialmäßig entgegengesetzten Versorgungsanschluß der den Busdraht BUS_H ansteuernden Schaltendstufe der Sendemittel eingeschleifte zweite und dritte einstellbare Offset-Spannungsquelle, wobei letztere auf unterschiedlich hohe Versorgungspotentiale bezogen oder an unterschiedlich hohe Versorgungspotentiale angeschlossen sind.
- Gemäß Anspruch 30 sind die zweite und dritte Offset-Spannungsquelle alternativ aktivierbar.
- GemäB Anspruch 31 sind die bezugspotentialbezogene Offset-Spannungsquelle (Q_{SL}) und die wirksame, bezugspotentialferne Offset-Spannungsquelle nur in zeitlicher Aufeinanderfolge abwechselnd aktivierbar.
- Gemäß Anspruch 32 umfaßt die Vorrichtung Mittel, welche eine Wirksamschaltung der zweiten und dritten Offset-Spannungsquelle in Abhängigkeit vom Sendesignal erlauben.
- Gemäß Anspruch 33 umfassen die Potentialsteuermittel Mittel zur autonomen Veränderung der Einstellung wenigstens einer Offset-Spannungsquelle über der Zeit.
- Gemäß Anspruch 34 ist diese Veränderung in Abhängigkeit vom sendeseitigen Datensignal möglich.
- Gemäß Anspruch 35 ist den Mitteln zur autonomen Veränderung der Einstellung wenigstens einer Offset-Spannungsquelle ein von dem Mikroprozessor oder Microcontroller beziehbares Taktsignal zuführbar.
- Gemäß Anspruch 36 umfassen die Potentialsteuermittel Regelungsmittel, welche es erlauben, die Potentialsteuerung nach Maßgabe durch eine von dem Mikroprozessor oder Microcontroller empfangbare Wertvorgabe in Abhängigkeit von einem an einem Busdraht abnehmbaren Potential vorzunehmen.
- Gemäß Anspruch 37 umfaßt die Vorrichtung - unabhängig von den Sendemitteln - mit wenigstens einem Busdraht verbundene oder verbindbare Ersatzmittel, welche eine durch das Sendesignal getastete Aufschaltung auf den wenigstens einen Busdraht eines geregelten Potentials erlauben.
- Gemäß Anspruch 38 umfaßt die Vorrichtung Meßmittel, welche die Erfassung einer durch die Ersatzmittel verursachten Fehlergröße zum Zwecke ihrer Kompensation durch Regelaufschaltung oder rechnerische Berücksichtigung bei der Sollwertvorgabe für die Regelung durch den Mikroprozessor oder Microcontroller leisten.
- Gemäß Anspruch 39 umfaßt die Vorrichtung - unabhängig von den Sendemitteln - mit wenigstens einem Busdraht verbundene oder verbindbare Ersatzmittel, umfaßt, über welche eine durch das Sendesignal getastete Aufschaltung auf den Busdraht eines nicht geregelten Potentials nach Maßgabe durch einen von dem Mikroprozessor oder Microcontroller vorgebbaren Digitalwert möglich ist.
- Gemäß Anspruch 40 ist zwecks Leitendsteuerung eines der Ersatzmittel diesem das Sendesignal von der betreffenden Aderendstufe über einen Umschalter zuführbar, der ggfs. die Endstufe von dem Busdraht trennt.
- Gemäß Anspruch 41 umfassen die Regelungsmittel einen mit einem Busdraht wirkverbundenen Sampler und ein Halteglied oder einen haltenden Regler.
- Gemäß Anspruch 42 handelt es sich bei dem Sampler um einen solchen mit zwei Diodenstrecken, wobei die zweite Diodenstrecke zur Kompensation von Temperatureinflüssen und/oder einer abtaststromflußbedingten Fehlerspannung längs der ersten Diodenstrecke vorgesehen bzw. wirksam ist.
- Gemäß Anspruch 43 sind die Potentialsteuermittel so beschaffen, daß sie die Beeinflussung wenigstens eines rezessiv diskriminanten Signalpegels durch Beeinflussung wenigstens einer Schwellenspannung im Empfänger erlauben.
- Gemäß Anspruch 44 weist die Vorrichtung für die kooperativen Empfangsmittel auf eine Bezugspotentialschiene bezogene Mittel zur Vorgabe zweier Schwellwerte auf, wobei diese Bezugspotentialschiene mit einem Bezugspotentialanschluß wirkverbunden oder wahlweise wirkverbindbar (S7) ist mit wenigstens zwei alternativen Bezugspotentialanschlüssen des Elektronikmoduls.
- Gemäß Anspruch 45 ist die empfangsseitige Beeinflussung gemäß Anspruch 16 durch eine in dem bezugspotentialnahen Versorgungsstrompfad wenigstens analog wirkender Teile der Empfangsmittel liegende, einstellbare Offset-Spannungsquelle möglich.
- Gemäß Anspruch 46 ist die Bezugspotentialschiene der Schwellwertvorgabemittel mit dem bezugspotentialnahen Versorgungsfußpunkt wenigstens der analog wirkenden Teile der Empfangsmittel verbindbar.
- Gemäß Anspruch 47 weisen die Empfangsmittel auf einen Versorgungsfußpunkt bezogene Pegeldiskriminationsmittel auf, wobei dieser Versorgungsfußpunkt wirkverbunden ist mit einem Bezugspotentialanschluß oder wahlweise wirkverbindbar ist mit wenigstens zwei alternativen Bezugspotentialanschlüssen des Elektronikmoduls.
- Gemäß Anspruch 48 umfaßt die Vorrichtung Digital/Analog-Wandlungsmittel und/oder Analog/Digital-Wandlungsmittel.
- Gemäß Anspruch 49 umfaßt die Vorrichtung Digital/Analog-Wandlungsmittel, die wenigstens sämtliche Bezugswerte, Steuer- und Schaltsignale für allfällig im Sende- und/oder Empfangsbetrieb der Transceiver-Funktion vorzunehmenden Potentialbeeinflussungen zu erzeugen vermögen.
- Gemäß Anspruch 50 kann in der Vorrichtung eine auf ein höheres Versorgungspotential bezogene Offset-Spannungsquelle auch durch eine auf ein niedrigeres Versorgungspotential bezogene, entsprechend offsetfähig variable Versorgungsspannungsquelle ersetzt sein.
- Gemäß Anspruch 51 ist die Vorrichtung Bestandteil eines Elektronikmoduls, welches für nur eindrähtigen Empfang und/oder nur eindrähtige Sendeweise (mit nur einem Leitungstreiber) ausgebildet, beschaltbar oder ansteuerbar ist.
- Gemäß Anspruch 52 handelt es sich bei dem Elektronikmodul um einen integrierter Halbleiterschaltkreis.
- Gemäß Anspruch 53 ist die Vorrichtung Bestandteil eines integrierten Halbleiterschaltkreises, welcher außer der Vorrichtung wenigstens besagte Mittel zur Verwirklichung der Transceiver-Funktion für den Mikroprozessor oder Microcontroller an das Busmedium trägt.
- Gemäß Anspruch 54 ist die mit der Vorrichtung kooperative Transceiver-Funktion für eine Kommunikation nach CAN-Standard und zum Anschluß an ein CAN-Busleitungsnetz (CAN_H/CAN_L) ausgebildet.
- Gemäß Anspruch 55 umfaßt die Transceiver-Funktion Empfangsmittel mit wenigstens einem Eingang zum Anschluß wenigstens eines Busdrahtes und einen Ausgang zum Anschluß an den Empfangseingang des Mikroprozessors oder Microcontrollers, und Sendemittel mit einem Eingang zum Anschluß an den Sendeausgang des Mikroprozessors oder Microcontrollers und wenigstens einem Ausgang zum Anschluß an wenigstens einen Busdraht, wobei die Transceiver-Funktion wenigstens in den zwei verschiedenen Betriebsarten "Senden und Empfang / NORMAL" und "kein Senden - nur Empfang / RECEIVE ONLY" betreibbar ist und einen Eingangsport zum Empfang eines Selektionssignales des Mikroprozessors oder Microcontrollers zur Auswahl einer dieser wenigstens zwei Betriebsarten aufweist.
- Gemäß Anspruch 56 umfaßt die Transceiver-Funktion Empfangsmittel mit zwei Eingängen zum Anschluß an die beiden Busdrähte und einem Ausgang zum Anschluß an den Empfangseingang des Mikroprozessors oder Microcontrollers und Sendemittel mit einem Eingang zum Anschluß an den Sendeausgang des Mikroprozessors oder Microcontrollers und zwei Ausgängen zum Anschluß an die beiden Busdrähte, des weiteren Mittel, die beim Auftreten eines die normale Kommunikationsweise über beide Busdrähte beeinträchtigenden Busfehlers sowohl die Empfangsmittel als auch die Sendemittel für die beste noch bestehende Möglichkeit einer Notkommunikation über den Bus einzustellen und/oder umzukonfigurieren und/oder zu adaptieren vermögen, des weiteren Busfehler-Erkennungsmittel und Busfehler-Auswertungsmittel zur Aufbereitung wenigstens eines an den Microcontroller abgebbaren Fehler- oder Unterbrechungssignals, sowie mit den Busfehler-Erkennungsmitteln kooperative Bus-Abschluß-Umschaltmittel, die jedes von zwei an zwei Eingängen der Transceiver-Funktion anschließbaren Abschlußelementen an einen ihm zugeordneten Busdraht anzuschalten vermögen.
- Gemäß Anspruch 57 sind die wesentlichen Teile der Vorrichtung in einem mobilen Prüfgerät angeordnet, das einerseits mit wenigstens einem Busdraht und andererseits mit wenigstens einem Abschlußwiderstand im Elektronikmodul und dem Ausgang wenigstens einer Sendeendstufe der Transceiver-Funktion des Elektronikmoduls verbindbar ist.
- Gemäß Anspruch 58 umfaßt die Vorrichtung wenigstens einen Umschalter, mittels dessen die wenigstens eine Endstufe der Sendemittel des Elektronikmoduls wahlweise mit dem wenigstens einen Busdraht oder mit wenigstens einem entsprechenden Ansteuereingang eines Ersatzmittels verbindbar ist.
- GemäB Anspruch 59 ist der die Vorrichtung tragende integrierte Halbleiterschaltkreis in einer Hochvolt-Technologie hergestellt.
- Gemäß Anspruch 60 ist die Vorrichtung verwendbar bei und insoweit ausgebildet in oder bei einem der folgenden: Verkehrsmittel, Baumaschine, Hebezeug, Steuergerät der Automatisierungstechnik, Steuergerät der Elektroinstallationstechnik, Steuergerät der Gebäudetechnik, Steuergerät der Heizungstechnik, Steuergerät der Klimatechnik, Steuergerät der Alarmtechnik, Steuergerät der Sicherheitstechnik, Steuergerät der Zugangskontrolltechnik.

Mehrere Ausführungsbeispiele sind in der Zeichnung dargestellt und werden nachfolgend erläutert. Das erfindungsgemäße Verfahren und die erfindungsgemäß vorgeschlagenen Vorrichtungen bzw. deren Elemente sind sowohl in eindrähtig als auch zweidrährig betriebenen Busnetzen anwendbar. Wenn in der Zeichnung und darauf bezogenen Beschreibung nachfolgend ein zweidrähtiges Busnetz - in Anlehnung an den z.B. CAN-Standard - zur Verständlichmachung und Funktionalität herangezogen wird, so stellt dies keinesfalls eine Einschränkung der Erfindung auf zweidrähtige Bussysteme dar, sondern dient allein der Text- und Wiederholungsvermeidung und somit der Übersichtlichkeit.

Um das Verfahren verständlich zu machen werben zunächst einige einfachere Vorrichtungen erläutert, die zweckmäßig für "once-at-a-time" eindrähtige Tests sind. In anschließenden Figuren wird auf das Verfahren Bezug genommen. In abschließenden Figuren sind weiterreichende Vorrichtungen dargestellt, die auch für "once-at-a-time" zweidrähtige Tests geeignet sind, eine höhere Prüfmächtigkeit erlauben und beispielsweise mit Mitteln der Halbleiterintegration gut herstellbar sind. Es zeigen
- **Fig. 1**: eine blockschematische Veranschaulichung einer erfindungsgemäßen Vorrichtung in Form eines Simulationsmoduls in Verbindung mit einem zweidrahtbusfähigen elektronischen Gerät;
- **Fig. 2**: ein Funktionsblockschaltbild eines Simulationsmoduls, eine Offset-Spannungsquelle Q_{SG} bildend;
- **Fig. 3**: ein schematisches Wirkschaltbild eines entsprechenden Moduls, das eine digitale Einstellung einer Offsetspannung V_{SG} erlaubt;
- **Fig. 4**: ein schematisches Wirkschaltbild eines Vorrichtungsteils, der eine digitale Erfassung eines Spannungsoffsets erlaubt;
- **Fig. 5**: ein erstes Diagramm zur Veranschaulichung von sende- und empfangsmäßigen Pegelverschiebungen im Hinblick auf die Eindraht-Empfangsfähigkeit;
- **Fig. 6**: ein zweites Diagramm zur Veranschaulichung von sende- und empfangsmäßigen Pegelverschiebungen im Hinblick auf die Eindraht-Empfangsfähigkeit;
- **Fig. 7**: eine graphische Veranschaulichung der Empfangsfähigkeit eines Busteilnehmers über einer rampenförmigen Potentialverschiebung im Zuge der Durchführung des Verfahrens;
- **Fig. 8**: ein exemplarisches Zustandsdiagramm eines Busteilnehmers im Zuge einer Durchführung des Verfahrens;
- **Fig. 9**: ein exemplarisches Zustandsdiagramm im Zuge der Durchführung des Verfahrens desjenigen Busteilnehmers, der die Schritte "Erfassungsphase" (während Zustand Test) und "Bewertungsphase" (während Zustand Bewertung) durchführt;
- **Fig. 10**: eine schematische Veranschaulichung der Unterbrechung des Sendepfades zwecks Freihaltung des Busses von Responsezugriffen;
- **Fig. 11**: einen Auszug aus einer Blockdarstellung eines Schaltkreises oder Moduls zur Veranschaulichung einer softwarebasierten Realisierung einer solchen Unterbrechung;
- **Fig. 12**: eine Veranschaulichung der Integration einer Vorrichtung gemäß der Erfindung in einer komplexeren Einheit zusammen mit einem Bus-Transceiver;
- **Fig. 13**: eine Funktionsblockdarstellung einer Stromversorgung, die zur Unterstützung der erfindungsgemäßen Vorrichtung und damit kooperativer Elemente in einem Bus-Transceiver einen Versorgungszweig zur Bereitstellung einer Hilfsspannung V_{T} oder eines Hilfstromes I_{T} umfaßt;
- **Fig. 14**: eine vereinfachte Wirkblockdarstellung von Vorrichtungselementen beispielhaft gemäB Fig. 12, die Sendeseite der Transceiver-Funktion betreffend;
- **Fig. 15**: eine weitere entsprechende Wirkblockdarstellung von Vorrichtungselementen, die Sendeseite der Transceiver-Funktion betreffend;
- **Fig. 16**: eine weitere vereinfachte Wirkblockdarstellung von Vorrichtungselementen, die Sendeseite der Transceiver-Funktion betreffend;
- **Fig. 17**: eine weitere entsprechende Wirkblockdarstellung von Vorrichtungselementen, die Sendeseite der Transceiver-Funktion betreffend;
- **Fig. 18**: eine schematische Illustration von einander entsprechenden oder ineinander überführbaren und insoweit äquivalenten Versorgungsquellen;
- **Fig. 19**: ein schematisches Zeitdiagramm der Quellenpotentiale, von denen Signalströme aus der Vorrichtung auf die Busadern dominant einspeisbar sind;
- **Fig. 20**: zwei einander überlagerte Zeitdiagramme beispielhafter Signalverläufe, wie sie mittels der Vorrichtung gemäß Fig. 16 oder 17 an Aderkoppelpunkten sendeseitig erzeugbar sind;
- **Fig. 21**: ein vereinfachtes Funktionsschaltbild zur Veranschaulichung verschiedener Funktionalitäten einer beispielhaften Vorrichtung in Verbindung mit Elementen der Sendemittel eines Bus-Transceivers wie in Fig. 12 dargestellt;
- **Fig. 22**: ein beispielhaftes Logikschema der Ansteuerfunktionalität L₃ in Fig. 21;
- **Fig. 23**: ein vereinfachtes Funktionsschaltbild zur Veranschaulichung weiterer Funktionalitäten über jene der Vorrichtung gemäß Fig. 21 hinaus;
- **Fig. 24**: ein Verteilungsschema von Vorrichtungselementenim Sinne von Fig. 12, wobei diese hier beispielhaft auf eine Unterstützung der Sendeseite des Bus-Transceivers 100' beschränkt sind;
- **Fig. 25**: ein Funktionsschaltbild einer fortgebildeten Vorrichtung, welche in einfacher Weise die unmittelbare Regelung an der Busader BUS_L eines darauf dominant einzuprägenden Tastpotentials erlaubt;
- **Fig. 26**: ein entsprechendes Funktionsschaltbild für die Busader BUS_H;
- **Fig. 27**: ein Funktionsschaltbild eines in den Vorrichtungen gemäß Fig. 25 und Fig. 26 einsetzbaren Samplers, welcher keiner Fehlerkompensation bedarf und sehr leicht integrierbar ist, mit angeschlossenem Hold-Regler;
- **Fig. 28**: ein Funktionsschaltbild einer alternativen Vorrichtung, welche die unmittelbare Regelung an der Busader BUS_L eines darauf dominant einzuprägenden Tastpotentials erlaubt und sich dabei eines externen Microcontrollers zur Fehlerkompensation bedient, in Anwendung gezeigt bei z.B. einem mobilen Prüfgerät;
- **Fig. 29**: eine Abwandlung der Vorrichtung gemäß Fig. 28, die vermittels einer Sample-&-Hold-Einrichtung einen Microcontroller zwecks Kompensation verzichtbar macht, gültig für die Bus-Ader BUS_L;
- **Fig. 30**: ein Funktionsschaltbild einer alternativen Vorrichtung zwecks Einspeisung auf die Busader BUS_L eines gegenüber dem normalen dominanten Potential mit varaiablem Offset behafteten Quellpotentials;
- **Fig. 31**: eine Funktionsblockdarstellung eines Empfangsblockes innerhalb eines Bus-Transceivers z.B. in einem Halbleiterschaltkreis, der mit zusätzlichen Vorrichtungselementen ausgestattet ist;
- **Fig. 32**: eine Funktionsblockdarstellung eines fortgebildeten Empfangsblockes innerhalb eines Bus-Transceivers in einem Halbleiterschaltkreis, der mit weiter fortgebildeten Vorrichtungselementen ausgestattet ist;
- **Fig. 33**: ein graphisches Schema eines Teils der Vorrichtungsfunktionalität in einem Empfangsblock gemäß Fig. 32;
- **Fig. 34**: eine Wirkblockdarstellung von auf spezifische Anwendungen beschränkten Vorrichtungselementen gemäß Fig. 12 und Fig. 32, die Empfangsseite der Transceiver-Funktion betreffend;
- **Fig. 35**: eine weitere Wirkblockdarstellung von auf spezifische Anwendungen beschränkten Vorrichtungselementen gemäß Fig. 12 und Fig. 32, die Empfangsseite der Transceiver-Funktion betreffend;
- **Fig. 36**: eine weitere Wirkblockdarstellung von auf spezifische Anwendungen beschränkten Vorrichtungselementen gemäß Fig. 12 und Fig. 32, die Empfangsseite der Transceiver-Funktion betreffend;
- **Fig. 37**: eine weitere Wirkblockdarstellung von auf spezifische Anwendungen beschränkten Vorrichtungselementen gemäß Fig. 12 und Fig. 32, die Empfangsseite der Transceiver-Funktion betreffend;
- **Fig. 38**: ein schematisches Wirkschaltbild eines Fortbildungsdetails der Vorrichtung gemäß Fig. 5 zur Erfassung und Übertragung einer Bezugspotentialdifferenz an einen Microcontroller;
- **Fig. 39**: eine schematische Veranschaulichung eines zentralen Vorrichtungselements, das sämtliche Steuersignale und Wertvorgaben zur Beeinflussung der Sende- und Empfangsmittel eines Bus-Transceivers zwecks Potentialfehlerbestimmung erzeugt;

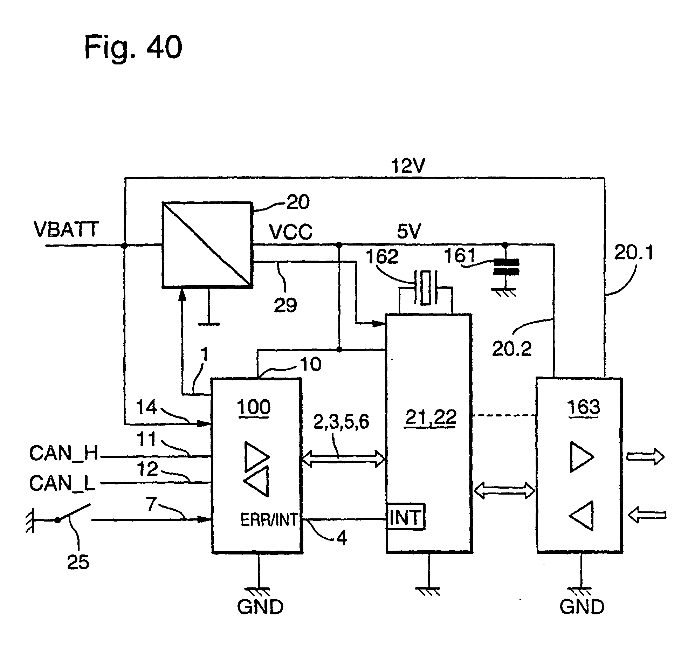

- **Fig. 40**: ein Blockschaltbild zur groben Veranschaulichung eines Gerätes oder Moduls, in dem ein Bus-Transceiver 100 mit einem Microcontroller 21 zusammenwirkt (entspricht der Fig. 13 aus der Prioritätsanmeldung) ;
- **Fig. 41**: ein in Funktionsblöcke aufgelöstes Schema eines Bus-Transceivers 100 wie in der Prioritätsanmeldung beschrieben (entspricht der Fig. 2 aus der Prioritätsanmeldung;
- **Fig. 42**: ein in Funktionsblöcke aufgelöstes Schema eines Bus-Transceivers 100' wie in der zeitgleich eingereichten und im Text i.V. mit Fig. 12 angezogenen Parallelanmeldung beschrieben (dort Fig. 4).

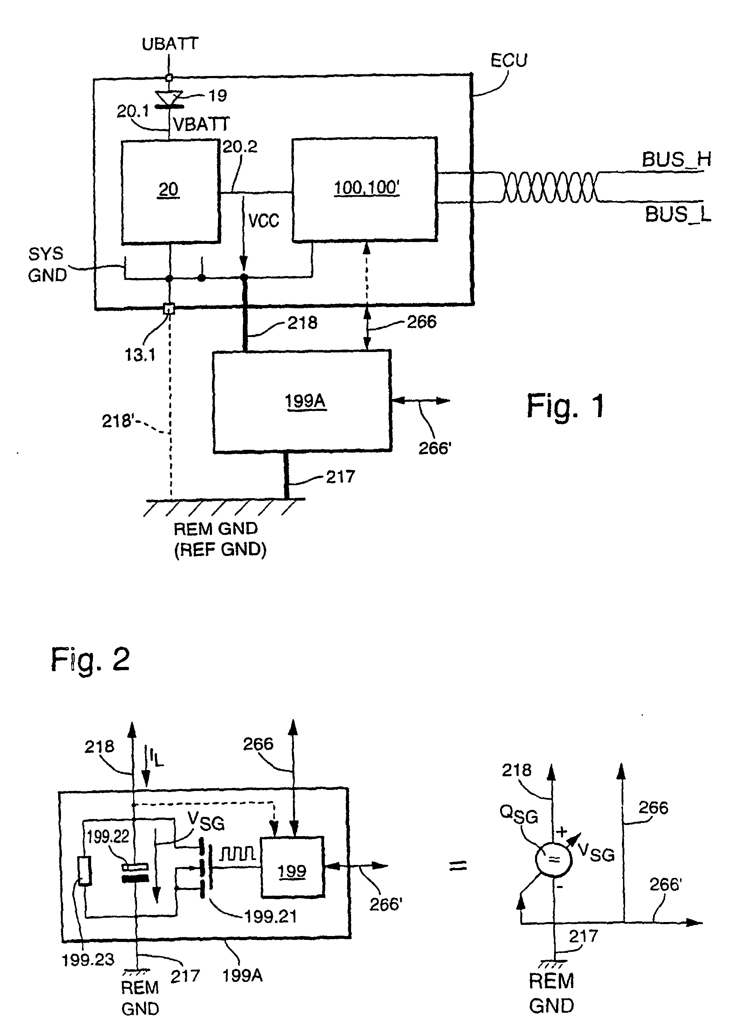

In **Fig. 1** ist ein Simulationsmodul 199A in den normalen (gestrichelten) Massebetriebsstrompfad 218' eines Busteilnehmers ECU geschaltet, wobei dieser normale Pfad zwischen einer teilnehmerinternen Masseschiene SYStem GrouND (SYS GND) - an eine Anschlußklemme 13.1 des Teilnehmers ECU geführt - und einem Speisemassepunkt REMote bzw. REFerence GrouND (REF bzw. REM GND) im Applikationsumfeld verläuft. Der Versorgungsstromkreis des Teilnehmers ECU schließt sich massewärts von der teilnehmerinternen Masseschiene SYS GND über die fett hervorgehobenen Verbindungen 217 und 218 und das Simulationsmodul 199A.

Dem Busteilnehmer ECU wird von einer nicht dargestellten Versorgungsschiene die Betriebsspannung UBATT zugeführt. Ggfs. um einen geringen Spannungsabfall an einem Verpolschutzelement 19 auf VBATT reduziert speist sie den Eingang 20.1 eines Spannungsreglers 20, dessen Fußpunkt mit der vorgenannten Masseschiene SYS GND verbunden ist. Mit letzterer ist auch der masseseitige Versorgungsanschluß des Bus-Transceivers 100, 100' verbunden, welchem zwecks Stromversorgung von einem Ausgang 20.2 des Reglers 20 eine stabilsierte Versorgungsspannung VCC von z.B. 5 Volt zuführbar ist. Mit der teilnehmerinternen Masseschiene SYS GND sind auch alle übrigen elektrischen Komponenten im Teilnehmer ECU verbunden.

Der Bus-Transceiver 100, 100' ist mit einem Zweidraht-Bus BUS_H/BUS_L verbunden, über den der Busteilnehmer ECU mit entsprechenden anderen Busteilnehmern kommunizieren kann. Er kann für Zwei- und Eindraht-Empfang ausgestattet sein, wobei im differentiellen Zweidrahtbetrieb drahtbezogen ein anderer Ansprechpegel als bei Empfang nur vom jeweils betrachteten Draht wirksam sein kann. Zwischen dem Busteilnehmer ECU und dem Simulationsmodul 199A ist eine Verbindung 266 vorgesehen. Sie kann gleichwohl auch zwischen dem Bus-Transceiver 100, 100' und dem Simulationsmodul 199A bestehen. Für den Fall, daß das Simulationsmodul 199A Bestandteil z.B. eines mobilen Testgerätes ist, kann auch eine Steuerverbindung 266' z.B. mit einem hier nicht gezeigten Computer o.dgl. vorgesehen sein.

Das Simulationsmodul 199A kann beispielsweise gemäß **Fig. 2** aufgebaut sein. Demgemäß kann zwischen seinen Anschlüssen 217 und 218 die Schaltstrecke eines Schalttransistors 199.21 von beliebiger Art und eine Kapazität 199.22 geschaltet sein. Des weiteren kann auch noch ein spannungsbegrenzendes Element 199.23 parallel dazu vorgesehen sein. Der Schalttransistor wird von einer Potentialsteuervorrichtung 199 beispielsweise mit einem PWM-Signal angesteuert, so daß sich entsprechend dem Stromfluß I_{L} in Abhängigkeit vom Tastverhältnis durch Glättung vermittels der Kapazität 199.22 eine Offset-Spannung V_{SG} über Masse GND ergibt. Gestrichelt ist noch eine Rückführungsmöglichkeit des Potentials am Anschluß 218 in die Potentialsteuervorrichtung 199 angedeutet. Durch Auswertung dieses Potentials dort kann letzeres durch entsprechende Nachführung des PWM-Tastverhältnisses unabhängig vom Laststrom I_{L} gehalten werden.

Die Potentialsteuervorrichtung 199 kann alternativ über den Pfad 266 von einem angeschlossenen ECU oder über den Pfad 266' z.B. von einem Computer in einem Testgerät oder dgl. angesteuert werden. Insoweit realisiert das Simulationsmodul 199A eine auf Masse GND bezogene steuerbare Spannungsquelle Q_{SG}, deren Klemmenspannung im Idealfall zu Null gemacht werden kann. Dies kann z.B. durch entsprechende Daueransteuerung des Schalttransistors 199.21 verwirklicht werden.

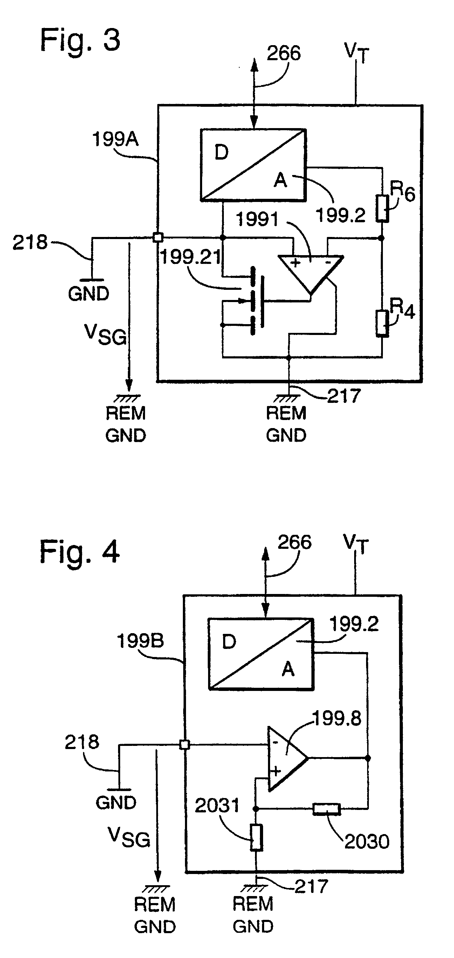

Statt einer schaltenden Beeinflussung der Offset-Spannung V_{SG} kann gemäß **Fig. 3** eine solche auch linear erfolgen. Dazu wird der Transistor 199.21 von einem Verstärker 1991 angesteuert, der durch Beschaltung mit Widerständen R₄ und R₆ als Regler mit dem Transistor 199.21 als Ausgangsstufe geschaltet ist. Zu diesem Zweck ist in an sich bekannter Weise der nichtinvertierender Eingang des Verstärkers 1991 mit dem Anschluß 218 und der invertierende Anschluß über den Widerstand R₆ mit dem Analogausgang eines D/A-Wandlers 199.2 verbunden. Diesem ist über einen digitalen Pfad 266 eine Vorgabe zuführbar, welche dann die über dem Transistor 199.21 abfallende und insoweit zwischen den Anschlüssen 218 und 217 sich einstellende offsetspannung V_{SG} bestimmt.

Die zusätzliche Vorrichtung 199B gemäß **Fig. 4** erlaubt eine Erfassung und digitale Weiterverarbeitung einer Spannung zwischen ihren Anschlüssen 218 und 217, wobei es sich vorzugseise um eine Offsetspannung V_{SG} handeln kann unabhängig davon, wie diese zustandekommt (realfehlerhaft vorhanden oder mittels 199A zwecks Prüfung simuliert).

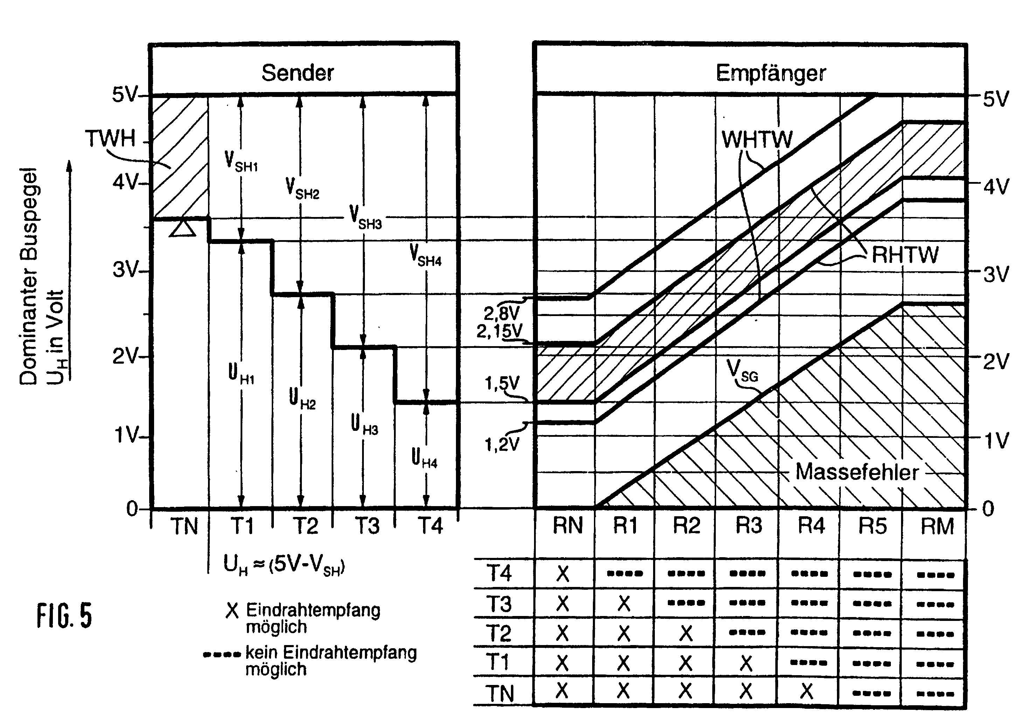

Das Diagramm gemäß **Fig. 5** veranschaulicht die eindrähtige Empfangsfähigkeit bei Auftreten einer fehlerhaften Masse-Offsetspannung V_{SG} bei einem Empfänger, wenn der von einem Sender der der Busader BUS_H dominant aufgeprägte Buspegel U_{H} durch eine Offsetspannung V_{SH} schrittweise verringert wird. Aus folgenden Angaben erklärt sich das Diagramm wie folgt: TN bedeutet den Normalzustand bei einem Sender im Netz. Für diesen Zustand ist hier beispielhaft ein 1,4 Volt hohes Toleranzfenster TWH für den dominanten H-Pegel von z.B. 3,6 bis 5,0 Volt spezifiziert, wobei 5,0 Volt den systemspezifisch festliegenden Oberpegel darstellt. T1 bis T4 kennzeichnen vier Testzustände eines Senders, bei denen der der Busader BUS_H dominant aufgeprägte Buspegel U_{H1} bis U_{H4} um eine schrittweise wachsende, auf die dominante Oberspannung von 5,0 Volt bezogene Offsetspannung V_{SH1} bis V_{SH4} sukzessive verringert wird. Bezüglich des massefehlerhaften Empfängers sind dessen Normalzustand durch RN, daran anschließend fünf weitere Zustände mit monoton zunehmendem Masse-Offsetspannung VSG durch R1 bis R5 und abschließend ein stationärer Zustand mit einer maximalen Masse-Offsetspannung von beispielhaft ca. 2,6 Volt durch RM gekennzeichnet. Des weiteren ist schraffiert das bezüglich der Busader BUS_H eindrähtig wirksame Empfangsfenster RHTW (in RN 1,5...2,15 Volt) und - durch seine Ansprechschwellen kenntlich gemacht - ein eindrähtig wirksames Weckfenster WHTW (in RN 1,2 ...2,8 Volt) eingetragen. Über der rampenförmig ansteigenden Masse-Offsetspannung V_{SG} beim Empfänger verschieben sich diese Fenster entsprechend rampenförmig vom Zustand RN ohne Masse-Offsetspannung bis zum Zustand RM mit V_{SG} = 2,6 Volt Masse-Offsetspannung. Aus dem Diagramm ist unmittelbar die darunter dargestellte Tabelle der Empfangsmöglichkeit ableitbar, wenn einerseits beim Empfänger eine Masse-Offsetspannung V_{SG} vorliegt bzw. ansteigt und der der Busader BUS_H dominant aufgeprägte Pegel U_{H} verringert bzw. der Offset V_{SH} zur Oberspannung von 5 Volt vergrößert wird. Es ist ersichtlich, daß bei zunächst vorhandener Empfangsfähigkeit eines masse-offsetbehafteten Empfängers dieser über einer sukzessiven Erhöhung in einem Sender der Offsetspannung V_{SH} bzw. Erniedrigung der dominanten Aderspannung U_{H} um diese Offsetspannung vor allen übrigen Empfängern als erster seine Empfangsfähigkeit verliert.

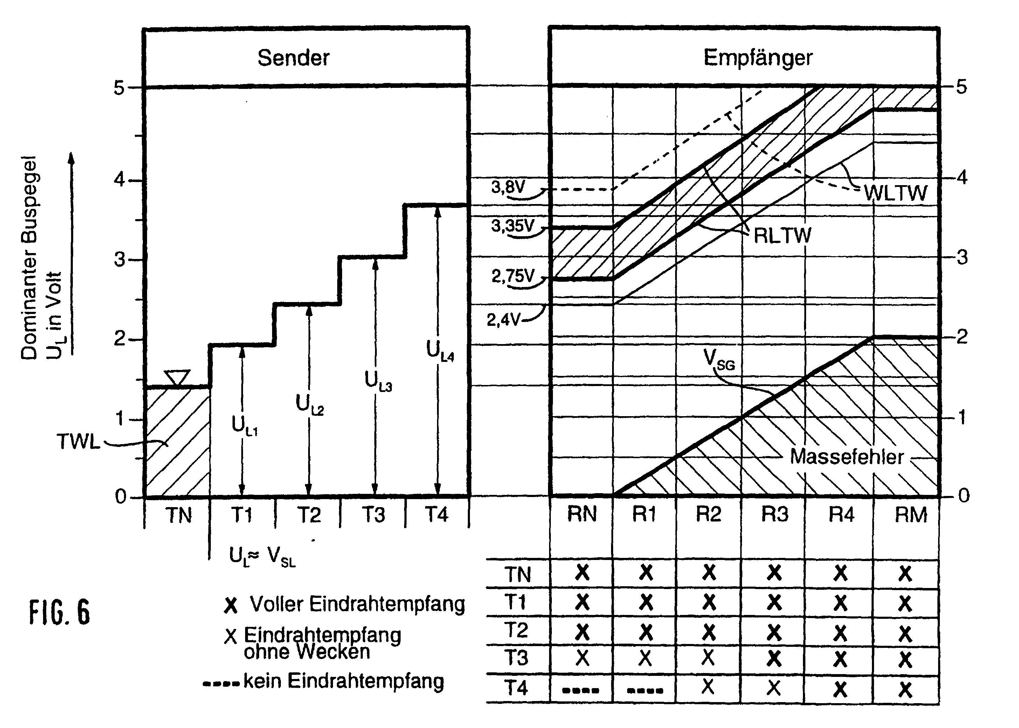

Das Diagramm gemäß **Fig. 6** veranschaulicht die eindrähtige Empfangsfähigkeit bei Auftreten einer fehlerhaften Masse-Offsetspannung V_{SG} bei einem Empfänger, wenn der von einem Sender der der Busader BUS_L dominant aufgeprägte Buspegel U_{L} durch eine Offsetspannung V_{SL} schrittweise erhöht wird. Aus folgenden Angaben erklärt sich das Diagramm wie folgt: Auch hier bedeutet TN den Normalzustand bei einem Sender im Netz. Für diesen Zustand ist hier beispielhaft ein Toleranzfenster TWL für den dominanten L-Pegel von 0,0 bis 1,4 Volt spezifiziert, wobei 0,0 Volt den systemspezifisch festliegenden Bezugspegel darstellt. T1 bis T4 kennzeichnen Testzustände eines Senders, bei denen der der Busader BUS_L dominant aufgeprägte Buspegel Uₜ₁ bis U_{L4} auf eine schrittweise wachsende Offsetspannung V_{SL1} bis V_{SL4} sukzessive angehoben wird. Bezüglich des massefehlerhaften Empfängers sind dessen Normalzustand wieder durch RN, daran anschließend fünf weitere Zustände mit monoton zunehmender Masse-Offsetspannung V_{SG} durch R1 bis R5 und abschließend ein stationärer Zustand mit einer maximalen Masse-Offsetspannung von beispielhaft ca. 2,0 Volt durch RM gekennzeichnet. Des weiteren ist schraffiert das bezüglich der Busader BUS_L eindrähtig wirksame Empfangsfenster RLTW (in RN 2,75...3,35 Volt) und - durch seine Ansprechschwellen kenntlich gemacht - ein eindrähtig wirksames Weckfenster WLTW (in RN 2,4...3,8 Volt) eingetragen. Über der rampenförmig ansteigenden Masse-Offsetspannung V_{SG} beim Empfänger verschieben sich diese Fenster entsprechend rampenförmig vom Zustand RN ohne Masse-Offsetspannung bis zum Zustand RM mit V_{SG} = 2,0 Volt Masse-Offsetspannung. Aus dem Diagramm ist unmittelbar die darunter dargestellte Tabelle der Empfangsmöglichkeiten ableitbar, wenn einerseits beim Empfänger eine Masse-Offsetspannung V_{SG} auftritt bzw. ansteigt und der der Busader BUS_L dominant aufgeprägte Pegel U_{L} erhöht wird.

Dabei ist hier eine Differenzierung getroffen nach eindrähtigem Vollempfang (Kommunikationsempfang innerhalb des Empfangsfensters RLTW und Weckempfang innerhalb des Weckfensters WLTW) und eingeschränktem Empfang (Weckempfang nicht mehr möglich).

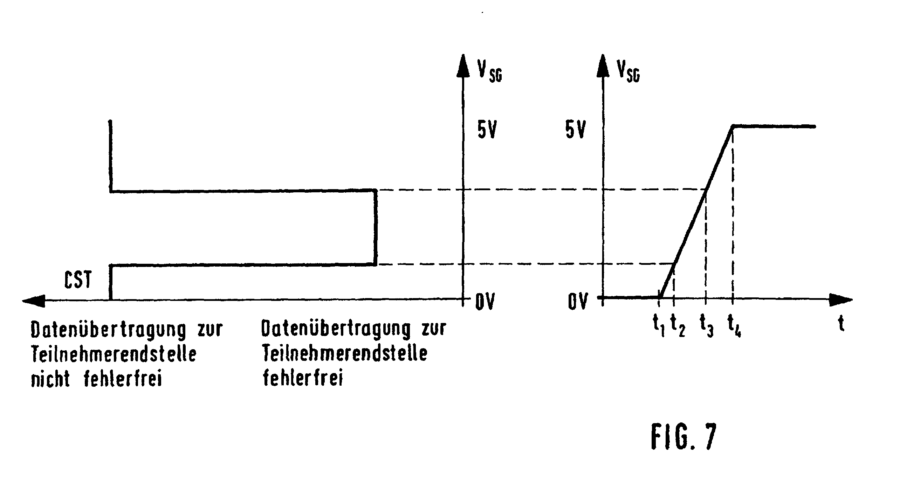

Fig. 7 veranschaulicht den Kommunikationsstatus CST der Datenübertragung zu einem hier beispielhaft massefehlerhaften Busteilnehmer. Dabei ist im rechten Diagrammteil eine zwischen Zeitmarken t₁ und t₄ rampenförmig ansteigende Simulationsspannung V_{SG} dargestellt und im linken Diagrammteil das zwischen Zeitmarken t₂ und t₄ sich ergebende Fenster, innerhalb dessen eine Datenübertragung zum massefehlerbehafteten Busteilnehmer bzw. Empfänger in letzterem möglich ist. Aus dieser Darstellung ist ersichtlich, daß eine Bewertung vereinfacht werden kann, wenn z.B. statt einer rampenförmig verlaufenden Simulationsspannung eine solche mit über der Zeit stufenförmigem Verlauf benutzt wird, d.h., wenn netzweit gültig jeder Stufe aus einer festen Zahl von Stufen ein dominant applizierter Offsetspannungswert entspricht.

Anhand dieser Darstellung ist auch nachvollziehbar, daß bei anfänglicher Vorgabe in einem am Bus liegenden Sender einer sehr hohen Simulationsspannung V_{SG} und anschließender Verringerung derselben derjenige Busteilnehmer, der als erster Empfangsfähigkeit erlangt, der ggfs. gesuchte mit dem größten Bezugspotentuialfehler gegen Masse im Netz ist - ansonsten einwandfreie Funktion des Empfängers vorausgesetzt.

Umgekehrt ist bei anfänglicher Vorgabe in einem am Bus liegenden Sender keiner oder einer sehr niedrigen Simulationsspannung V_{SG} und anschließender Erhöhung derselben derjenige Busteilnehmer, der nach allen übrigen als letzter Empfangsfähigkeit erlangt, der ggfs. gesuchte mit dem größten Bezugspotentialfehler gegen Masse REM GND im Netz, vgl. auch **Fig. 1.**

Unter der Voraussetzung, daß alle Empfänger im Netz jedenfalls bezüglich ihrer in **Fig. 1** gezeigten teilnehmerinternen Bezugspotentialschiene SYS GND (innerhalb systemspezifischer Toleranzgrenzen) korrekte Schwellwerte für den Botschftsempfang wie auch immer aufweisen, folgt daraus, daß bei monotoner Veränderung der Simulationsspannung V_{SG} bei einem Sender und dabei konstanten Bürdeverhältnissen am Bus bzw. der unter Test stehenden Busader aus der Reihenfolge des Erlangens bzw. Verlierens der Empfangsfähigkeit von Busteilnehmern auf die relativen Höhen des Offsets zum Bezugspotential REM GND bei diesen Busteilnehmern geschlossen werden kann.

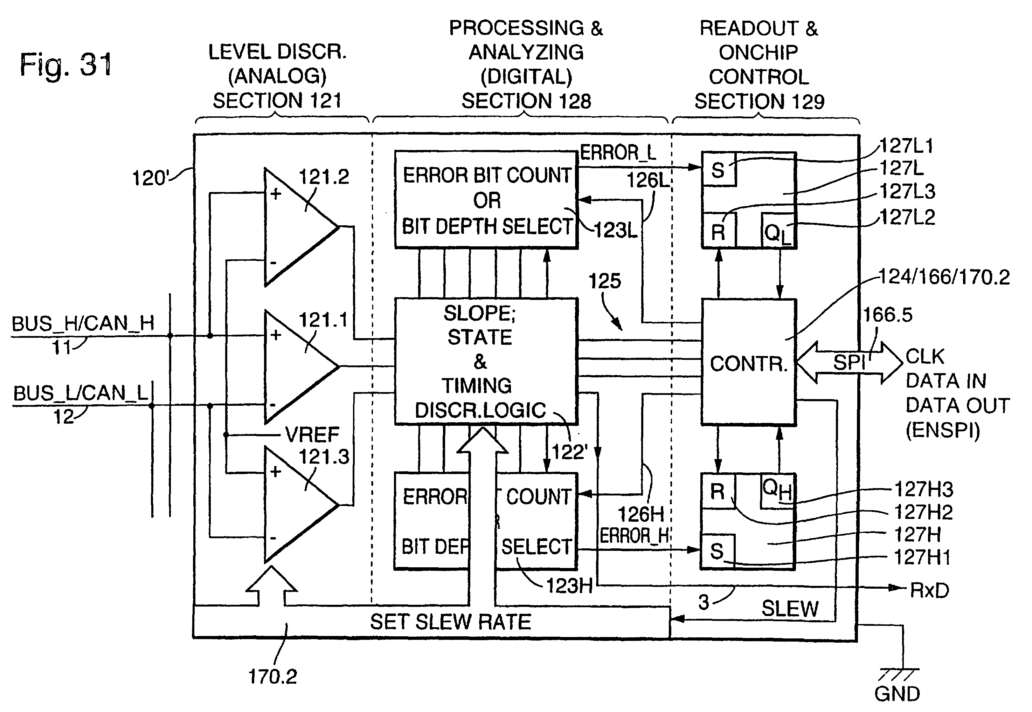

Diese Erkenntnis macht sich das erfindungsgemäße Verfahren zunutze, indem diese universell sowohl unter Eindraht- als auch Zweidraht-Testbedingungen gilt. Im letzten Fall können besondere Vorrichtungselemente (vgl. **Fig. 31 - 33**) innerhalb der in einem Busnetz eingesetzten Empfänger weitergreifende Bewertungen ermöglichen als im ersten Fall.

Wie im Lichte des obigen aus der Fig. 1 unmittelbar ablesbar, ist es vom Bus BUS_H, BUS_L aus gesehen jeweils bedeutungslos, auf welche Weise der Empfänger und/oder Sender des Transceivers 100, 100' bzw. dessen diskriminante Empfangsschwellwerte bzw. dominanter/n Quellenpegel potentialmäßig angehoben wird oder dessen/deren in Bezug auf den Bus wirksame Betriebspegel verfälscht werden. Für das erfindungsgemäße Verfahren kann es im Prinzip schon ausreichen, in Bezug auf ein netzweit bezogenes Potential (REFerence GRounD) offsetmäßig nur solche Teile im Empfänger bzw. Sender des Transceivers 100, 100' zu beeinflussen, welche die vom Bus her gesehen in Bezug auf REF GND effektiv wirksamen Empfangsschwellwerte bzw. dominanten Quellenpegel bestimmen.

Am allereinfachsten ist dies gemäß **Fig. 1** dadurch möglich, daß alle elektronischen Komponenten in einem Busteilnehmer ECU, m.a.W. also der gesamte Busteilnehmer bezüglich seiner internen Bezugspotentialschiene SYS GND um eine durch das Simulationsmodul 199A erzeugte Simulationsspannung V_{SG} angehoben werden bzw. wird.

In diesem Falle muß das Simulationsmodul 199A allerdings den gesamten Betriebsstrom I_{L} des Busteilnehmers ECU tragen können. Eine solche Lösung ist sinnvoll, wenn z.B. ein ganz normaler Busteilnehmer ohne eigene Vorrichtungsmittel, um das Verfahren durchzuführen, mit einfachen Mitteln und ohne nennenswerte Eingriffe zur Verfahrensdurchführung als Prüfteilnehmer tauglich und bereit gemacht werden soll. Betrachtet man den Busteilnehmer ECU in Fig. 1 als ein solcher Gerät, ist insoweit nur der Fußpunkt 217 des dementsprechend dimensionierten Simulationsmoduls 199A gemäß **Figen. 1 - 3** an das netzweit als Bezug dienende Potential REF GND und sein Ausgang 218 mit der teilnehmerinternen Bezugspotentialschiene SYS GND zu verbinden.

Effektiver sind Lösungen, die i.S. des obigen nur bestimmte Elemente im Sender und/oder Empfänger des Transceivers mittels geeigneter Vorrichtungen potentialmäßig beeinflussen. Auf deren beispielhafte Ausführbarkeit als feste Bestandteile von Busteilnehmern wird in Verbindung mit **Figen. 10 - 38** Bezug genommen.

### Nomenklatur

Zwecks übersichtlichkeit liegt der nachfolgenden Beschreibung des Verfahrens folgende Sprachregelung zugrunde:
- Prüfteilnehmer:: Der Prüfteilnehmer ist ein ganz normaler Busteilnehmer, der dauerhaft am Bus liegt und zwecks Durchführung der Verfahrensschritte lediglich im Sinne der **Figen. 10 - 39** ausgerüstet zu sein braucht, oder ein entsprechend ausgerüstetes Prüfgerät, welches nur während der Dauer eines Tests vorübergehend an den Bus angeschlossen wird;
- Fehlerteilnehmer:: Der Fehlerteilnehmer ist jeweils der am Bus liegender Teilnehmer, dessen Kommunikationsfähigkeit tatsächlich oder zunächst nur vermutetermaßen infolge eines Bezugspotential- oder Kommunikationspegelfehlers eingeschränkt oder verloren gegangen ist;
- Beobachtungsteilnehmer:: Beobachtungsteilnehmer ist jeder am Bus liegende Teinehmer, der eine Botschaft wenigstens vom Prüfteilnehmer, unter bestimmten Voraussetzungen aber auch vom Fehlerteilnehmer empfangen kann, jedoch diagnoseprogrammbedingt in einen **RECEIVE ONLY**-Status versetzt und damit sendemäßig am Buszugriff gehindert ist.

### Verfahrensvoraussetzungen

Die Voraussetzungen, welche alle Teilnehmer erfüllen müssen, um an dem nachfolgend beschriebenen Verfahren teilnehmen zu können, sind folgende:

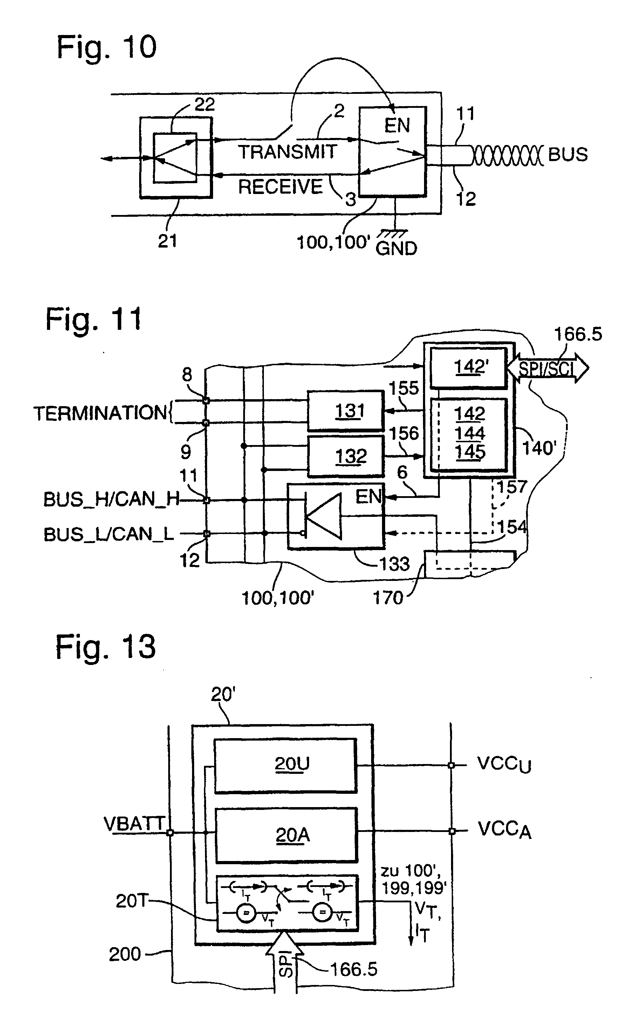

Jeder Teilnehmer verfügt gemäß Fig. 10 über
(a) ein Modul zur Behandlung des Bus-Protokolls, im Beispielfalle eines CANs also z.B. über einen CAN-Protokollbaustein oder einen Mikroprozessor oder Microcontroller 21 mit fest integriertem Bus- bzw. CAN-Protokoll-Modul 22,
(b) einen Physical Layer in Form eines Transceivers 100, 100' zur Sende-/Empfangskopplung des Mikroprozessors oder Microcontrollers 21 an den (Zwei-) Drahtbus 11, 12;
(c) Mittel und Fähigkeit, in Abhängigkeit von einem über den Bus übermittelbaren Steuersignal EN zwei unterschiedliche Betriebszustände einzunehmen, nämlich
   - NORMAL: gekennzeichnet durch Sendefähigkeit von Datenbotschaften über das Protokoll-Modul und den Transceiver auf die beiden Busdrähte und Empfangsfähigkeit von Datenbotschaften auf den Busdrähten über den Transceiver und das Protokoll-Modul;
   - RECEIVE ONLY: gekennzeichnet durch eine unterbundene bzw. gesperrte Sendefähigkeit und volle Empfangsfähigkeit von Datenbotschaften auf dem Busmedium über den Transceiver und das Protokoll-Modul.
   In **Fig. 10** ist symbolisiert, daß die angedeutete Unterbrechbarkeit des Sendepfades 2 im Rahmen der Erfindung gleichwohl im Transceiver 100, 100' realisiert sein kann.

Der als Prüfteilnehmer fungierende Teilnehmer ist so beschaffen, daß er
(1) entweder konstruktionsbedingt an dem bekannten (z.B. negativen) Bezugspotential liegt, oder daß er eine eventuell vorhandene eigene Potentialverschiebung gegenüber dem vorgenannten Potential erfassen und berücksichtigen kann;
(2) die übrigen Busteilnehmer durch Botschaften über den Bus veranlassen kann, über ihren jeweils eigenen Bezugspotentialpfad Lastströme fließen zu lassen;
(3) er das oben genannte Steuersignal EN aussenden kann;
(4) die übrigen Busteilnehmer durch Botschaften über den Bus veranlassen kann, selbst keine Protokoll-Quittierungen auszusenden (z.B. Gut/Schlecht-Rückmeldungen).

Wesentlich ist, daß bezüglich der Bestimmung von Bezugspotentialfehlern nur der Prüfteilnehmer Vorrichtungselemente wie in **Figen. 13 - 30** bzw. **34 - 38** aufweisen muß. Gleichwohl können über den Prüfteilnehmer hinaus auch alle übrigen Teilnehmer (d.h. Fehlerteilnehmer und Beobachtungsteilnehmer) im Hinblick auf ihre vorrichtungsgemäße Ausstattung gemäß **Figen. 13 - 38** beschaffen sein, da deren Wirksamwerden bzw. -keit ausschließlich per Software über den Bus gesteuert wird. Ein mobiles "Prüfgerät" (im Werkstattsinne) kann insoweit auch jeder an den Bus vorübergehend zugeschaltete Prüfteilnehmer von gleicher oder ähnlicher Beschaffenheit in vorgenanntem Sinne sein. Er muß lediglich die Software zur Durchführung des Verfahrens in sich tragen, wenn er Prüfteilnehmer sein soll.

### Verfahren

### Das Verfahren glieder sich in eine "Erfassungsphase" und eine "Bewertungsphase"

Alle am Bus liegenden Teilnehmer werden durch den als Prüfteilnehmer fungierenden Busteilnehmer - bei dem es sich wiegesagt auch um ein temporal angeschlossenes Prüf- oder Testgerät im Werkstattsinne handeln kann - durch ausgesendete Datenbotschaften gesteuert. Dieser Prüfteilnehmer installiert und verändert in Bezug auf wenigstens eine Busader einen eigenen Bezugspotentialversatz - vom Bus her gesehen also letztlich seinen jeweils entsprechenden Quellenpegel, an den die Busader durch den Prüfteilnehmer dominant getastet wird - in vorbestimmter Weise und sendet Daten aus **("Stimulus-Phase")** und stellt dann fest, ob Datenbotschaften von Busteilnehmern fehlerfrei oder fehlerhaft empfangen werden **("Response-Phase").** Die beiden vorgenannten Phasen können sich aufeinanderfolgend sukzessive abwechseln. Die beiden vorgenannten Phasen zusammengenommen bilden die Erfassungsphase.

In einer anschließenmden **"Bewertungsphase"** können die in der Erfassungsphase gewonnenen Ergebnisse bewertet werden. Bei Vorliegen von z.B. programmstützendem Wissen über den Stromlauf der Verbindungen der einzelnen Busteiinehmer mit dem netzweit genutzten Bezugspotential (Einzelanschluß, Gruppen- oder Serienanschluß) können unzulässige Potentialverschiebungen einzelnen Teilnehmern bzw. Gruppen davon zugeordnet werden. In diese Bewertung werden alle gewonnen Ergebnisse einbezogen. Diese Bewertung kann, muß aber nicht im Prüfteilnehmer erfolgen. Sie kann vielmehr genau so gut in einem oder mehreren angeschlossenen Auswertungsgeräten erfolgen.

Das Verfahren läßt sich in Schritte gliedern wie folgt:
1/ Es wird ein Busteilnehmer als Prüfteilnehmer bestimmt, der physikalisch und im Hinblick auf systemspezifisch mögliche Potentialfehier in der Lage ist, mit jedem der übrigen Busteilnehmer als potentiellem Fehlerteilnehmer (d.h. mit systemtypisch beliebigem Potentialfehler als Ursache der potentiellen Störung einer Kommunikation unter Normalbedingungen) zu kommunizieren;
2/ der Prüfteilnehmer sendet wenigstens eine Bus-Botschaft aus, um alle zu prüfenden Busteilnehmer in einen Betriebsmodus "Keine Anwendungsbotschaften senden" zu versetzen;
3/ der Prüfteilnehmer sendet wenigstens eine Bus-Botschaft aus, um alle zu prüfenden Busteilnehmer in einen Betriebsmodus "nur Empfangen, Senden nicht möglich" (RECEIVE ONLY) zu versetzen, wodurch diese zu Beobachtungsteilnehmern werden;
4/ der Prüfteilnehmer sendet wenigstens eine Bus-Botschaft aus, um aus der Menge der Beobachtungsteilnehmer einen bestimmten Teilnehmer als (potentiellen) Fehlerteilnehmer in den Betriebsmodus "Senden und Empfangen" (NORMAL) zu versetzen;
5/ der Prüfteilnehmer sendet zyklisch wenigstens eine Prüf-Botschaft aus;
6/ der potentielle Fehlerteilnehmer in der Betriebsart NORMAL quittiert die Prüf-Botschaft wie folgt:
   6.a/ Wird eine Prüf-Botschaft vom Fehlerteilnehmer fehlerfrei empfangen, sendet der Fehlerteilnehmer über den Bus eine Gut-Quittung an den Prüfteilnehmer zurück.
   6.b/ Wird eine Prüf-Botschaft vom Fehlerteilnehmer fehlerhaft empfangen, sendet der Fehlerteilnehmer über den Bus eine Schlecht-Quittung an den Prüfteilnehmer zurück.
   6.c/ Wird eine Prüf-Botschaft vom Fehlerteilnehmer nicht empfangen, sendet der Fehlerteilnehmer keine Quittung auf den Bus;
7/ der Prüfteilnehmer wertet eine Gut-Quittung als Wahrheitsstatus für eine Fehlerfreiheit der Datenübertragung und eine Schlecht-Quittung oder eine überhaupt fehlende Quittung als Wahrheitsstatus für eine Fehlerhaftigkeit der Datenübertragung;
8/ der Prüfteilnehmer verschiebt wenigstens einen Quellenpegel, an den die (wenigstens eine) zur Prüfung benutzte Busader dominant getastet wird;
9/ der Prüfteilnehmer erfaßt den Bereich der Potentialverschiebung seines (wenigstens eine). Quellenpegels, in welchem die Prüf-Botschaft gemäß den Schritten 6.a/ und 7/ fehlerfrei empfangen wird, und den/die Bereiche der Potentialverschiebung des (wenigstens einen) Quellenpegels, in dem/denen die Prüf-Botschaft gemäß den Schritten 6.b/ und 6.c/ nicht bzw. fehlerhaft empfangen wird;
10/ der Prüfteilnehmer stellt bezüglich wenigstens einer zuvor prüfungshalber benutzen Busader eine Potentialverschiebung des dieser Busader dominant zugeordneten Quellenpegels in den Bereich ein, in dem die Prüf-Datenübertragung zuvor fehlerfrei möglich war;
11/ nach Beendigung der Prüfung eines Fehlerteilnehmers sendet der Prüfteilnehmer wenigstens eine Bus-Botschaft aus, um den Fehlerteilnehmer in den Betriebsmodus "Nur Empfang - Senden nicht möglich" (RECEIVE ONLY) zu versetzen, wodurch dieser wieder ein Beobachtungsteilnehmer wird;
12/ die Schritte 4/ bis 11/ werden für spezifisch interessierende oder alle Beobachtungsteilnehmer wiederholt;
13/ die Prüfergebnisse werden bewertet;
14/ das Busnetz wird vom Prüfteilnehmer in seinen Nennbetrieb zurückversetzt.

Dabei können die Schritte 2/ und 3/ untereinander sowie die Schritte 13/ und 14/ untereinander vertauscht sind.

Des weiteren können die Schritte 5/ bis 9/ gleichzeitig ablaufen bzw. erfolgen.

Im Rahmen der Erfindung kann die Verschiebung des wenigstens einen Quellenpegels gemäß Schritt 8/ rampenförmig über der Zeit, schrittweise monoton erfolgen.

Des weiteren kann die Verschiebung gemäß Schritt 8/ des (ersten) Quellenpegels in Abwechslung mit der Verschiebung eines weiteren (zweiten) Quellenpegels nach Maßgabe durch ein vorgegebenes Verschiebeschrittmuster erfolgen.

Das Verfahren kann ferner einen Schritt
15.a/ vorsehen, dem zufolge der Prüfteilnehmer nach Schritt 1/ und vor Schritt 4/ wenigstens eine Bus-Botschaft aussendet, um einen als Fehlerteilnehmer aufzurufenden Busteilnehmer in einen Betriebsmodus "Teilnehmer-Lastströme eingeschaltet" zu versetzen.

Alternativ dazu kann das Verfahren ferner einen Schritt
15.b/ vorsehen, dem zufolge der Prüfteilnehmer nach Schritt 1/ und vor Schritt 4/ wenigstens eine Bus-Botschaft aussendet um alle Busteilnehmer in einen Betriebsmodus "Teilnehmer-Lastströme eingeschaltet" zu versetzen.

Durch die zwei vorgenannten Schritte können nur im Fehlerteilnehmer bei mäßigem Gesamtstromverbrauch im Busnetz bzw. in allen übrigen Teilnehmern (Fehlerteilnehmer und Beobachtungsteilnehmer) bei entsprechend hohem Gesamtstromverbrauch im Busnetz Potentialtests insbesondere bezüglich stromverbrauchsbedingter Bezugspotentialverschiebungen durchgeführt werden.

Das Verfahren kann ferner einen Schritt
16/ vorsehen, dem zufolge während aller auf den Schritt 1/ bis zum Schritt 4/ folgenden Schritte zwecks Aussendung wenigstens einer Bos-Botschaft der Prüfteilnehmer wenigstens einen Quellenpegel, an den der (wenigstens eine) zur Kommunikation benutzte Busdraht dominant getastet wird, verschiebt.

Das Verfahren kann ferner vorsehen, daß der Prüfteilnehmer ein dauernd um Bus liegender Busteilnehmer ist und daß das Verfahren von diesem Busteilnehmer wenigstens nach jeder neuen Inbetriebnahme des Busnetzes als dem normalen Busbetrieb unterlagert bezüglich aller Busteilnehmer durchgeführt wird.

Weiter sieht das Verfahren vor, daß die anläßlich der Überprüfung aller Busteilnehmer wenigstens nach jeder Inbetriebnahme des Busnetzes gewonnenen Bewertungsergebnisse im Prüfteilnehmer oder einem von diesem auswählbaren Busteilnehmer gespeichert werden.

Das Verfahren ist ein- oder zweidrähtig durchfühbar. Im letzten Fall kann der Prüfteilnehmer zwecks Prüfung beide Busadern ansteuert. In diesem Zusammenhang sieht das Verfahren des weiteren vor, daß der Schritt 8/ mit dem Schritt 5/ wenigstens zeitweise botschaftsverkettet schrittweise erfolgt und jede Prüf-Botschaft eine Erwartungszahl an den zu prüfenden Fehlerteilnehmer enthält. Dabei kann die Verkettung vorteilhaft bitblockbasiert sein.

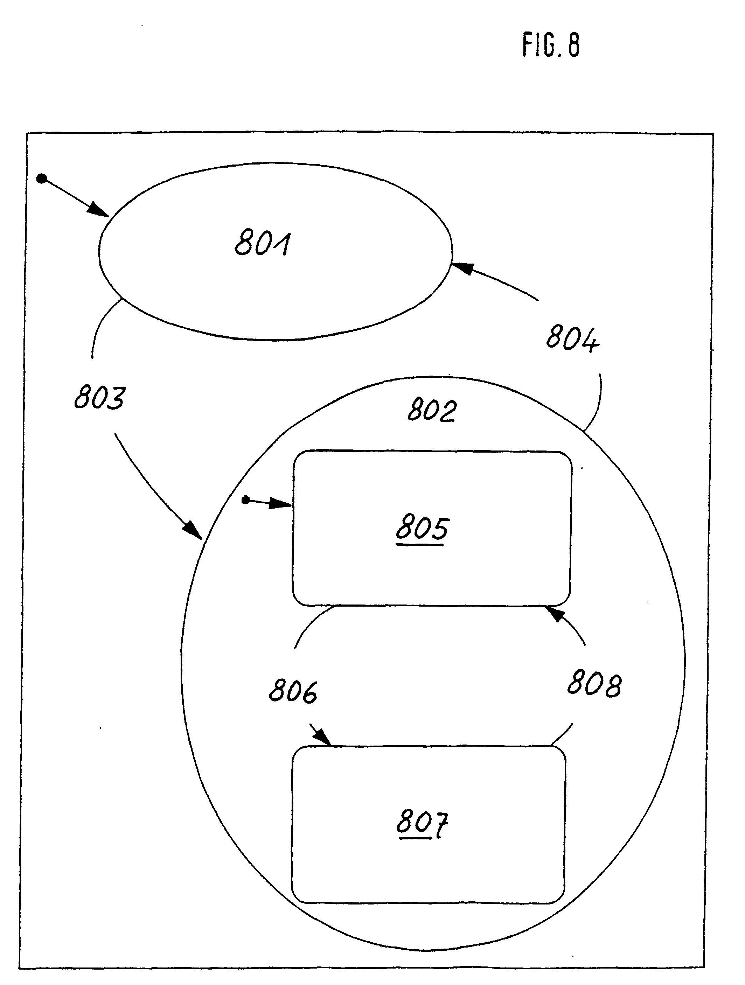

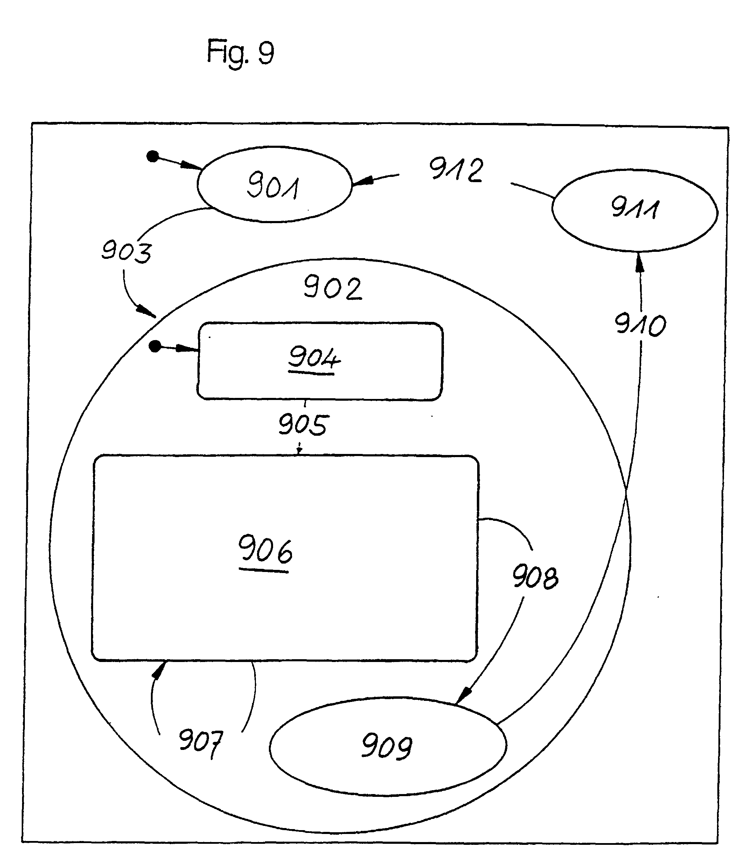

In **Fig. 8** ist beispielhaft ein Zustandsdiagramm eines Teilnehmers als (potentieller) Fehlerteilnehmer dargestellt, der unter Lastsrombedingungen getestet werden soll, um einen möglicherweise unzulässig hohen Spannungsabfall in seiner Masseleitung als störende Ursache einer möglichen Kommunikationsstörung zu erkennen und bestimmen zu können. In **Fig. 9** ist beispielhaft ein Zustandsdiagramm eines Prüfteilnehmers für den einfachen Fall des Massefehlerpotentialtests dargestellt, aus dem die Zweiteilung in eine Erfassungsphase (während des Zustands Prüfung) und eine Bewertungsphase (während des Zustands Bewertung) ersichtlich ist. Dabei kennzeichnen in beiden Fällen die aus Punkten startenden Pfeile Default-Eingänge des Verfahrens.

Die oben beschriebene verfahrensgemäße Behandlung von Potentialfehlern setzt jedenfalls voraus, daß der Sendepfad zwischen einem Microcontroller 21 bzw. dessen Bus-Protokoll-Modul 22 und dem Busdrahtanschluß (Eindrahtnetz) bzw. den Busdrahtanschlüssen 11 und 12 (Zweidrahtnetz) in irgend einer Weise aufgetrennt werden kann, damit der Bus von unerwünschten Sendezugriffen freigehalten werden kann. Dies ist in **Fig. 10** symbolisiert. Zur Verwirklichung wird eine hardwaremäßig angelegte Betriebsart RECEIVE ONLY des Bus-Transceivers 100, 100' herangezogen.

Gemäß **Fig. 11** kann die Betriebsart RECEIVE ONLY und damit eine Freischaltung des Busses von Sendezugriffen beispielsweise von einem Microcontroller aus über ein Steuerbit EN bewirkt werden, welches (zunächst über den Pfad 166.5 und anschließend) über einen Pfad 6 an die Sendemittel 133 des Bus-Transceivers übertragen werden kann. Nur wenn das Steuerbit EN den vorgeschriebenen logischen Pegel aufweist, befindet sich der Bus auch im Sendezugriff des Transceivers, andernfalls nicht. In **Fig. 11** ist dieses Detail für den beispielhaften Fall einer SPI-Implementation veranschaulicht.

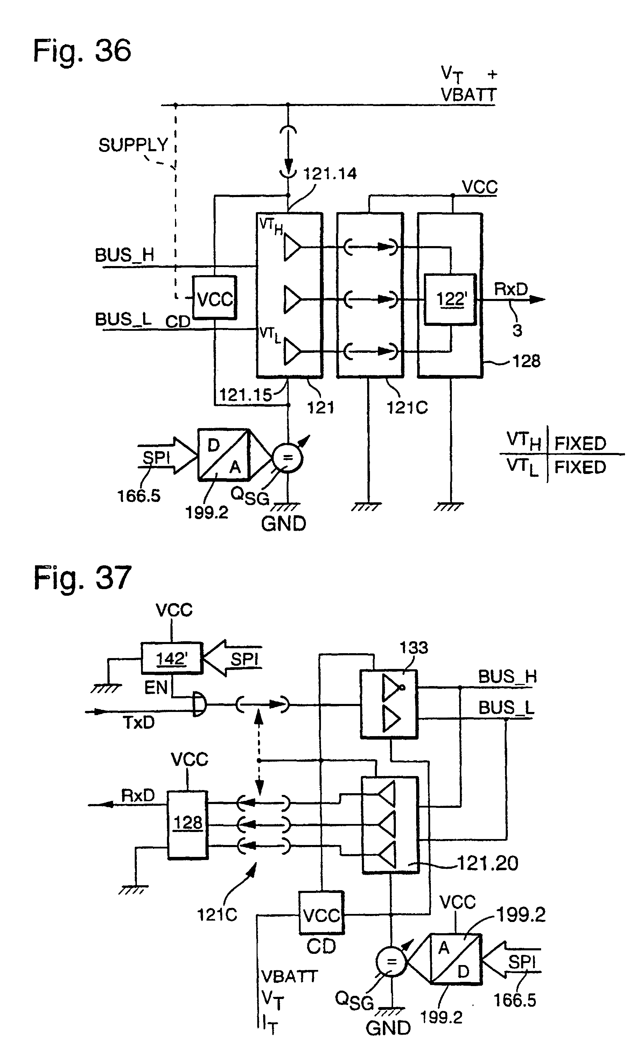

Hierbei kommuniziert ein nicht dargestellter Mikroprozessor oder Microcontroller mit dem Bus-Transceiver 100' über den SPI/SCI-Bus 166.5. Infolgedessen wird das EN-Bit hier protokolliert an den Bus-Transceiver 100' übertragen. Letztlich wird dabei also ein die Sendemittel 130 bzw. die Sendeendstufe 133 freigebendes oder sperrendes EN-Bit in einem SPI-kommunikationsfähigen Steuerungsblock 140' eines entsprechenden Bus-Transceivers 100' bzw. 100.11 durch Dekodierung generiert, gespeichert bzw. überschrieben. In der Figur ist deshalb - als Bestandteil einer solchen SPI-Implementation - dem Block 142 - welcher die Betriebsarten des Transceivers 100' gemäß Instruktion vom Microcontroller einstellt und der-dort mit Blöcken 144 und 145 zusammengefaßt dargestellt ist - wenigstens ein Speicherregister 142' zugeordnet, der die jeweils empfangene Betriebszustandsinformation so lange hält, bis sie durch den Empfang einer aktuelleren überschrieben wird. Dieser Speicher umfaßt jedenfalls auch eine Zelle für das oben erwähnte SPI-dekodierte EN-Signal für die Endstufe 133. Innerhalb des Blockes 140' ist der Pfad 6 von diesem Speicher zur Sendeendstufe 133 gestrichelt angedeutet. In Fig. 37 ist der wenigstens eine Speicher für das EN-Bit auch dargestellt.

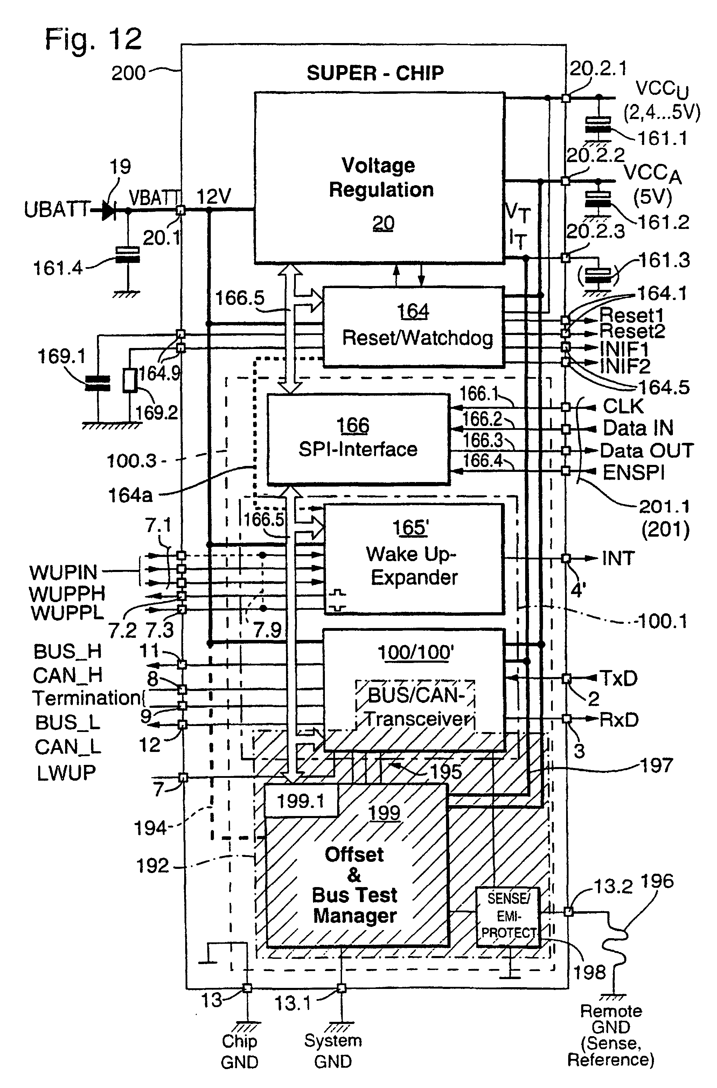

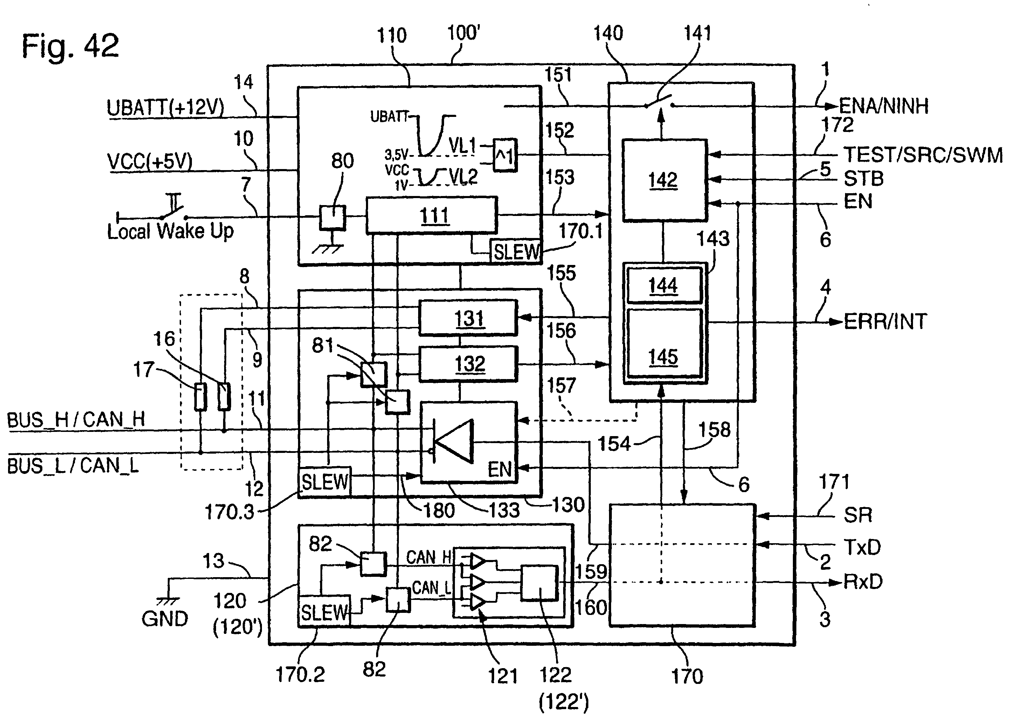

**Fig. 12** veranschaulicht eine Funktionsblockdarstellung eines komplexeren Schaltkreises oder Elektronik-Moduls 200. Ein solcher Schaltkreis ist beispielhaft in der zeitgleich eingereichten Anmeldung PCT/EP96/05087 näher beschrieben; wegen Details wird auf jenes Dokument vollumfänglich verwiesen. Im Rahmen der vorliegenden Erfindung ist - im wesentlichen - nur die zur Durchführung des Verfahrens dort behandelten Potentialbeeinflussungsmittel 199 in Verbindung 195 mit dem Bus-Transceiver 100, 100' und ihr Digitalpfad über 166.5, 166, 201 bzw. 201.1 zum nicht dargestellten Microprozessor oder Microcontroller relevant. Wegen Details des Bus-Transceivers wird auf die der vorgenannten, zeitgleich eingereichten Parallelanmeldung PCT/EP96/05087 entnommene **Fig. 42** und die **Figen. 40 und 41** aus der Prioritätsanmeldung verwiesen. Erläuterungen zur **Fig. 42** finden sich am Schluß der Beschreibung. Um bei Bedarf eine Bezugnahme zu erleichtern, sind in der Parallelanmeldung benutzte Kennzeichen auch hier durchgängig geführt.

Die Potentialsteuervorrichtung 199 befähigt ein/en so oder ähnlich aufgebauten/s Schaltkreis bzw. Elektronik-Modul 200, der/das jedenfalls wenigstens einen Bus-Transceiver 100, 100' und gleiche oder ähnlich wirkende bzw. nutzbare Mittel zur Kommunikation mit einem Microcontroller 21 mitumfaßt, eine netzweite Ortung, Erfassung und Behandlung von Betriebspegel- und Bezugspotentialfehlern in bzw. bei Busteilnehmern leisten zu können. Was z.B. im Falle von Kraftfahrzeugen als Träger von Zweidrahtbussystemen unter Bezugspotentialfehlern bezüglich beider Busadern zu verstehen ist, wird nachfolgend verdeutlicht:

Alle Steuergeräte eines Kraftfahrzeugs sind mit der Fahrzeugkarosserie als Befestigungsfläche mechanisch und als Bezugspotentialfläche - genannt Fahrzeugmasse - galvanisch verbunden. Dabei dient die Fahrzeugmasse einerseits als Verteilungsleiter zur Schließung der Betriebsstromkreise von Verbrauchern und Steuergeräten, andererseits auch als Bezugspotentialfläche für Drahtbussignale wie vorliegend.

Durch den Betriebsstromfluß zwischen Steuergerät und Fahrzeugmasse entsteht unvermeidbar ein gewisser, kleiner Spannungsabfall, um den das geräteinterne Massepotential - System GND - über der Fahrzeugmasse angehoben wird. Je nach Ausführung dieser Masseverbindung und Stromfluß darin sind somit sich geringfügig unterscheidende geräteinterne Massepotentiale System GND die Folge. Als unmittelbare Folge können geräteintern auf einen festen Wert geregelte Versorgungsspannung in allen Steuergeräten zwar genau gleich sein, nicht jedoch die Potentiale der entsprechenden geräteinternen Versorgungsschienen gegenüber der Fahrzeugmasse. Dies gilt analog beispielsweise auch für Schwellwerte oder dominante Einspeispotentiale von Empfangsdiskriminatoren in im Empfangsteil 120, 120' bzw. von Leitungstreibern 133L und 133H in einem Sendeteil 133 wie als Bestandteile des Transceivers 100, 100' vorliegend.

Bei schlechtem oder z.B. durch Korrosion sich verschlechterndem Kontakt des betriebsstromdurchflossenen Massekabels eines Steuergerätes mit der Karosserie kann der "Offsetfehler" des geräteinternernen Massepotentials SYStem GND gegenüber den entsprechenden geräteinternen Massepotentialen anderer Steuergeräte unzulässig groß werden. Infolgedessen verschiebt sich dann z.B. der Schwellwert VREF der Empfangsdiskriminatoren 121.2 und 121.3 in **Fig. 31** aus einem busspezifisch zulässigen Toleranzbereich hinaus, und insbesondere gegenüber den entsprechenden Schwellwerten anderer Busteilnehmer. Es kann sich so für diesen Empfänger das rezessive Buspegelfenster gar so weit verschieben, daß ein Empfang nicht mehr möglich ist.

Um eine maximale Verfügbarkeit großer Draht-Busnetze mit vielen Teilnehmern unter rauhen Betriebsbedingungen zu ermöglichen, bezweckt die erfindungsgemäße Vorrichtung, einem entsprechenden Bussystem (Leitungsnetz und Teilnehmer) sowohl die Fähigkeit zur Ortung bzw. Verifikation solcherart fehlerhafter Busteilnehmer als auch die Fähigkeit zur latenten Prüfung und Überwachung der Betriebspegelfenster aller Teilnehmer zu verleihen, d.h. die Fähigkeit zur Gewinnung und zur laufenden Aktualisierung eines Maßes, welches den jeweils aktuell vorliegenden Abstand zum pegelfehlerbedingten Ausfall eines oder mehrerer Busteilnehmer beschreibt (Neben anderen Aspekten ist dieses Maß das wichtigste hinsichtlich einer Definition der Busgüte).

Im Falle eines Kraftfahrzeugs kann eine Service-Station so bei jedem Service sofort einen Eindruck vom Gesamtzustand der physikalisch-kommunikativen Passung der Transceiver im Busnetzwerk in Bezug aufeinander erhalten und erforderlichenfalls sehr gezielt Vorsorge- oder Wartungsarbeiten mit minimalem Aufwand ausführen. Ersichtlich wird bei einem Fahrzeug mit sehr vielen solcher Schaltkreise in sehr vielen mit der Fahrzeugmasse verbundenen Steuergeräten durch so gestützte Eingriffsmöglichkeiten vor dem tatsächlich auftretenden Fehlerfall unnötiger Serviceaufwand vermieden und die Verfügbarkeit des Kraftfahrzeugs erhöht.

Im weiteren Text wird unter dem Kennzeichen 200 der Einfachheit halber ein (Halbleiter-)Schaltkreis angesprochen. Gleichwohl kann es sich dabei auch um ein herkömmlich hergestelltes Elektronik-Modul mit vergleichbaren oder ähnlichen Funktionalitäten handeln, ohne daß dadurch der Rahmen der Erfindung verlassen wird. Ein solcher Schaltkreis bzw. ein solches Modul kann im Rahmen der Erfindung insbesondere auch Bestandteil eines speziellen Bus-Testgerätes sein.

Die Erfindung findet sich vorrichtungsmäßig in der über einen digitalen Pfad (beispielsweise nach SPI-Standard; SPI = Serial Parallel Interface) beeinflußbaren Potentialsteuervorrichtung 199 in Verbindung mit ganz spezifischen Vorrichtungselementen im Bus-Transceiver 100, 100', und zwar dort wenigstens in seinem hier figürlich nicht ausgeführten Sendeteil 133 **(Figen. 29 - 45).**

Für maximale Testflexibilität sind weitere Vorrichtungselemente auch im hier figürlich nicht ausgeführten Empfangsteil 120 vorgesehen **(Figen. 46 - 52).** Diese Elemente und wie diese ohne Beschränkung der Allgemeinheit beispielhaft realisierbar sind um mit der Potentialsteuervorrichtung 199 zusammenwirken, wird nachfolgend beschrieben.

Die nachfolgenden Vorrichtungselemente bezwecken also die oben in Verbindung mit **Fig. 1** schon als effektiver erläuterte Einflußnahme in Sachen Potentialverschiebung dort, wo diese mit minimalem Verlustleistungsaufkommen optimal reproduzierbar möglich ist, nämlich in dem oder bei dem Bus-Transceiver 100, 100'.

Die Potentialsteuervorrichtung 199 (OFFSET & BUS TEST MANAGER) ist hier beipielhaft über einen besonderen Anschluß 13.1 mit einem Bezugsmassepunkt SYSTEM GND in dem den Schaltkreis 200 tragenden Gerät verbindbar. Des weiteren kann der Potentialsteuervorrichtung 199 - vorzugsweise Über ein vorgelagertes Vorrichtungselement 198 (SENSE/EMI-PROTECTION) - noch über einen anderen, besonderen Anschluß 13.2 ein externes Bezugspotential REMote GND aus dem Einsatzumfeld des betreffenden Gerätes zuführbar sein. Die Leitung 196 symbolisiert jedenfalls eine Verbindung, welche - beim o.g. Beispiel eines Fahrzeugs - aus dem betreffenden Gerät heraus zu einem im wesentlichen strombelastungsfreien Massepunkt an der Fahrzeugkarosserie geführt werden kann.

Die Potentialsteuervorrichtung 199 steht mit dem Transceiver 100/100' mehr oder weniger komplex in Wirkverbindung, was der multiple Pfad 195 symbolisieren soll. Schon an dieser Stelle wird darauf hingewiesen, daß sich diese Komplexität daraus ergeben kann, daß die Potentialsteuervorrichtung 199 etwa in einem Halbleiterschaltkreis mehr oder weniger stark mit Steuerstrukturen des Transceivers 100, 100' - Empfänger und/oder Sender umfassend - und/oder des beispielhaft mit einem Microcontroller 21 eine Verbindung herstellenden SPI-Interface 166 verbunden oder sogar in solchen Strukturen regelrecht eingebettet sein kann. Zur Charakterisierung und Verständlichmachung der durch die Potentialsteuervorrichtung 199 ermöglichten Funktionalität werden nachfolgend spezifische Sender- und Empfängerausbildungen erläutert, die mit der Potentialsteuervorrichtung 199 zusammenwirken, um - beispielhaft zusammen mit dem Interface 166 und einem hier nicht gezeigten Microcontroller 21 des elektronischen Gerätes - die oben beschriebene "Intelligenz" zur automatischen Potentialfehlerortung und -bestimmung und zur Fehlerabstandsüberwachung in Verbindung mit einer geeigneten Netzmanagement-Software zu ermöglichen.

Zwecks Stromversorgung digitaler Schaltkreisfunktionen in der Potentialsteuervorrichtung 199 kann letztere vom Ausgang 20.2.2 des Blockes 20A mit dem Potential VCC_{A} stromversorgt werden, der hier beispielsweise ein Spannungsregler ist. Ausdrücklich wird darauf hingewiesen, daß die Erfindung keinesfalls an das Vorhandensein von Stromversorgungsteilen zusammen mit dem Bus-Transceiver 100, 100' in ein- und demselben Schaltkreis oder Elektronik-Modul 100 gebunden ist; die hier getroffene Zusammenfassung hat nur nichteinschränkenden Beispielcharakter.

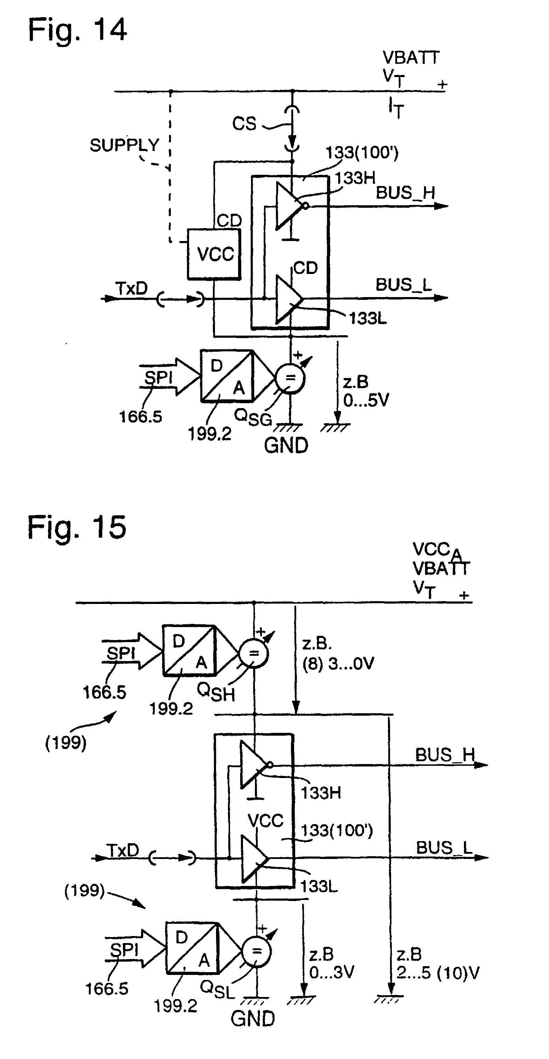

Vorliegend kann die Spannungsregelung 20 optional noch wenigstens einen dritten Regler 20T für ein weiteres Versorgungspotential V_{T} oder aber einen festen Versorgungsstrom I_{T} umfassen, wie in **Fig. 13** illustriert, von dem aus die Potentialsteuervorrichtung 199 - und erforderlichenfalls auch der Bus-Transceiver 100, 100' - über einen Speisepfad 197 versorgbar ist, d.h. mit hoher Entkopplung gegenüber dem Ausgang 20.2.2 des Reglers 20A mit dem Potential VCC_{A}.

In der Regel wird die Spannung V_{T} höher sein als die Spannung VCC_{A}, je nach Realisierung des Potentialsteuervorrichtung 199 und dem Grad der Ausbildung verschiedener Merkmale (z.B. Eindraht- oder Zweidraht-Testfähigkeit, gering- oder großhubige Pegeltestfähigkeit, etc.) und Herstellungstechnologie der Elemente 100, 100' und 199. Der in **Fig. 12** gezeigte Anschluß 20.2.3 kann insoweit (nur) zum Anschluß einer Sieb-Kapazität 161.3 vorgesehen sein, d.h. nicht zur Versorgung anderer Schaltkreise oder Gerätekomponenten, oder zu externen Überwachungszwecken, insbesondere wenn es sich dabei z.B. um einen Stromquellenausgang handelt. Wie aus **Fig. 13** ersichtlich ist, kann der Block 20T auch so ausgebildet sein kann, daß seine Ausgangsgröße zwischen einer Spannung V_{T} und einem eingeprägten Strom I_{T} umschaltbar ist, hier beispielhaft unter Steuerzugriff über den SPI-Pfad 166.5. Eine solche Ausbildung in Zusammenwirken mit Schaltkreisstrukturen in der Potentialsteuervorrichtung 199 und im Bus-Transceiver 100, 100' kann u.a. die selbsttätige Umschaltung oder Ein- und Ausschaltung von Funktionen solcher Strukturen bewirken.

Im allereinfachsten Falle umfaßt die Potentialsteuervorrichtung 199 nur Mittel, die es erlauben, das sog. dominante Pegelfenster wenigstens der Endstufe 133 des Transceivers 100/100' in Bezug auf ein Referenzpotential zu beeinflussen, insbesondere anzuheben.

Dies ist in **Fig. 14** veranschaulicht. Dabei ist ein von 199 mitumfaßter und über den Digitalpfad 166.5 angesteuerter D/A-Wandler zur Vorgabe eines Spannungswertes vorgesehen, der auf eine steuerbare Offset-Spannungsquelle Q_{SG} wirkt. Diese erscheint wirkungsnäßig in den Strompfad der "normalen" Masseverbindung der Endstufe 133 mit dem Potential GND eingeschleift, was auch im Falle einer Integration durch geeignete monolithische Isolation diverser Komponenten der Endstufe 133 möglich ist.

Zur Konstanthaltung der Versorgungsspannung VCC der Endstufe 133 ist dieser eine Spannungsklammer oder ein Spannungsregler CD parallelgeschaltet. Im ersten Falle ist die Endstufe vorzugsweise über eine Stromquelle CS von einer Versorgungsschine mit entsprechend hohem Potential VBATT oder V_{T} und im zweiten Falle vom Regler CD aus stromversorgbar, wobei dann der Regler CD über den gestrichelt angedeuteten Versorgungspfad SUPPLY von besagter Versorgungsschiene speisbar ist. Die Stromquelle CS kann auch ganz entfallen, wenn eine Versorgung der Endstufe 133 durch einen eingeprägten Strom I_{T} aus dem Regler 20T gemäß **Fig. 13** möglich ist.

Die gesteuerte Spannungsquelle Q_{SG} kann im einfachsten Falle z.B. durch einen Impedanzwandler realisiert sein, der den Ausgangsspannungshub des D/A-Wandlers 199.2 im wesentlichen 1:1 auf eine dem Speisestrom der Endstufe 133 angemessene Quellenimpedanz übersetzt.

Mit dieser Vorrichtung ist es also möglich, nach Maßgabe durch eine digitale Vorgabe an den D/A-Wandler 199.2 das durch die Spannungsklammer bzw. den Spannungsregler CD konstant gehaltene dominante Einspeispegelfenster (Differenz der Quellenpegel der beiden Ader-Endstufen 133L und 133H) in Richtung zu höheren Spannungswerten zu verschieben, wobei dieser variable Spannungshub beispielsweise 0 bis 5 Volt betragen kann, so daß sich in Bezug auf das Busnetz ein einspeisender H-Quellenpegel von bis zu 10 Volt ergibt. Um den folglich variablen Ansteuerspannungshub der Endstufeneingänge zu überbrücken, ist hier beispielhaft eine logische Ansteuerung der Endstufen mit dem sendesignal TxD durch einen eingeprägten Strompfad vorgesehen.

Ein so beschaffene Potentialsteuervorrichtung 199 in Verbindung mit einer entsprechend ausgestatten Sendeendstufe 133 erlaubt also, vermittels über den Pfad 166.5 bezogener digitaler Einstelldaten sendeseitig eine Fehlerspannung zu simulieren, die bei einem Bus-Transceiver in einem massefehlerhaften Busteilnehmer eine normale Kommunikation, insbesondere einen normalen Empfang, nicht mehr erlaubt.

Bei angemessener Größe der Klemmenspannung der Quelle Q_{SG} kann so über den gesamten Busabschluß (Sinn: Abschlußbürde aller übrigen Teilnehmer sowie ggfs. eine zusätzliche Fehlerbürde) hinweg die Fehlerspannung beim empfangsgestörten Empfänger wenigstens zum Teil oder vollständig kompensiert werden.

Zweckmäßigerweise ist die Klemmenspannung der Quelle Q_{SG} definiert einstellbar, insbesondere wenigstens in Stufen veränderbar, bei entsprechender Stufigkeit also z.B. mehr oder weniger treppen- bzw. rampenförmig über der Zeit entsprechend jeweiligen Vorgaben über den digitalen Pfad 166.5.

Gemäß **Fig. 15** kann die Vorrichtung bezüglich der Sendeseite gleichwohl zwei separate, steuerbare Offset-Spannungsquellen Q_{SL} und Q_{SH} umfassen, wobei die Quelle Q_{SL} der vorbeschriebenen entspricht und zur Anhebung des negativen Versorgungspotentials der Ader-Endstufe 133L die Quelle Q_{SH} so geschaltet ist, daß sie eine entsprechend digital steuerbare Veränderung des positiven Versorgungspotentials VCC oder VBATT bzw. V_{T} der Ader-Endstufe 133H erlaubt. Es ist hier also der auf den Bus einspeisende L-Quellenpegel unabhängig von dem auf den Bus einspeisenden H-Quellenpegel und vice versa veränderbar.

Beispielsweise kann die steuerbare Offset-Quelle Q_{SL} einen Spannungshub von 0 bis 3 Volt und die steuerbare Offset-Quelle Q_{SH} einen solchen von 8 oder 3 bis 0 Volt überstreichen. Je nachdem, wie hoch das Versorgungspotential der Offset-Quelle Q_{SH} ist, kann bei dieser Vorrichtung also der dominante L-Quellenpegel von 0 bis 3 Volt und der dominante H-Quellenpegel von 3 oder 8 bis 0 Volt einstellbar sein.

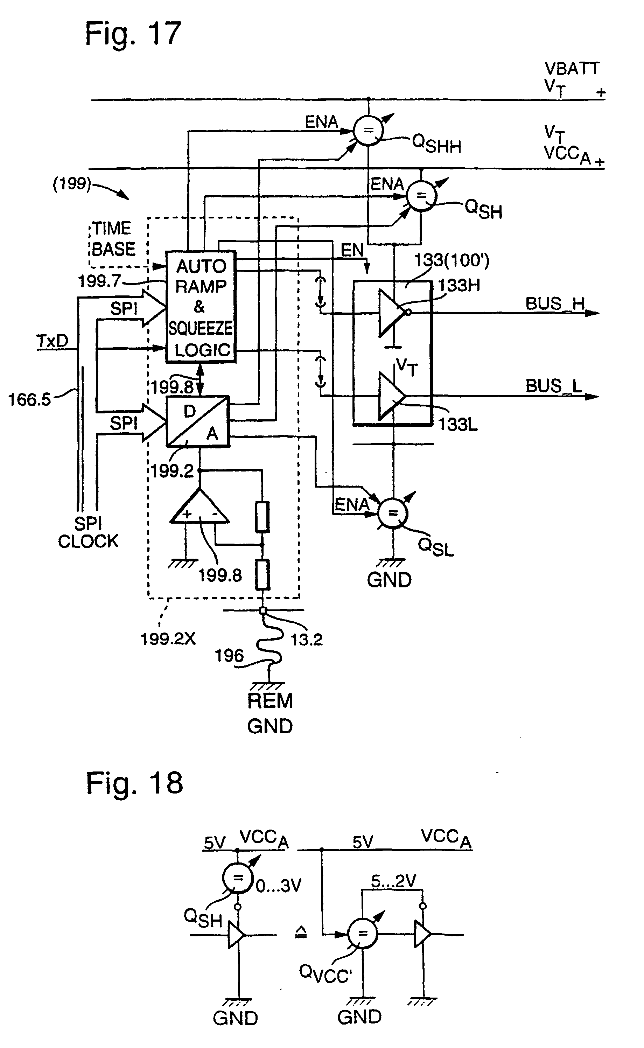

Im Zusammenhang wird auf die erläuternde Darstellung in **Fig. 18** verwiesen, der zufolge es im Rahmen der vorliegenden Erfindung unerheblich ist, auf welches von zwei Versorgungspotentialen eine Offset-Spannungsquelle bezogen wird, indem beispielsweise eine zwischen 0 und 3 Volt einstellbare Offset-Spannungsquelle Q_{SH} unterhalb einer Versorgungschiene VCC mit 5 Volt mit einer einstellbaren Offset-Spannungsquelle Q_{VCC'} über GND mit einem Einstellbereich von 5 bis 2 Volt äquivalent ist.

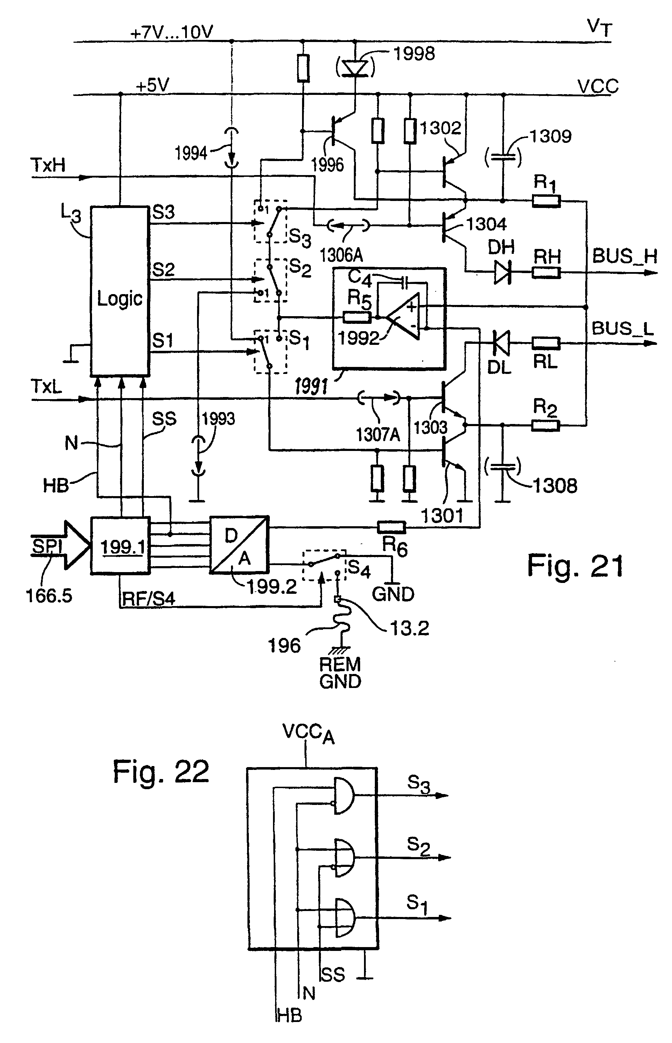

Die Erfindung deckt die Vorrichtung gemäß der **Fig. 15** zum einen dahingehend ab, daß die beiden Offset-Quellen Q_{SL} und Q_{SH} alternativ nutzbar sind, wie etwas detaillierter beispielsweise in **Fig. 21, Fig. 22** und **Fig. 24** ohne Beschränkung der Allgemeinheit veranschaulicht. Es ist dann im Grunde jeweils immer nur eine spannungsvorgabe und insoweit nur ein D/A-Wandler erforderlich, der bei der Auswahl aus beiden Alternativen der jeweils aktuell benötigten Vorgabe entsprechend zu laden / umzuladen ist.

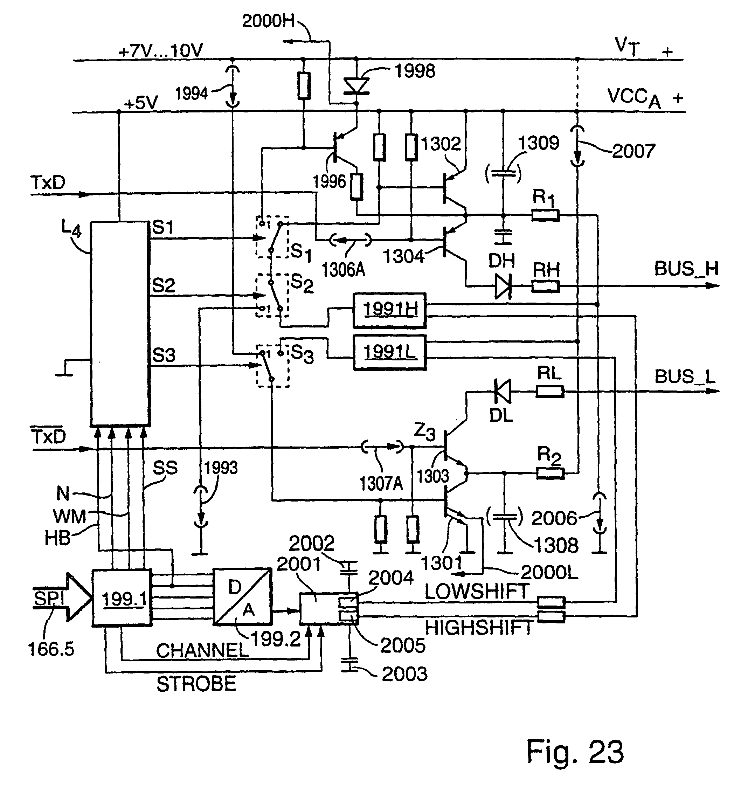

Gleichwohl deckt die Erfindung die Vorrichtung gemäß der **Fig. 15** auch dahingehend ab, daß die beiden Offset-Quellen Q_{SL} und Q_{SH} simultan und unabhängig voneinander nutzbar sind, wie etwas detaillierter beispielsweise in **Fig. 23** ohne Beschränkung der Allgemeinheit veranschaulicht. Auf die drei genannten Figuren wird noch weiter unten Bezug genommen.

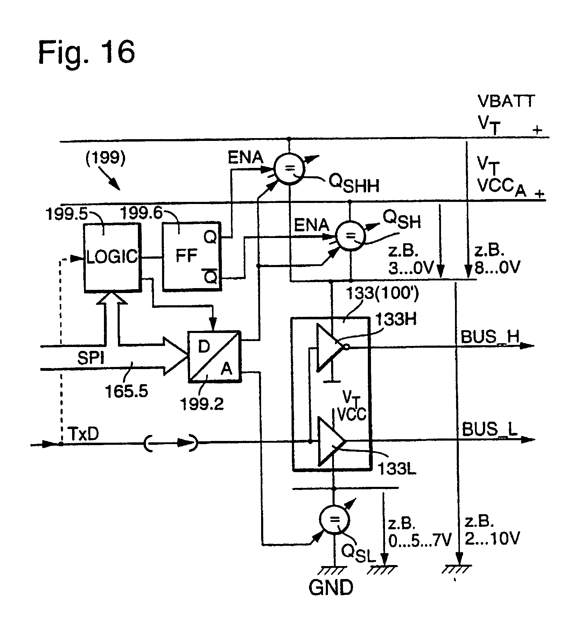

Die Anlage wenigstens zweier gleichzeitig nutzbarer Offset-Quellen Q_{SL} und Q_{SH} erlaubt auch die Vorrichtung gemäß **Fig. 16,** indem dort ein D/A-Wandler 199.2 mit zwei dementsprechenden Ausgängen zur Vorgabe zweier Offset-Werte vorgesehen ist. Dabei ist beispielhaft ein Ausgang der Quelle Q_{SL} fest zugeordnet und der andere Ausgang ausschließlich zur wahlweisen Steuerung einer ersten Quelle Q_{SH} (an der Versorgungsschiene V_{T} oder VCC) und einer zweiten Quelle Q_{SHH} (an der potentialmäßig höheren Versorgungsschiene VBATT oder V_{T}) vorgesehen. Wie bei den vorherigen Beispielen ist auch hier eine logische Ansteuerung beider Endstufen durch wenigstens einen eingeprägten Strompfad vorgesehen.

Der den D/A-Wandler 199.2 ansteuernde Digitalpfad 166.5 steuert des weiteren eine Logik 199.5 an, welche ihrerseits sowohl mit dem D/A-Wandler 199.2 verbunden ist als auch ein Flipflop 199.6 ansteuert. Die beiden zueinander invertierten Ausgänge des Flipflops 199.6 steuern die Offset-Quellen Q_{SH} und Q_{SHH} im Sinne einer Auswahl an. Nach Maßgabe durch den Zustand des Flip-flops 199.6 liegt ein aktives ENAble-Signal an der einen oder anderen Offset-Quelle an, d.h., es ist entweder die Offset-Quelle Q_{SH} an der Versorgungsschiene V_{T} oder VCC oder die Offset-Quelle Q_{SHH} an der (noch positiveren) Versorgungsschiene VBATT oder V_{T} aktiv, d.h. nie beide gleichzeitig. Im inaktiven Zustand kann jede der Offset-Quellen Q_{SH} und Q_{SHH} als Kurzschluß gedacht werden (oder in Praxis als Quelle mit unbedeutendem Restspannungsabfall).

Die Logik 199.5 kann so so beschaffen sein, daß sie beim Ansteuern des Flipflops 199.6 zwecks Zustandswechsel auch den D/A-Wandler 199.2 zwecks Umladung wenigstens einer Sollwertvorgabe, insbesondere im Sinne einer Auswahl für die Quelle Q_{SH} oder Q_{SHH}, ansteuern kann. Aus den obigen Erläuterungen sind die in **Fig. 16** eingetragenen Spannungsbereiche selbsterklärend. Diese Vorrichtung läßt also ein dominantes H-Quellpotential zu, das wahlweise unterhalb oder oberhalb des busspezifisch normalen H-Quellpotentials liegen bzw. gleichwohl bedarfsweise zwischen beiden umgetastet werden kann. In den Rahmen der Erfindung fällt weiter, durch entsprechende Ausbildung der Logik 199.5 eine solche Umschaltung auch verkettet mit dem Datensignal TxD zu ermöglichen, was durch den gestrichelten Signalpfad zur Logik 199.5 versinnbildlicht ist.

Mit den bis hierher beschriebenen Vorrichtungen ist also eine Verschiebung eines oder beider einspeisenden dominanten Quellenpegel/s zum einen in eine Richtung möglich, in die auch das Empfangspegelfenster eines Busteilnehmers zwangsläufig verschoben wird, wenn er über eine fehlerhafte, stromführende und insoweit einen eigenen Fehlspannungsabfall verursachende Verbindung mit einem Bezugspotential verfügt, wie z.B. bei einer fehlerhaften Masseverbindung eines Steuergerätes als Busteilnehmer mit der Karosserie eines Kraftfahrzeugs der Fall.

Zum anderen ist damit aber nach Maßgabe durch die zeitliche Ansteuerung eines oder mehrerer D/A-Wandler auch umgekehrt eine Verschiebung eines oder beider einspeisender dominanter Quellenpegel/s von einem bzw. zwei höheren Werten beginnend gegenläufig zur Verschiebungsrichtung bzw. Ablage des Empfangspegelfensters eines entsprechend fehlerhaften Busteilnehmers möglich. Diese Fähigkeit des Schaltkreises 200 erschließt spezifische Testmöglichkeiten sowohl vor als auch nach dem Eintritt eines Potentialfehlerfalles in einem Busnetz.

Solche über ein ganzes Busnetz mit vielen Teilnehmern sich erstreckende Tests werden vereinfacht und beschleunigt bei Fortbildung der Vorrichtung beispielsweise gemäß der **Fig. 17.**

Das bezüglich **Fig. 18** bereits ausgeführte gilt uneingeschränkt auch für diese Vorrichtung. Es ist hier zum einen ein D/A-Wandler 199.2 vorgesehen, der die Ausgabe von hier beispielsweise drei analogen Steuer- bzw. Sollwerten an entsprechende Offset-Quellen Q_{SL}, Q_{SH} und Q_{SHH} erlaubt. Ohne Beschränkung der Allgemeinheit können alle oder nur zwei dieser Werte simultan verfügbar sein. Der D/A-Wandler 199.2 ist auch hier über einen digitalen Pfad 166.5 beispielsweise vom SPI-Typ ansteuerbar. Ebenfalls durch den digitalen Pfad 166.5 ansteuerbar ist des weiteren eine Logik 199.7, die über eine bidirektionale Verbindung 199.8 mit dem D/A-Wandler 199.2 zusammenwirkt.

Die Logik 199.7 kann vom SPI-Taktsignal angetrieben sein; gleichwohl kann auch die Zufuhr eines externen Zeitbasis-Signals vorgesehen sein. Ohne Beschränkung der Allgemeinheit der Erfindung könnte ein entsprechendes Zeitbasis-Signal von einem Zeitgeber innerhalb des Schaltkreises 200 - hier beispielsweise von einem sog. Weck-Expander 165' - abgeleitet sein oder - falls letzterer seinerseits gemäß **Fig. 12** etwa über 164a von einer Watchdog-Funktion 164 mit einem Zeit- oder Frequenzsignal versorgt wird - entweder mit einer Periodendauer eines internen Referenzsignales der Watchdog-Funktion 164 zeitlich verkettet bzw. aus einem Abzweig der Verbindung 164a in **Fig. 12** bezogen sein.

Der Logik 199.7 kann außerdem auch noch das Sendesignal TxD zuführbar sein. Die Endstufen 133L und 133H werden hier beispielhaft über jeweils individuelle logische Pfade mit Stromeinprägung von der Logik 199.7 angesteuert. Des weiteren ist noch ein Meßverstärker 199.8 angedeutet, der zur Generation einer Größe entsprechend der Differenz zwischen dem Chip- oder geräteinternen Massepotential und einer externen Bezugsmasse REM GND beschaltet ist. Diese Größe ist hier beispielhaft dem D/A-Wandler 199.2 zuführbar.

Die Beschaffenheit und Funktion der Logik 199.7 in Verbindung mit dem D/A-Wandler 199.2 ist folgende.

Angetrieben durch eine Taktsignal, das entweder das Taktsignal des Pfades 166.5 oder aber ein gemäß obiger Beschreibung bezogenes sein kann, erzeugt die Logik 199.7 nach Maßgabe durch über den Pfad 166.5 empfangene Daten u.a. Steuersignale für den D/A-Wandler 199.2. Diese Signale befähigen den D/A-Wandler zur Erzeugung und Bereitstellung rampenförmig definiert sich verändernder Sollwertvogaben des A/D-Wandlers, und/oder für ein freizügiges, definiertes Verändern der dominanten Fensterweite (Squeezing der Busbit-Augenweite), sowie für die Auswahl bzw. Umschaltung (ENAbling) der entsprechenden Zieloffset-Quelle(n) Q_{SL}, Q_{SH} und/oder Q_{SHH}.

Ohne Beschränkung der Allgemeinheit der Erfindung kann dabei die erste Funktion (sog. "Ramping") sowohl für ein- als auch zeidrähtige Tests und die zweite Funktion ("sog. Squeezing") bevorzugt für zweidrähtige Tests vorgesehen sein, je nach Ausgestaltung einer die obengenannten Eigenschaften nutzenden Diagnose-Software. Dabei kann die Bereitstellung von analogen Spannungstufen, welche eine Spannungsrampe annähern bzw. ein Squeeze-In- oder Dekrement repräsentieren, erforderlichenfalls optional zeitschlitzverkettet mit dem nicht notwendigerweise synchronen Datensignal TxD vorgesehen sein.

Beispielsweise kann so nach Maßgabe durch eine über den Pfad 166.5, 201.1 vom Microcontroller 21 ladbare Zahl M ein Rampenin- oder -dekrement frühestens oder genau nach einer durch diese Zahl bestimmten Anzahl von Sendebitzeiten erfolgen. Wenn diese Zahl M von allen empfangsfähigen Busteilnehmern empfangbar ist, kann eine entsprechend ausgebildete Test-Software mit dieser vorgebbaren Zahl M quasi ein elementares Verifikations-Vorwissen zu einem bevorstehenden Testzyklus busweit vermitteln.

In Verbindung mit weiter unten beschriebenen Empfängermerkmalen werden Plausibilitätsprüfungen innerhalb der Busteilnehmer so unter geringer Belastung des Busnetzes möglich. Dies ist der Schlüssel für eine hohe Beschleunigung entsprechender Tests. In diesem Zusammenhang wird ausdrücklich darauf hingewiesen, daß die Vorrichtung auch noch figürlich nicht dargestellte Mittel umfassen kann, welche eine Strombezugsumschaltung der Endstufe 133H zwischen den Offset-Quellen Q_{SH} und Q_{SHH} innerhalb eines Zeitraumes zu leisten vermögen, der kürzer als die Bus-Bitzeit ist.

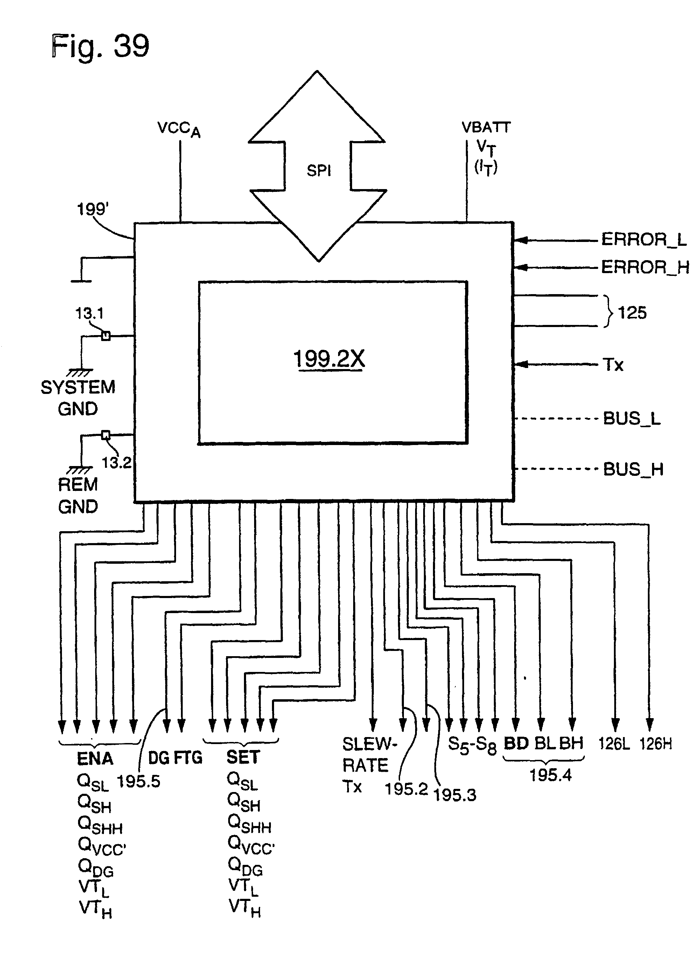

Einige der oben erläuterten Vorrichtungselemente sind in der **Fig. 16** gestrichelt eingerahmt und mit 199.2X bezeichnet, da der in diesem gestrichelten Rahmen gefaßte Funktionalitätsumfang wie oben erläutert im Rahmen der Erfindung durch eine einzige integrale Funktionalität 199.2X innerhalb der Potentialsteuervorrichtung 199 realisiert sein kann. Hierauf wird i.V. mit **Fig. 39** noch Bezug genommen.

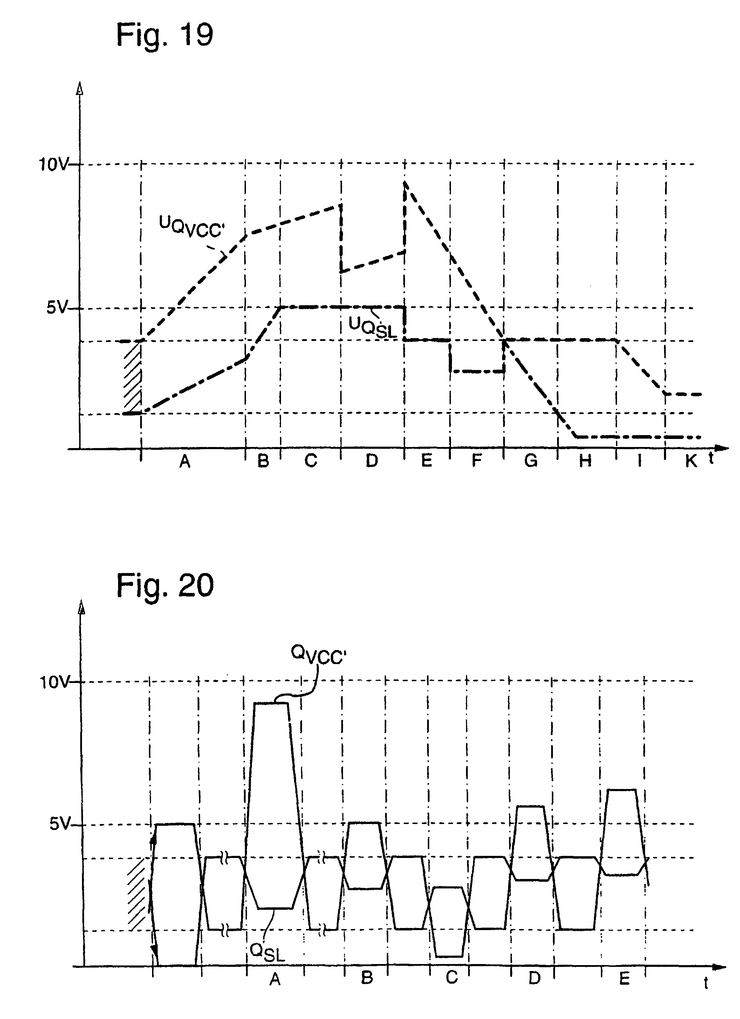

In **Fig. 19** ist vereinfacht in Form eines Hüllschemas beispielhaft aufgetragen, wie mit der Vorrichtung gemäß **Fig. 17** die auf den Bus einspeisenden dominanten Quellenpegel beispielhaft veränderbar sind. **Fig. 20** veranschaulicht eine Vergrößerung auf Bitebene, wenn das vorgenannte Merkmal einer Umschaltbarkeit des Strombezugs der Endstufe 133H zwischen den Offset-Quellen Q_{SH} und Q_{SHH} binnen einer Zeit kürzer als die Bus-Bitzeit möglich ist. Daraus ist ersichtlich, daß unter bestimmten Voraussetzungen eine Stromeinspeisung in eine Busader nicht möglich ist, was zu Diskriminationszwecken genutzt werden kann.

Je nach Anwendungsspektrum des Schaltkreises 200 kann der Grad der Ausbildung der oben genannten Vorrichtungsmerkmale sehr unterschiedlich sein. In jedem Falle können Merkmale eines Beispieles ohne jede Beschränkung mit Merkmalen eines anderen Beispiels kombiniert werden, ohne daß dadurch der Rahmen der Erfindung verlassen wird. Die **Figen. 21 - 23** vermitteln in diesem Sinne anhand vereinfachter Wirkschemata einige wenige praktische Beispiele, um die verschiedenen Funktionalitäten plausibel zu machen; sie stellen insoweit keinerlei Beschränkung der Erfindung dar. Vielmehr können - z.B. je nach Realisierungstechnologie in einem Schaltkreis oder Modul - auch weit davon abweichende Wirkschemata realisiert werden, um die verdeutlichte Funktionalität in der Praxis zu erreichen.

**Fig. 21** zeigt in diesem Sinne ein Wirkschema, in welchem sowohl der Potentialsteuervorrichtung 199 zuordnungsfähige als auch dem Bus-Transceiver 100, 100' - insbesondere dessen Endstufe 133 - zuordnungsfähige Elemente versammelt sind. Mit Ausnahme der optional vorgesehenen Verkettung der Offset-Quellen-Beeinflussung mit dem Datensignal TxD vermittelt dieses Ausführungsbeispiel einer Potentialsteuervorrichtung und kooperierender Vorrichtungselemente im Bus-Transceiver in etwa die Funktionalität des in **Fig. 16** blockschematisch Dargestellten.

1303 ist der (normalerweise) gegen GND schaltende L-Schalter der L-Endstufe 133L und 1304 der (normalerweise) gegen VCC_{A} schaltende H-Schalter der H-Endstufe 133H. Die hier beispielhaft als bipolare, komplementäre Transistoren werden basisseitig durch eingeprägte Strompfade 1307A bzw. 1306A mit dem jeweiligen Datensignal Tx_L bzw. Tx_H beaufschlagt. Die Kollektoren der Transistoren 1303 und 1304 speisen in an sich bekannter Weise über Schutzdioden DL bzw. DH und ggfs. kleine Schutzwiderstände RL bzw. RH die Busadern BUS_L bzw. BUS_H.

Die Transistoren 1301 und 1302 erfüllen in Abwechslung miteinander eine insgesamt dreifache Funktion, wozu sie eingangsseitig über durch Digitalsignale S1 und S2 steuerbare Analog-UM-Schalter S₁ und S₂ ansteuerbar sind.

In der beispielhaften Schalterstellung 1 des Analog-UM-Schalters S₁ wird der Transistor 1301 **erstens** durch die vom Potential V_{T} speisende Stromquelle 1994 in Sättigung gehalten, wodurch der Emitter des Transistors 1303 nahe bei Massepotential GND liegt. Der Transistor 1301 "deaktiviert" quasi die entsprechende Offset-Quelle Q_{SL}.

Durch diese Maßnahme wird zweitens der Widerstand R₂ des Spannungsteilers aus R₁ und R₂ auch mit GND verbunden, so daß dieser das Teilverhältnis R₂/(R₁+R₂) hat.

Über den Analog-UM-Schalter S₂ in Stellung 2 liegt drittens die Basis des Transistors 1302 am Ausgang des Reglers 1991. Damit fungiert der Transistor 1302 in Verbindung mit dem Regler 1991 als Ausgangsstufe einer Offset-Quelle Q_{SH}.

Der Regler 1991 kann in bekannter Weise aufgebaut sein. Unter bestimmten Bedingungen kann er auch auf einem Komparator 1992 basieren, wie im Beispiel angenommen. Die beispielhaft angedeutete Kapazität C₄ i.V. mit R₅ und R₆ sind dann regelungstechnischen Anforderungen gemäß an ein nicht ideales Phasendrehverhalten der Transistoren 1301 und 1302 ggfs. anzupassen. Je nach den Eigenschaften des Komparators können auch andere Kompensationsmittel zweckmäßig sein. Die für EMV-Schutzzwecke nützlichen Kapazitäten 1308 und 1309 können bei einem anders konfigurierten Regler wiederum vorteilhaft sein.

Dem Regler 1991 wird eine analoge Sollwertvorgabe des D/A-Wandlers 199.2 zugeführt. Da sich über den Transistor 1302 und den o.g. Spannungsteiler aus R₁ und R₂ der Regelkreis schließt, kann die am Emitter des Transistors 1304 anstehende Gleichspannung als das Potential VCC_{A} absenkende Offset-Spannung geregelt werden (Quelle Q_{SH}).

Ersichtlich liegen bei umgekehrter Ansteuerung der beiden Analog-UM-Schalter S₁ und S₂ umgekehrte Verhältnisse vor: Es wird dann der Transistor 1302 durch die Stromquelle 1993 in Sättigung gehalten, während der Transistor 1301 als Regelendstufe fungierend den Regelkreis schließt. Der vorgenannte Spannungsteiler aus R₁ und R₂ liegt dann quasi an VCC_{A} und hat dann das Übersetzungsverhältnis R₁/(R₁+R₂). Bei R₁ = R₂ wirkt der Spannungsteiler sowohl bei L-Shift als auch bei H-Shift identisch und bewirkt eine gekrümmte Regelkennlinie, die unter bestimmten Voraussetzungen im Hinblick auf die Umladung des D/A-Wandlers 199.2 zwecks eindrähtig abwechselnder Tests vorteilhaft sein kann.

Die Auswahllogik L₃ steuern mit einem Signal S3 einen weiteren Analog-UM-Schalter S3 an. Über diesen besteht die Möglichkeit, den Ausgang des Reglers 1991 bei Wahrheit des High Bits HB vom Transistor 1302 auf den von der positiveren Versorgungsschinene V_{T} gespeisten Transistor 1996 umzuschalten; dabei ist dann der Transistor 1302 wirkungslos. Die Diode 1998 ist technologieabhängig zweckmäßig. Ein Zenerdurchbruch des Transistors 1302 bei sättigungsnahem Transistor 1996 ist im Falle der Realisierung in einer Hochvolttechnologie bei relevanten Differenzen zwischen V_{T} und VCC_{A} auszuschließen.

Der D/A-Wandler 199.2 wird seinerseits von einer Logik 199.1 angesteuert, die ihrerseits über den digitalen Pfad 166.5 angesteuert wird. Die Logik 199.1 hat dabei die Funktion eines Interface zum Digitalpfad 166.5 und kann insoweit wenigstens ein Register umfassen, in dem wenigstens ein Teil eines seriell empfangenen Datentelegramms vorübergehend haltbar ist. Das in **Fig. 16** dargestellte Flipflop ist als Speicherzelle darin enthalten. Z.B. eine zum D/A-Wandler führende Bit-Leitung HB (für High Bit) sowie zwei weitere Bit-Leitungen N (für Normal oder Override) und SS (für Shift Select) sind an die Auswahllogik L₃ geführt (Die Override-Funktion wird im nächster Absatz erläutert). Eine beispielhafte Realisierung derselben ist in **Fig. 22** wiedergegeben; sie ist abhängig von der Wahrheitsbewertung ihrer Eingangssignale gestaltet.

Die oben erwähnte Override-Funktion ist folgende: Bei Wahrheit des Signals N wird der Betriebszustand der Endstufe für normale Buskommunikation eingesteuert, unabhängig davon, ob gleichzeitig eine HB-Ansteuerung erfolgt oder welches der beiden dominanten Quellpotentiale GND und VCC_{A} zur "Manipulation" durch Offset-Shift nach Maßgabe durch den D/A-Wandler angewählt ist.

Von der Logik 199.1 führt noch ein Ansteuerpfad zu einem weiteren Analog-UM-Schalter S₄, über den der Masseanschluß des D/A-Wandlers 199.2 und des Reglers 1991 in Abhängigkeit von einem Steuersignal S₄ (ReFerence) aus der Logik 199.1 wahlweise an z.B. das Potential Chip GND oder den Anschluß 13.2 für das externe Bezugspotential REM GND schaltbar ist.

Ohne Beschränkung der Erfindung deckt eine Funktionalität gemäß diesem Ausführungsbeispiel schon viele eindrähtig ausführbare Potentialtests ab, die in einem Zeitpunkt jeweils eine Offset-Beeinflussung nur eines speisenden dominanten Quellenpegels erfordern.

Die Vorrichtung gemäß **Fig. 23** stellt eine Erweiterung für Anwendungen dar, in denen eine simultane Offset-Beeinflussung beider speisender dominanter Quellenpegel erforderlich ist. Auch diese beispielhafte Vorrichtung stellt keinerlei Beschränkung der Erfindung dar und dient nur zur Funktionalitätsveranschaulichung. Es sind hier beispielhaft zwei separate Regler 1991H und 1991L vorgesehen und eine durch Hilfsstromquellen 1312 und 1313 ermöglichte ungeteilte Erfassung der Ist-Offsets an den Kollektoren der Transistoren 1301 und 1302. Die entsprechende Logik 199.1 verfügt über einen zusätzlichen Ausgang WM (Wire Mode).

Die entsprechende Logik L4 kann ähnlich wie die Logik L3 ausgeführt sein. Dem D/A-Wandler 199.2 ist hier beispielsweise eine zweikanalige Hold-Einrichtung 2001 mit Signalstützen 2002 und 2003 nachgeschaltet, welche von der Interface-Logik 199.1 über zwei zusätzliche Verbindungen (Channel und Strobe) angesteuert und mit ihren zwei Ausgängen 2004 und 2005 die Sollwerteingänge der Regler 199L und 1991H speist. Als Besonderheit sind ein separates Emitterpitch 2000L des Transistors 1301 und eine Abtastleitung 2000H an der Diode 1998 vorgesehen. Als zusätzliche Schutzmaßnahme für den Schaltkreis 200 unter Testbedingungen bei Bus-Fehlern können daran abgreifbare Größen in eine Überlastabschaltung etwa der Spannungsregler 20U und 20A gemäß **Fig. 13** einbezogen sein.

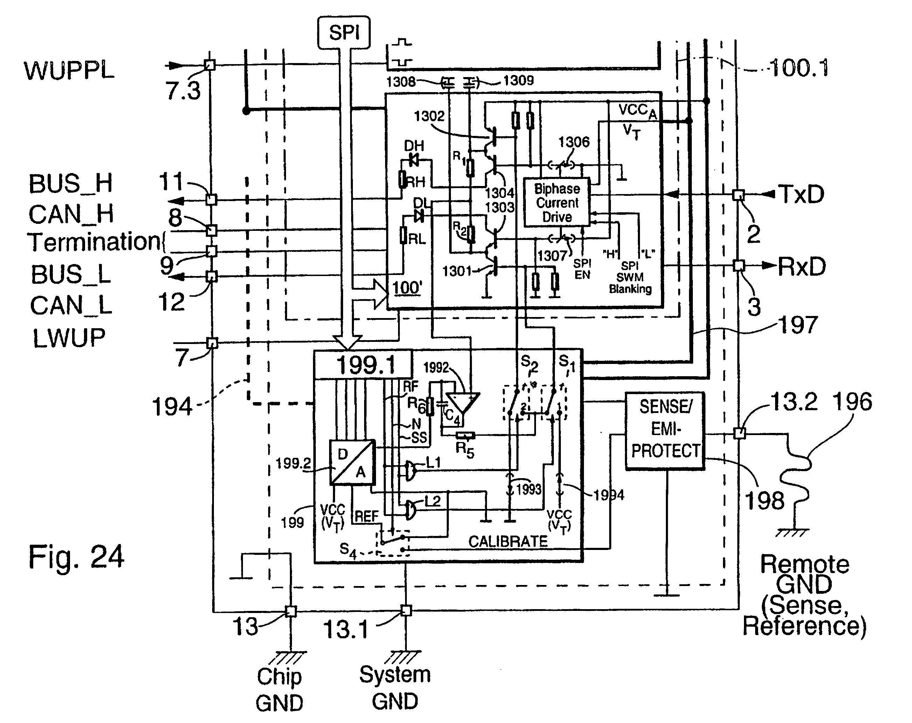

Eine eindeutige Zuordnungsfähigkeit bestimmter Vorrichtungselemente zum Transceiver 100, 100' bzw. zur Potentialsteuervorrichtung 199 ist in der Praxis nicht immer gegeben und im Falle eines z.B. integrierten Halbleiterschaltkreises 200 nur bei relativ geringem Grad der Merkmalsausbildung "Offsetbeeinflussung" gegeben. Zudem kann es z.B. sinnvoll sein, gewisse, der Potentialsteuervorrichtung 199 in Strenge zuzurechnende Elemente im Bus-Transceiver eingebettet zu integrieren, wie z.B. in dem in **Fig. 24** (nur für Sendebelange) illustrierten Fall.

Dieses Beispiel veranschaulicht in schematischer Vereinfachung die Verteilung beispielhafter Elemente einer Lösung gemäß **Fig. 15** für den Fall zweier ungleichzeitig nutzbarer Offset-Quellen Q_{SL} und Q_{SH} und für den Sonderfall, daß das einspeisende dominante H-Potential nicht größer als VCC_{A} zu sein braucht.

Es ist erkennbar, daß bei einer solchen Lösung die die Potentialverschiebung bewirkenden Elemente - nämlich die Transistoren 1301 und 1302 - zweckmäßig als Bestandteile einer thermisch ausbalancierten Sendeendstufe unschwer integrierbar sind. Kennzeichenmäßig sind sie deshalb hier auch der Sendeendstufe zugeordnet. Auch dieses Vorrichtungsbeispiel dient ausschließlich der Veranschaulichung, in welcher Auflösung bzw. Verteilung Vorrichtungsbestandteile ausgebildet sein können und stellt keinerlei Einschränkung der Erfindung dar.

Die vorgenannten Vorrichtungen weisen die gemeinsame Eigenschaft auf, daß sie die in den **Figen. 14 - 18** symbolisierten Offset-Quellen tatsächlich realisieren.

Dies bedeutet, daß das auf der Busader BUS_L bzw. BUS_H tatsächlich bewirkte Potential aufgrund des unvermeidbaren Strömungsspannungsabfalles an der Schutzdiode DL bzw. DH und dem Schutzwiderstand RL bzw. RH von der geregelten Klemmenspannung der Offsetquelle Q_{SL} bzw. Q_{SH} oder Q_{SHH} stets um einen gewissen Betrag abweicht.

Dies kann von einem geeigneten Test-Programm ausgeglichen werden, indem zum einen im Microcontroller 21 durch Abzug bzw. Aufaddition eines entsprechenden festen, korrigierenden Digitalwertes diesem Versatz Rechnung getragen werden kann, oder indem eine generell um einen mittleren Fehlspannungsabfall bereits verschobene Werteliste für die D/A-Wandlervorgaben zur Sollwertbildung für Offset-Quellen im Microcontroller abgelegt bzw. benutzt wird.

Zum anderen kann - je nach Test-Software - für Praktikabilität die Auflösungshöhe eingesetzter D/A-Wandler und die Absolutgenauigkeit der Aderspannungen mit zunehmender Zahl der Teilnehmer im Netz an Bedeutung verlieren, wenn zwecks Testschnelligkeit die im Schaltkreis oder Elektronik-Modul 200 installierten Funktionalitäten eine hohe Ausnutzung desselben zugunsten eines möglichst geringen Signaldurchsatzes über das Busnetz und zugunsten geringsmöglicher Verlustzeiten im SPI-Pfad 201.1 zwischen Microcontrollern 21 und Schaltkreis bzw. Modul 200 in Busteilnehmern erlauben.

Die nachfolgenden Vorrichtungen zielen auf Anwendungen ab, in denen demgegenüber eine möglichst direkte, und insoweit genauere Festlegung einer Aderspannung - d.h. eine Spannungseinprägung - testhalber wünschenswert ist.

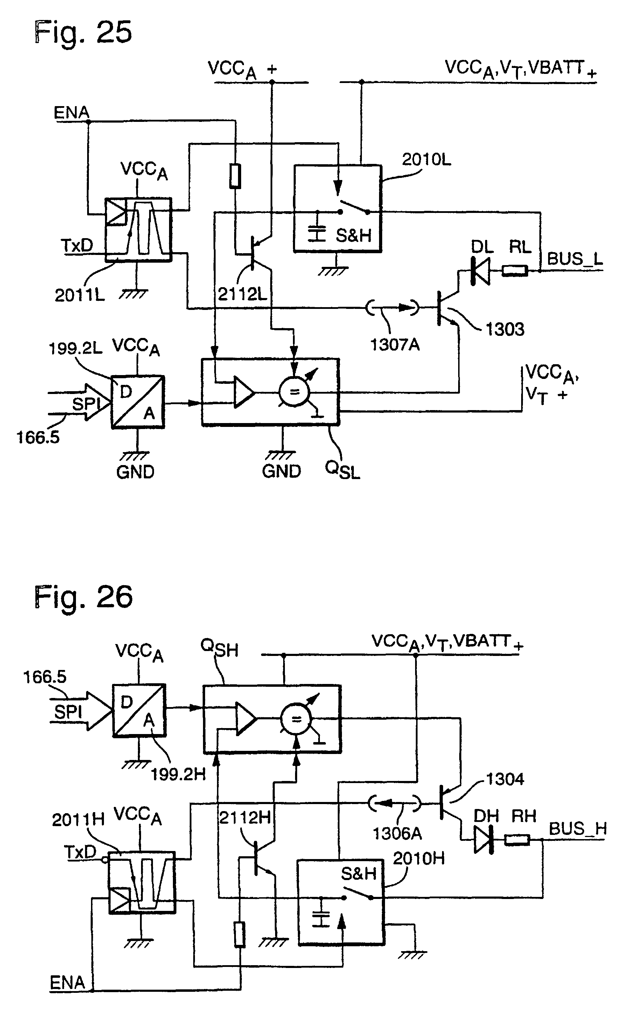

Dabei betrifft das Beispiel gemäß **Fig. 25** eine entsprechende Potentialvorgabe auf die Ader BUS_L, das Beispiel gemäß **Fig. 26** eine solche auf die Ader BUS_H, wobei jeweils nur wesentliche Elemente in beispielhaft möglicher Ausführung dargestellt sind. Insbesondere sind Elemente weggelassen, die eine Regelung unterbinden, wenn z.B. Potentialverhältnisse vorliegen, welche eine Bestromung einer Busader unter Offset nicht erlauben. Soweit einander entsprechende Teile der Funktionalität der Potentialsteuervorrichtung 199 zuzurechnen wären, sind sie auch hier durch die Buchstaben L oder H aderspezifisch voneinander unterschieden.

Beiden Vorrichtungen gemeinsam ist als wesentliches Element eine zwischen Versorgungsklemmen GND und z.B. V_{T} oder VBATT liegende Sample & Hold-Schaltung 2010L bzw. 2010H.

Sie weist einen mit der Busader BUS_L bzw. BUS_H beispielsweise unmittelbar verbundenen Eingang auf. Des weiteren ist eine vorzugsweise vom Datensignal TxD flankengetriggerte Impulsauslöseschaltung 2011L bzw. 2011H vorgesehen, die einen sehr kurzen, innerhalb der Datenbitzeit auf die gepfeilten Taktflanke folgenden Abtast-Impuls SP erzeugt, der hier beispielhaft im ersten Falle nach GND und im zweiten Falle nach V_{T} bzw.

VBATT gerichtet ist; die zweckmäßige Polarität richtet sich nach der Technologie des verwendeten Samplers.

Die Sample & Hold-Schaltung 2010L bzw. 2010H umfaßt neben dem eingangsseitigen Sampler noch ein Haltglied und, erforderlichenfalls, auch ausgangsseitige Impedanzkonversionsmittel nach dem Stande der Technik.

Der Transistor 1303 bzw. 1304 ist durch die jeweils wirksame aktive Flanke des Datensignals TxD bereits leitend gesteuert, wenn der Abtastimpuls ausgelöst wird (Positiv-Maskierung). Durch diese Maßnahme ist kurze Zeit später im Augenblick des Abtastens über den leitenden Transistor 1303 bzw. 1304 der Regelkreis vom Ausgang der steuerbaren Offset-Quelle QSL bzw. QSH über den Endstufentransistor 1301 bzw. 1302 sowie die Diode DL bzw. DH und den Schutzwiderstand DL bzw. DH bis zum Eingang der Sample & Hold-Schaltung geschlossen.

Die von der Sample & Hold-Schaltung 2010L bzw. 2010H ausgegebene Abtastgröße und die Sollwertvorgabe vom D/A-Wandler 199.2L bzw. 199.2H werden über Verbindungen der Offset-Quelle Q_{SL} bzw. Q_{SH} zwecks deren Einstellung zugeführt. Durch ein ENA- bzw. NENA-Signal am Aktivierungseingang der Impulsauslöseschaltung 2011L bzw. 2011H und einem Deaktivierungseingang der Offset-Quelle Q_{SL} bzw. Q_{SH} kann letztere zwecks KurzschluB gegen Masse GND bzw. gegen die Schiene V_{T} oder angesteuert und die Abtastimpulserzeugung in 2011L bzw. 2011H gesperrt werden. In diesem Zustand ist die betroffene Offset-Quelle Q_{SL} bzw. Q_{SH} dann unwirksam.

Selbstverständlich kann im Rahmen der Erfindung die Vorrichtung gemäß **Fig. 26** wie oben schon gezeigt auch auf zwei entsprechende Quellen Q_{SH} und Q_{SHH} erweitert werden, oder aber eine diese substituierende Ersatzversorgungsquelle Q_{VCC'} vorgesehen werden. Auch können beide Beispiele wahlweise für abwechselnde oder gleichzeitige Betreibbarkeit ausgebildet werden.

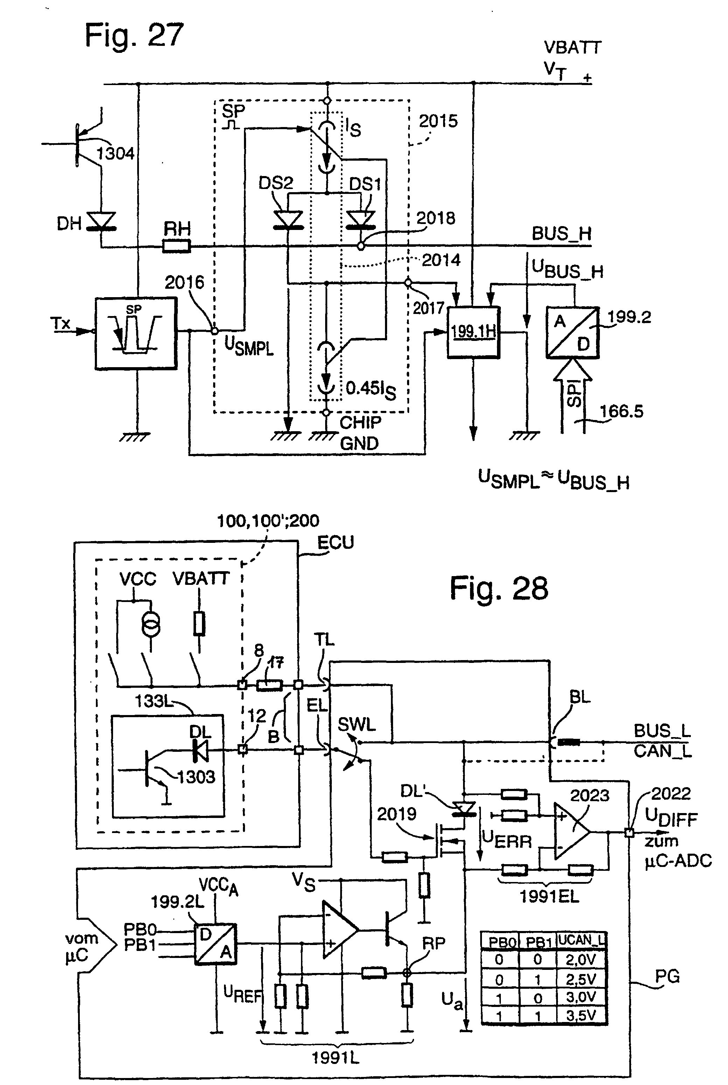

**Fig. 27** veranschaulicht einen für diese Zwecke geeigneten Sampler 2015 - hier beispielsweise beschaltet für die Busader BUS_H -, der z.B. monolithisch besonders einfach und genau realisierbar ist.

Er verwendet vorzugsweise eine komplementär-balancierte, am Eingang 2016 samplegepulste Stromquellenstruktur 2014 im 20/9-Pitch-Design, sowie eine mit der Busader BUS_H verbundene 2018 Abtastdiode DS1 und eine mit dem Eingang eines Halte-Reglers 199H verbundene Kompensationsdiode DS2 mit einem eingeprägten, zwangsläufigen Flußstromverhältnis von 0.55 zu 0.45. Da der erforderliche Strom Iₛ sehr gering ist, nur im Testbetrieb überhaupt gesampelt wird und entsprechende gesteuerte Stromquellenstrukturen 2015 monolithisch mit geringem Eigenstromverbrauch auslegbar sind, sind besondere Ansteuerungen bzw. Stromfreigabemittel zur Stromersparnis überflüssig.

Die Abtastdiode DS1 erfüllt eine wichtige Schutzfunktion für den nachgeschalteten Regler im Falle eines Kurzschlusses gegen das Potential UBATT bzw. noch höherer Störspannungsbeaufschlagung der Busader BUS_H. Bei geeigneter monolithischer Realisierung der Dioden DS1 und DS2 entsprechend der Busader-Schutzdiode DH liegt, wenn der Endstufentransistor 1304 leitet, die Abtastspannung am Ausgang 2017 nahe bei der tatsächlichen Aderspannung U_{BUS_H}, so daß der residuelle Fehler kleiner als die praktische Auflösungsabstufung von hier relevanten D/A-Wandlern 199.2 ausfällt.

Die Stromquellenstruktur 2014 kann einschließlich der beiden Diodenstrecken DS1 und DS2 klein, kapazitätsarm und -balanciert zu einem Abtastkern 2015 integriert werden, der außer Anschlüssen VBATT bzw. V_{T} und GND für seine Stromversorgung und den Busaderknoten 2018 nur noch zwei weitere Anschlüsse 2016 und 2017 aufweist. Bei nur kleinen Abtastströmen wie vorliegend von Interesse und entsprechender Berücksichtigung im monolithischen Design kann eine gegenseitige Kompensation von Richtspannungen in der Zelle 2015 realisiert und somit - trotz schneller Reaktion dieses Samplers (und damit auch einer möglichen Regelung) auf Gleichspannungsänderungen am Buskoppelknoten 2018 - ein relativ hoher Störabstand gegenüber hochfrequenten Störungen auf der Busader erreicht werden (EMV).

Dieses Vorrichtungselement ist also vorteilhaft insoweit, als eine unvermeidbare Fehlerspannung zwar auch hier entsteht, aber noch am selben Ort und bei derselben monolithischen Struktur, in der sie zwangsläufig verursacht wird, unter Nutzung genau desselben physikalischen Wirkprinzips, das ihrer Entstehung zugrundeliegt, kompensiert wird.

Daraus folgt auch eine innerhalb weiter Grenzen realisierbare thermische Invarianz der Fehlerkompensation. Aus diesen Gründen kann auf sonstige Kompensationsunterstützung etwa seitens des Schaltkreises 200 oder gar eine Beanspruchung eines externen Microcontrollers 21 zum Zwecke einer rechnerischen Kompensation verzichtet werden.

Auch der beschriebene Sampler stellt selbstverständlich keinerlei Einschränkung der Erfindung dar; vielmehr fallen in deren Rahmen auch andere Lösungen zur Verwirklichung sowohl einer Rückwärtsisolation gegen Überspannungen auf einer Busader und einer entsprechenden Fehlspannungskompensation.

Die Vorrichtung gemäß der **Fig. 28** wird einem ganz anders gelagerten Anwendungsfall gerecht, bei dem ein leistungsfähiger Microcontroller mit dem Schaltkreis 200 zusammenarbeitet, die Inanspruchnahme seiner Rechenleistung und eine entsprechende Inanspruchnahme des digitalen Pfades 166.5, 201.1 nicht stört oder aber eine Verweiklichung eines in obigem Sinne schützenden und physikalisch fehlerspannungskompensierten Samplers gemäß **Fig. 27** o.ä. nicht möglich ist.

In dieser Vorrichtung für die Busader BUS_L wird die eigentliche Ader-Endstufe 133L nicht zwecks Einspeisung des erstrebten Aderpotentials, sondern nur als Treiberstufe zur Ansteuerung eines eine Ersatzeinspeisung leistenden Ersatzschalters 2019 benutzt, der seinerseits durch eine separate Schutzdiode DL' mit der Busader BUS_L in Verbindung steht. Der vom dominanten Einspeispotential in den Bus abfließende Strom nimmt hier also einen ganz anderen Weg, nämlich vom Regelpunt RP am Ausgang des Aderpotentialreglers 1991L über die Schaltstrecke des Transistors 2019 und die Schutzdiode DL'. Um dies zu ermöglichen, ist ein niederohmiger Umschalter SWL vorgesehen, der für die Dauer entsprechender Potentialtests in den gezeigten Schaltzustand zu aktivieren ist.

Der Regler 1991L wird von einem D/A-Wandler 199.2L mit einem Sollwert für die am am Regelpunkt RP einzustellende Spannung versorgt. Die Fehlerspannung U_{ERR}, die längs den Elementen 2019 und DL' stromflußbedingt abfällt, wird mit einem weiteren, zu einem Meßverstärker 1991EL beschalteten Verstärker 2023 erfaßt und die entsprechende analoge Ausgangsspannung U_{Diff} einem A/D-Eingang eines figürlich hier nicht dargestellten Microcontrollers 21 zugeführt.

Der Microcontroller 21 kann so aus der digital gewandelten Fehlerspannung U_{Diff} und der aktuellen digitalen Sollwertvorgabe für den D/A-Wandler 199.2 den Wert der Busaderspannung berechnen, bei durch die Stufigkeit des D/A-Wandlers 199.2L vorgegebener Auflösung. Vorzugsweise realisiert der Regler 1991L in Verbindung mit der Kompensation der Fehlerspannung U_{ERR} in Bezug auf die Busader BUS_L eine strombegrenzte Spannungsquelle mit einem Maximalstrom von 200 mA, bei dessen Erreichung die einspeisende Quellenspannung zusammenbricht.

Abgesehen vom Anschluß 2022 für den Analogausgang des Verstärkers 2023 sind bei einer Realisierung des Umschalters SWL außerhalb des Schaltkreises oder Moduls 200 weitere Anschlüsse 2020 und 2021 am Schaltkreis 200 erforderlich. Andererseits kann die Vorrichtung im Umfang 500 abgesetzt vom Bus-Transceiver 100, 100' auch in einem beispielsweise mobilen Prüfgerät untergebracht sein, das nur zu Testzwecken an den Bus angeschlossen wird. Der Umschalter SWL kann sich dann z.B. in besagtem Testgerät befinden.

Von einer solchen Anwendung ist in der Figur auch beispielhaft ausgegangen. Demnach befinden sich die Teile innerhalb des Rahmens PG in einem mobilen Prüfgerät, welches zwischen ein busfähiges Elektronik-Modul 200, hier beispielsweise in einem Steuergerät ECU befindlich, und einen Busdraht BUS_L bzw. CAN_L geschaltet werden kann. Hierzu kann z.B. im Anschlußbereich des Gerätes ECU eine Brücke B entfernt werden, so daß der Abschlußwiderstand 17 - der normalerweise über diese Brücke mit der Busleitung BUS_L verbunden ist - über einen Kontakt TL mit besagter Busader im Prüfgerät verbunden werden kann. Über einen weiteren Kontakt EL ist hier der Ausgang der Endstufe 133L mit dem Steuereingang des Ersatzschalters 2019 im Prüfgerät PG verbindbar. Der Busdraht wird über einen weiteren Kontakt BL mit dem Prüfgerät verbunden. Bei dieser Vorrichtung verläuft der Kompensationspfad dann vorzugsweise über den Microcontroller des Prüfgerätes. Eine Vorrichtung für eine entsprechende Beaufschlagung der Busader BUS_H entspräche der vorbeschriebenen weitgehend.

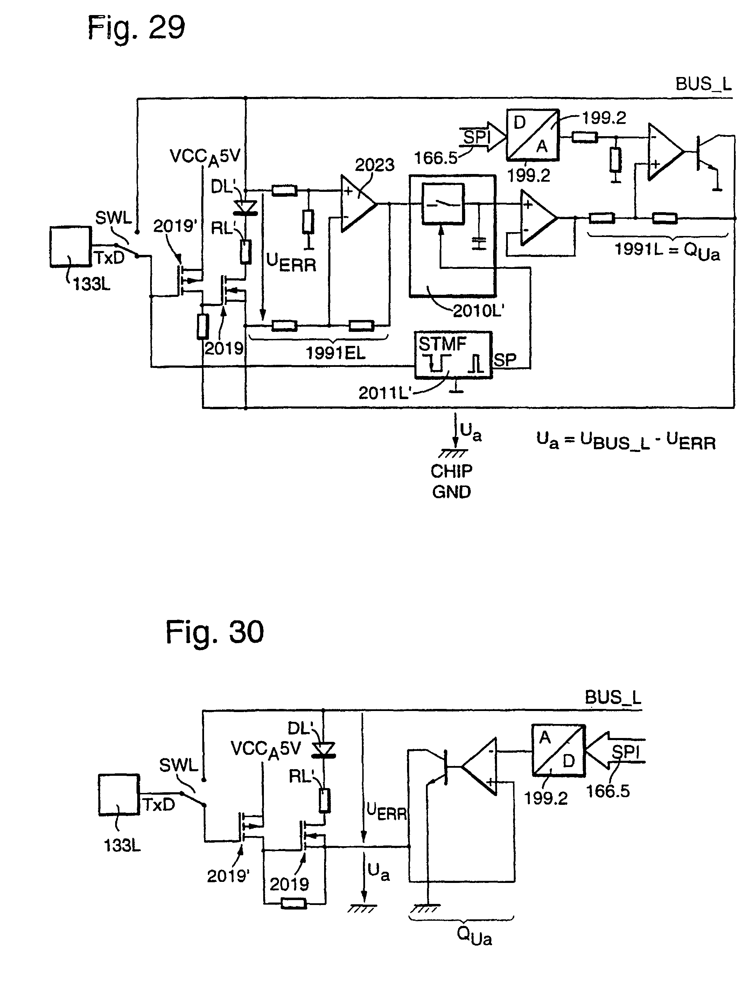

Die Vorrichtung gemäß **Fig. 29** vermeidet den Anschluß 2022 und den Kompensationspfad über den Microcontroller, indem sie nicht die Aderspannung U_{BUS_L}, sondern die vorgenannte Ausgangsspannung des Meßverstärkers 1991EL mittels einer Sample & Hold-Schaltung 2010L' abtastet und festhält. Diese wird von einer Impulsauslöseschaltung 2011L' mit einem Abtastimpuls SP beaufschlagt, der - verkettet mit dem Datensignal TxD - nach dessen aktiver Flanke erzeugt wird. Ohne Beschränkung der Allgemeinheit der Erfindung kann dies ein flankengesteuerter monostabiler Multivibrator STMF sein.

Die der Fehlerspannung U_{ERR} entsprechende, durch 2010L' gehaltene Fehlergröße wird dem Aderpotentialregler 1991L als Störgröße aufgeschaltet und analog verrechnet, um so im Rahmen der Auflösung des D/A-Wandlers 1992L eine der auf dem digitalen Pfad 166.5 vorgegebenen Größe entsprechende Aderspannung U_{BUS_L} als Summe der Reglerausgangsspannung Uₐ und der jeweiligen Fehlerspannung U_{ERR} zu erhalten.

Entsprechendes gilt auch für die Vorrichtung gemäß **Fig. 30**, welche auf eine Erfassung der Fehlerspannung U_{ERR} gänzlich verzichtet und dieser durch Berücksichtigung eines festen Zusatz-Offsetwertes in der Sollwertvorgabe über den digitalen Pfad 166.5 vom Microcontroller 21 Rechnung trägt. Insoweit liegt diesem Ausführungsbeispiel das bereits aus den Beispielen gemäß den **Figen. 14 - 18** und **21 - 24** bekannte Prinzip zugrunde.

**Fig. 31** veranschaulicht beispielhaft einen Empfangsblock 120' als Bestandteil des Transceivers 100/100' nicht nur für Empfangszwecke, sondern auch zur Verifikation von Kommunikationsfehlern, beispielsweise auch als Folge von Bezugspotentialfehlern des elektronischen Gerätes das diesen Empfangsblock enthält, in Verbindung mit vorbeschriebenen Funktionalitäten der Potentialsteuervorrichtung 199 und kooperativen Pegelshift-Merkmalen der Endstufe 133 im Transceiver 100/100'.

Der Empfangsblock 120' umfaßt ein analog wirkendes Frontend 121, eine digitale Auswertungslogik 128 und eine Auslese- und Kontrolllogik 129.

Das Frontend (LEVEL DISCRIMINATING SECTION) umfaßt drei analog wirkende Pegeldiskriminatoren 121.1 bis 121.3. Diese sind vorzugsweise als Komparatoren ausgeführt und generieren durch analogen Vergleich der Busleitungspegel in Bezug aufeinander sowie auf ein Referenzpotential VREF digital weiterverarbeitbare Signalpegel und Flanken.

Die Auswertungslogik (PROCESSING & ANALYZING SECTION) enthält eine Schaltkreisfunktion 122', welche zum einen aus den definierten Signalpegeln und -flanken die serielle Businformation RxD als digital normierten Bitstrom wiedergewinnt, und zum anderen Busfehler leitungsaderabhängig zu erkennen vermag. Zu diesem Zweck ist die Schaltkreisfunktion 122' auch für eindrähtigen Empfang (über GND) ausgebildet.

In diesem Zusammenhang kann die Auswertungslogik 128 als Vorrichtungsbestandteile digitale Schaltkreisfunktionen 123H und 123L umfassen, welche es erlauben, ein jeweils für die zugeordnete Busader BUS_H/CAN_H bzw. BUS_L/CAN_L indikatives Fehlersignal bei Erreichen oder Überschreiten einer voreinstellbaren Zahl von unmittelbar oder überhaupt aufeinanderfolgenden Bitfehlern abzugeben (Bitfehlertiefendiskriminator bzw. Bitfehlerakkumulationsdiskriminator). Zu diesem Zweck sind die Schaltkreisfunktionen 123H und 123L mit der Schaltkreisfunktion 122' multipel verbunden.

Die Auslese- und Kontrolllogik (READOUT & ONCHIP CONTROL) umfaßt eine zu einem Steuerungsinterface 124 zusammengefaßte Funktionalität, welche wenigstens teilweise auch Bestandteil des digitalen SPI-Interfaces 166 bzw. mit diesem zusammengefaßt sein kann, sowie vorzugsweise wenigstens zwei Speicherzellen 127H und 127L mit Setzeingängen 127H1 bzw. 127L1, Rücksetzeingängen 127H2 bzw. 127L2 und Zustandsausgängen 127H3 bzw. 127L3. Diese Elemente, die nicht dem normalen Empfang dienen, sind in weiterem Sinne auch noch der erfindungsgemäßen Vorrichtung zuzurechnen und können innerhalb des Schaltkreises oder Moduls 200 auch Teil eines größeren Fehlerspeichers oder -registers etwa in Verbindung mit einem EEPROM sein.

Beispielhaft sind die Rücksetzeingänge 127H2 und 127L2 sowie die Zustandsausgänge 127H3 und 127L3 der diskreten Speicherzellen 127H und 127L mit dem Steuerungsinterface 124/166 verbunden. Der Setzeingang 127H1 ist vonseiten der Schaltkreisfunktion 123H mit einem Fehlersignal beaufschlagbar. Der Setzeingang 127L1 ist vonseiten der Schaltkreisfunktion 123L mit einem Fehlersignal beaufschlagbar. Verbindungen 126H und 126L ermöglichen die Übertragung von Einstellinformation bezüglich der zu diskriminierenden Bitfehlertiefe bzw. zu akkumulierenden Bitfehlerzahl sowie der Selektion dieser beiden Diskriminationsweisen vom Steuerungsinterface 124/166 an die Schaltkreisfunktionen 123H bzw. 123L. Verbindungen 125 ermöglichen die Übertragung von Einstellinformation vom Steuerungsinterface 124/166 an die Schaltkreisfunktion 122', welche u.a. auch wenigstens ein Speicheroder Schiebe- und/oder Zählregister enthalten kann.

Optional kann das Steuerungsinterface ferner mit Mitteln 170.2 zur Slew-Rate-Beeinflussung im Frontend 121 und in der Auswertungslogik 128 in Wirkverbindung stehen und ist dann vorzugsweise auch über den SPI-Bus 166.5 mit der Umgebung des Empfangsblockes 120' kommunikationsfähig. Diese weiteren Mittel 170.2 können in weiterem Sinne ebenfalls noch der erfindungsgemäßen Vorrichtung zugerechnet werden.

Denn die Slew-Rate-Beeinflussung kann Analysen von aderspezifischen Bitfehlern sowohl in Zusammenwirken mit den vorbeschriebenen Funktionalitäten der Potentialsteuervorrichtung 199 und den kooperativen Pegelshift-Merkmalen der Endstufe 133 im Transceiver 100/100' als auch bei kapazitven Störungen im Busnetz sowie bei Kommunikationsstörungen infolge elektromagnetischer Störeinwirkungen auf das Busnetz oder einen Busteilnehmer unterstützen.

Ein um die vorgenannten Vorrichtungseiemente erweiterter Empfangsblock 120' eines Bus-Transceivers 100' kann neben seiner normalen Bus-Empfangsfunktion unter einer geeigneten Netzmanagement-Software busleitungsbezogen Fehleranalysen unter SPI-Kontrolle unterstützen.

Dieser Empfangsblock 120' kann in Verbindung mit vorbeschriebenen Funktionalitäten des Offset- und Bus-Test Managers 199 und kooperativer Pegelshift-Merkmale der Endstufe 133 die Gesamtfunktionalität des Schaltkreises 200 erweitern, nämlich hinsichtlich Überwachungs- und Diagnosefunktionen bezüglich der Bestimmung von Busteilnehmern mit bezugspotentialfehlerbasierten Kommunikationsstörungen auch unter Zweidrahttestbedingungen in Verbindung mit zugehörigen Sendemitteln als "passiver Responder".

In diesem Zusammenhang kann er in Verbindung mit einer Potentialsteuervorrichtung 199 als Bestandteil eines busweit aufgelösten Testsystems verstanden und betrieben werden, letztwelches sich hardwaremäßig wenigstens auf eine Mehrzahl entsprechend ausgestatteter Busteilnehmer stützt.

Keinesfalls sind diese beispielhaften Vorrichtungsdetails als Einschränkung der Erfindung zu verstehen. Vielmehr kann der Empfangsblock 120' hinsichtlich Erweiterungen, die mit der Potentialsteuervorrichtung 199 kooperieren, in seinen Abschnitten 128 und 129 auch anders strukturiert sein bzw. dort vom vorliegenden Ausführungsbeispiel abweichende Funktionsblöcke umfassen, um insgesamt die beschriebenen Diskriminationsmerkmale zu realisieren.

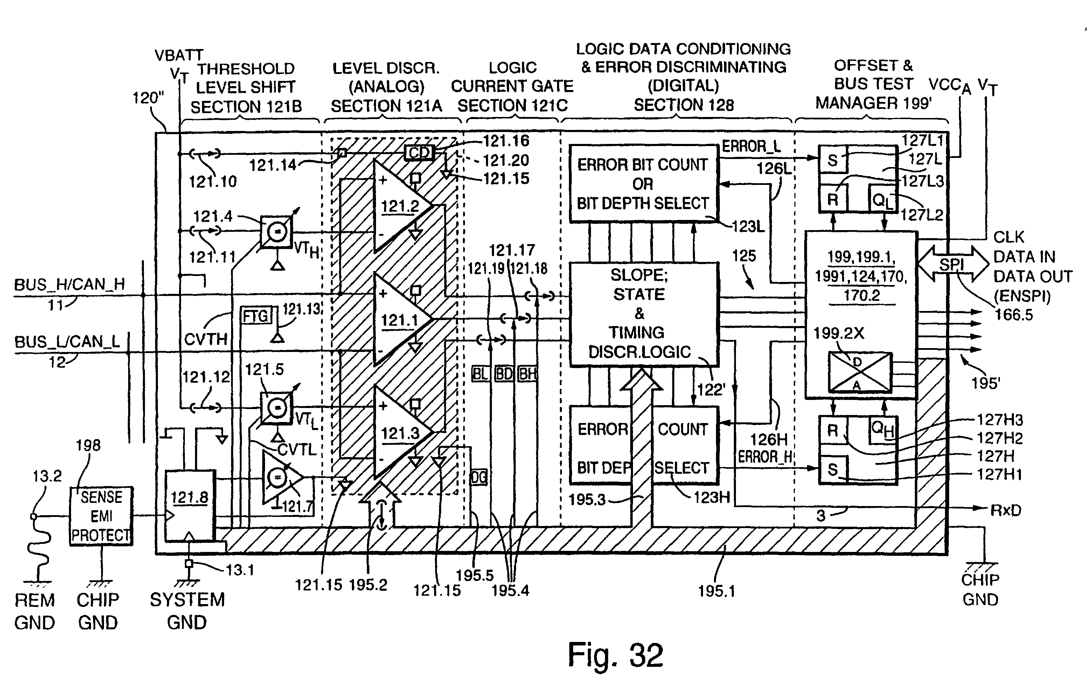

Eine noch weiterreichende Unterstützung von Fehleranalysen bei Vorliegen unexakter Buspegel ist mit einem um weitere Vorrichtungselemente erweiterten Empfangsblock 120" gemäß **Fig. 32** möglich. Er leistet wie der zuvor beschriebene eine normale zwei- und eindrähtige Empfangsfunktion. Unter Kontrolle durch eine geeignete Diagnose-Software stützt er in Verbindung mit Funktionalitäten einer hier beispielhaft diesem Block 120" zugeordneten komplexeren Potentialsteuervorrichtung 199' und den oben beschriebenen Pegelshift-Merkmalen der Endstufe 133 Bezugspotentialfehler-, Buspegelund Busfensteranalysen in Verbindung mit zugehörigen Sendemitteln als "aktiver Responder". So vorrichtungsgemäß erweiterte Empfänger können unter einem Netz-Diagnoseprogramm als potential- und signalagile Beobachter mit Meßkopffunktion aktiv zur (latenten) Netzgüteüberwachung vorteilhaft genutzt werden. Vorzugsweise wird er in integrierter Technologie ausgeführt.

Dabei umfaßt der Empfangsblock 120" ebenfalls einen analog wirkenden Pegeldetektionsabschnitt 121A, einen Schwellwertvorgabe- bzw. -shiftabschnitt 121B, einen logischen Stromkopplungsabschnitt 121C, eine digitale Auswertungslogik 128A und besagte Potentialsteuervorrichtung 199', die hier eine weiter gespannte Funktionalität aufweist als im Falle einer Offsetbeeinflussung nur auf der Sendeseite.

Der Pegeldetektionsabschnitt (LEVEL DISCRIMINATING SECTION) umfaßt drei analog wirkende Pegeldiskriminatoren 121.1 bis 121.3. Diese sind vorzugsweise als Komparatoren ausgeführt. Der Komparator 121.1 generiert durch Vergleich der zwei Busleitungspegel in Bezug aufeinander ein erstes digitales Ausgangssignal. Der Komparator 121.2 generiert durch Vergleich des Pegels der Busader BUS_H/CAN_H mit einer ersten Schwellwertspannung VT_{H} einer ersten Schwellwertquelle 121.4 ein zweites digitales Ausgangssignal. Der Komparator 121.3 generiert durch Vergleich des Pegels der Busader BUS_L/CAN_L mit einer zweiten Schwellwertspannung VT_{L} einer zweiten Schwellwertquelle 121.5 ein drittes digitales Ausgangssignal. Alle drei Komparatoren erzeugen digital weiterverarbeitbare Signalpegel und -flanken.

Im Gegensatz zur **Fig. 31** sind die Diskriminatoren 121.1 bis 121.3 so angelegt, daß sie zusammen mit ihren jeweiligen Versorgungsanschlüssen niedrigeren und höheren Potentials gegenüber dem Chip-Substrat elektrisch "angehoben" werden, d.h. "floaten" können. Dies ist durch eine besondere monolithische Konstruktion und Isolation im Aufbau des Halbleiterchips sowie dadurch gewährleistet, daß ihre jeweiligen Versorgungsanschlüssen niedrigeren Potentials - in der Figur gekennzeichnet durch Dreiecke mit Spitze nach unten - und höheren Potentials - in der Figur gekennzeichnet durch Quadrate - galvanisch untereinander verbunden sind. Diese Einheit ist in der Figur schraffiert unterlegt und mit 121.20 gekennzeichnet. Die durch Quadrate markierten Anschlüsse stehen so mit einem (hier positiver angenommenen Versorgungsanschluß 121.14 und die mit Dreieck mit Spitze nach unten markierten Anschlüsse mit beispielhaft drei (hier negativer angenommenen und untereinander verbundenen) Versorgungsanschlüssen 121.15 in Verbindung. Um eine konstante Versorgungsspannung der Komparatoren sicherzustellen, umfaßt die Struktur 121.20 hier beispielhaft noch eine Spannungsklammer oder einen Regler 121.16, der zwischen die Versorgungsanschlüsse 121.14 und 121.15 geschaltet ist und beispielhaft über eine Stromquelle 121.10 von einem der Potentiale VBATT oder V_{T} aus versorgt sein kann.

Der Schwellwertvorgabe- bzw. -shiftabschnitt (THRESHOLD LEVEL SHIFT SECTION) umfaßt beispielhaft eine erste einstellbare Schwellspannungsquelle 121.4 für ein Schwellpotential VT_{H} und eine zweite einstellbare Schwellspannungsquelle 121.5 für ein Schwellpotential VT_{L}, die über entsprechende Steuerpfade CVTH und CVTL einstellbar sind und die im allgemeinsten Falle ähnlich wie die vorgenannten Komparatoren auf eine eigene negative Bezugspotentialschiene 121.13 - symbolisiert durch Dreiecke mit Spitze nach oben - bezogen sein können, die erforderlichenfalls auch anhebbar ist. Beispielhaft werden die Schwellspannungsquellen 121.4 und 121.5 aus Stromquellen 121.11 und 121.12 versorgt. Zu deren Speisung kann eine Speisung des Abschnittes 121B aus einem der Potentiale VBATT oder V_{T} vorgesehen sein.

Des weiteren ist diesem Abschnitt eine durch Ansteuerung entsprechend einstellbare Offset-Quelle 121.7 zugeordnet, die mit ihrem Ausgang vorzugsweise den negativen Versorgungsanschluß 121.15 im Abschnitt 121A speist und damit - bei durch das Element 121.16 konstant gehaltener Versorgungsspannung der Komparatoren 121.1 bis 121.3 - deren negatives Versorgungspotential um einen definierten offset anzuheben erlaubt. Zu diesem Zweck kann diese Quelle als Regelverstärker ausgeführt sein, dessen Eingang von einem besonderen Block 121.8 angesteuert wird, an den auch der Ausgang des Regelverstärkers zurückgeführt ist. Dem Funktionsblock 121.8 kann vom Schaltkreisanschluß 13.1 und/oder 13.2 Massepotential aus dem Gerät, in welchem der Schaltkreis eingesetzt ist und/oder von einem Bezugspotential im Applikationsumfeld zuführbar sein.

Der Funktionsblock 121.8 steht über den Steuerpfad 195.1 mit der Potentialsteuervorrichtung 199' in Verbindung. Vom Block 121.8 aus ist die Offset-Quelle 121.7 ein- und ausschaltbar, bei Bedarf über den Pfad 195.5 auch kurzschließbar und mit einer über den Steuerpfad 195.1 vom Funktionsblock 199' bezogenen Sollwertvorgabe ansteuerbar.

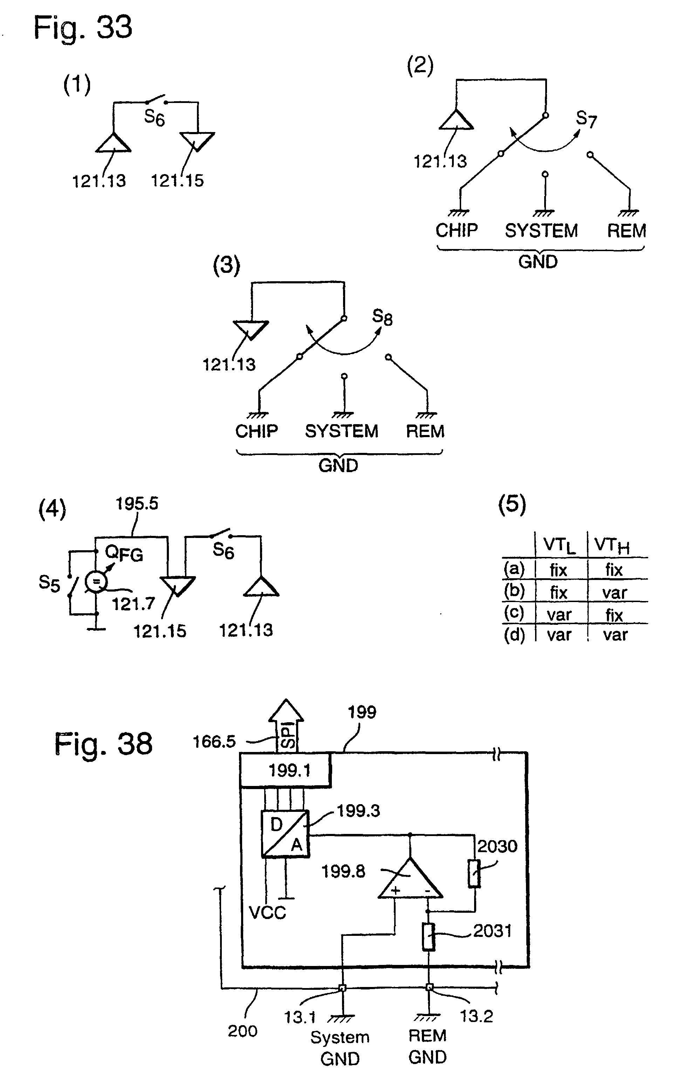

Eine weitere Funktion des Blockes 121.8 besteht in der Selektion von Masse- bzw. Bezugspotentialen. Ohne Beschränkung der Allgemeinheit der Erfindung ist eine beispielhafte Funktionalität des Blocks in **Fig. 33** veranschaulicht; je nach dem Grad der Merkmalsausbildung in einem praktischen Schaltkreis brauchen nicht alle Selektionsmöglichkeiten zugleich ausgebildet sein. Es können auch nur einige davon z.B. durch Einmalprogrammierung innerhalb eines komplexeren Schaltkreises ausgewählt verfügbar sein. Insoweit umfaßt der Block 121.8 also Mittel, welche entsprechend ihrer Ansteuerung über den Pfad 195.1 im Effekt die in der Figur dargestellten Potentialbezugnahmen für den Empfangsblock 120'' ermöglichen können. In diesem Zusammenhang kann der Block 121.8 steuerbare Analogschalt- bzw. Selektorstrecken S₅ bis S₈ umfassen. Des weiteren können Mittel vorhanden sein, die es erlauben, daß diese Strecken bei Bedarf vom Block 199' aus per Software von einem Microcontroller für Kalibrierzwecke aus- und ein- bzw. umschaltbar sind.

Die Ausgänge der Komparatoren 121.1 bis 121.3 sind vorzugsweise über logische Strompfade 121.17, 121.18 und 121.19 mit einer Auswertungslogik 128 verbunden. Dabei können die Strompfade über Statusleitungen 121.17 (BD), 121.18 (BH) und 121.19 (BL) im Sinne einer Signalunterbrechung schaltbar sein, um selektive Signalunterbrechungen zu ermöglichen.

Die Auswertungslogik (LOGIC DATA CONDITIONING & ERROR DISCRIMINATING SECTION) enthält eine Schaltkreisfunktion 122', welche im wesentlichen der Schaltkreisfunktion 122 in **Fig. 31** entsprechen und die dort schon beschriebenen Funktionen erfüllen kann und für zweidrähtigen und eindrähtigen Empfang (über GND) ausgebildet ist. Dabei können auch hier die Elemente 123L und 123H insbesondere für Fehleranalysen im Zweidrahtmodus besonders ausgebildet sein.

In der beispielhaft daran angeschlossenen, erweiterten Potentialsteuervorrichtung 199' sind schon beschriebene Funktionen des entsprechenden Blocks 199 gemäß **Fig. 12** beispielhaft zusammen mit Schaltkreisfunktionen 124 und 170.2 aus **Fig. 31** integriert. Die Speicherzellen 127H und 127L können hier als Bestandteil eines größeren Registers angelegt sein, welches der Block 199' zur Zwischenspeicherung von SPI-Daten enthält. Gleichwohl können sie auch Bestandteil wenigstens eines Teils eines Fehlerspeichers in Verbindung mit einem EEPROM sein, der ebenfalls der Potentialsteuervorrichtung 199' zugeordnet sein kann.

Der Steuerpfad 195.1 ist ein multipler und kann als solcher in einem praktischen Schaltkreis auch analoge und digitale Funktionselemente mehr oder weniger verteilt umfassen, die den Block 199' an unterschiedliche Ansteuererfordernisse anpassen. Beispielhaft kann die aus dem Potential VCC_{A} versorgte Festspannungslogik des Abschnitts 128 über den Steuerpfad 195.3 anders anzusteuern sein als die logischen Strompfade 121.17 bis 121.19 über Steuerpfade 195.4, die Schwellwert-Offset-Quellen 121.4 und 121.5 oder - zwecks Slewrate-Beeinflussung über den Pfad 195.2 - der "schwimmende" Pegeldiskriminationsabschnitt 121.20.

Vom Block 199' führen des weiteren zur Sendeendstufe 133 bzw. zu im Sendefalle wirksamen Offset-Quellen Q_{SL}, Q_{SH} und/oder Q_{SHH} bzw. Schalt- und Steuerpfade 195'. Als zentrales Element umfaßt der über den Digitalpfad 166.5 kommunikationsfähige Block 199' Konversionsmittel 199.2X zur Wandelung digitaler Signale in analoge. Die Erfindung umfaßt dort als Vorrichtungselemente auch die umgekehrte Konversionsrichtung. In letzterem Falle können je nach Ausbildung des Steuerpfades 195.1 Teile eines solchen Wandlungspfades auch in den Block 121.8 vorverlagert sein, vgl. **Fig. 38.**

In weitestem Sinne sind alle Elemente der erfindungsgemäßen Vorrichtung zuzurechnen, die nicht dem normalen ein- und zweidrähtigen Empfangsbetrieb ohne Vorliegen eines Potentialfehlers oder Buspegelfehlers dienen bzw. diesen stützen.

Ohne Beschränkung der Erfindung kann die erweiterte Potentialsteuervorrichtung 199' Funktionalitäten in sich vereinigen, welche sowohl mit der Erfassung von Fehlersignalen (als Ergebnis von Fehlerprüfungen unter fehlerbedingten bzw. testhalber erzeugten Offsetbedingungen) als auch mit der Beeinflussung der Empfangsund/oder Sendemittel zu tun haben, um dadurch entweder in einem Beobachtungsteilnehmer - in welchem ein so beschaffener Schaltkreis bzw. so beschaffenes Modul 200 sich befindet - zwecks Wiederherstellung einer potentialfehlerbedingt zuvor verloren gegangenen Kommunikationsfähigkeit mit einem anderen Husteilnehmer entsprechend "abnormale" Sende- und Empfangsbedingungen zu suchen und zu finden und einzustellen, oder die Empfangs- und/oder Sendemittel unter einer Diagnose-Software in der Art eines "Testempfängers" bzw. "Testsenders" zu betreiben.

Ein um solche Vorrichtungselemente erweiterter Empfangsblock 120" als Bestandteil eines Bus-Transceivers 100' kann in Verbindung mit vorbeschriebenen Funktionalitäten einer Potentialsteuervorrichtung ("Offset- und Bus-Test Manager") 199' und kooperativer Pegelshift-Merkmale der Endstufe 133 weitreichende Fehleranalysen unter SPI-Kontrolle durch einen Microcontroller unterstützen. Dabei kann es je nach Testaufgabe ausreichen, nur ganz spezifische Vorrichtungsmerkmale auszubilden oder - soweit ausgebildet - wirksam schalten zu können. Beispielhaft sind einige Möglichkeiten in Figen. 34 - 37 ausgeführt.

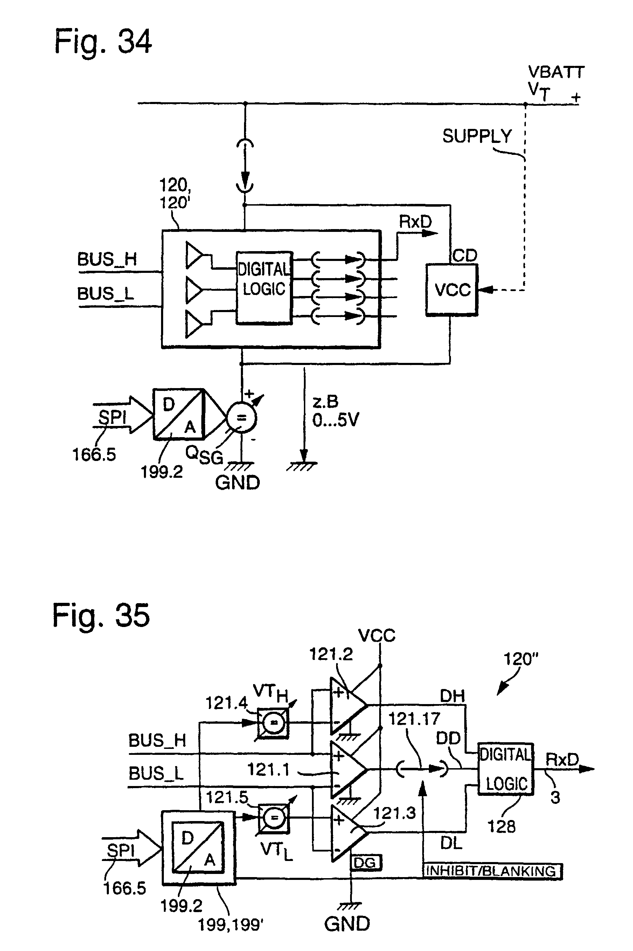

Gemäß **Fig. 34** ist der gesamte, vermöge einer Spannungsklammer oder eines Reglers CD mit einer Spannung VCC konstant versorgte Empfangsblock 120', 120" nach Maßgabe durch eine Offset-Quelle Q_{SG} um beispielhaft 0...5 Volt anhebbar. Dabei können die Schwellenspannungen VT_{N} und VT_{L} innerhalb des Empfangsblockes fest, auf netzspezifisch festgelegte feste "Abweichungswerte" umschaltbar oder variabel sein, was z.B. dem Fall (4) in **Fig. 33** bei geschlossenem Schalter S₆ entspricht; die entsprechenden Einstellsignale CVTH und CVTL können dann z.B. auch durch Stromsignale realisiert werden. Dieses Beispiel stellt insoweit eine Abwandlung des Beispiels gemäß **Fig. 32** dar, als hier von einer zusammen mit den Eingangskomparatoren mitschwimmenden digitalen Auswertung ausgegangen wird, die dann ihrerseits ausgangsseitig über logische Strompfade an die Schaltkreisumgebung signalflußmäßig angeschlossen ist. Im Vorrichtungsbeispiel gemäß **Fig. 35** ist der negative Versorgungsanschluß DG mit Masse GND verbunden, hat also z.B. das Potential des Chip GND. Testerfordernissen gemäß eingestellt bzw. mit einem Offset unterlagert werden nur die Schwellenspannungsquellen für die Komparatoren 121.2 und 121.3. Dazu kann der Digitalpfad 121.17 zwischen dem Komparator 121.1 und der Auswertungslogik 128 bedarfsweise unterbrochen werden, entsprechend 121.17 und BD 195.4 in **Fig. 32**.

Das Vorrichtungsbeispiel gemäß **Fig. 36** entspricht dem allgemeinen Beispiel gemäß **Fig. 32** für den Spezialfall gemäß **Fig. 33 (1) und (5) (a),** wobei die Schwellenspannungen VT_{H} und VT_{L} unveränderlich vorgegebene Größen sind und durch Gesamtanhebung des analog wirkenden Diskriminationsteils 121.20 mittels einer Fuß-punkt-Offset-Quelle Q_{SG} somit gemeinsam gegenüber Masse-potential verschiebbar sind.

In **Fig. 37** ist eine z.B. für Massepotentialfehleranalysen ausreichende Ausbildung von Vorrichtungselementen im Bus-Transceiver ersichtlich, bei der die Versorgungsanschlüsse sowohl des analog wirkenden Diskriminationsteils 121.20 als auch der Sendeendstufe 133 aus ein- und der/demselben Spannungsklammer bzw. Spannungsregler versorgt werden und insoweit zusammen mittels einer Fußpunkt-Offset-Quelle Q_{SG} über ein Potential GND anhebbar sind. Sowohl sende- als auch empfangsseitig eine entsprechend flexible Potentialanbindung der Digitalsignale TxD und DH, DD und DL leistende Strompfade sind ebenfalls angedeutet, ebenso der schon erwähnte Speicher 142' zur Ermöglichung der Sperrung der Endstufe 133 (kein Buszugriff), vgl. **Fig. 10, Fig. 11.**

Das Vorrichtungsdetail gemäß **Fig. 38** veranschaulicht das Wirkschaltbild einer optinalen Ausstattung des Funktionsblockes 199' wie schon in Verbindung mit **Figen. 17 und 32** erwähnt. Es handelt sich dabei um einen für eine definierte Verstärkung mit Widerständen 2030 und 2031 beschalteten Meßverstärker 199.8, dessen Ausgang zusätzlich vorgesehene Mittel 199.3 zur Analog/Digital-Wandlung speist. Diese Mittel stehen mit der als Interface zum SPI-Pfad 166.5 wirkenden Logik 199.1 in Verbindung und erlauben so, daß die analog erfaßte Differenz beispielsweise zwischen System GND und REM GND an einen Microcontroller digital übermittelbar ist. Wie schon erwähnt können diese Elemente gleichwohl dem Vorrichtungsblock 121.8 in **Fig. 32** zugeordnet sein.

Alle bis hierher erläuterten Ausführungsbeispiele stützten sich auf wenigstens einen D/A-Wandler, der nach Maßgabe durch über den digitalen Pfad 166.5 empfangene Daten einen analogen Sollwert bereitstellt.

Gemäß **Fig. 39** umspannt der Rahmen der Erfindung weiter, daß alle Sollwertvorgaben und Aktivierungsbefehle für Offset-Quellen, wie sie für praktische Bus-Test-Routinen benötigt werden, im Halbleiterschaltkreis 200 selbst von einer zentralen Schaltkreisfunktion 199.2X generiert werden, welche wesentlicher Bestandteil einer entsprechend erweiterten Potentialsteuervorrichtung 199 ist, wie in **Fig. 32** bereits angedeutet. Im Rahmen dieser Funktionalität kann optional auch die Berücksichtigung einer Spannungsdifferenz zwischen den Anschlüssen Chip- oder System GND 13 bzw. 13.1 und REM GND 13.2 erfolgen.

Des weiteren kann diese Funktionalität die Fähigkeit zur Messung der Busaderspannungen immanent sein. Im Rahmen der Erfindung ist also vorgesehen, daß ein entsprechender Funktionsblock 199.2X insbesondere alle D/A-Wandler in den bis hierher beschriebenen Ausführungsbeispielen substituiert, um unter einer spezifischen Software zur Auto-Diagnose eines vielteilnehmrigen Busnetzes alle Anforderungen des Ramping und Squeezing von Kommunikations-Pegelfenstern sende- und empfangsmäßig zu erfüllen.

Dieser Funktionsblock kann also so beschaffen sein, daß er u.a.
(1) wenigstens eines der ENAable-Signale zur Aktivierung und Sperrung sende- und empfangsmäßig wirksamer Offset-Quellen Q_{SG} gemäß Fig. 14; Q_{SL}, Q_{SH}, Q_{SHH}, Q_{VVC}, gemäß Figen. 15 & 16 & 17 & 18; 121.7/Q_{DG}, 121.4/VT_{H} und 121.5/VT_{L} gemäß Fig. 32,
(2) wenigstens einen der von busspezifischen Standardwerten abweichenden Sollwertvorgaben bzw. Einstellwerte für Q_{SG} gemäß Fig. 14; Q_{SL}, Q_{SH}, Q_{SHH}, Q_{VVC} gemäß Figen. 15 & 16 & 17 & 18; 121.7/Q_{DG}, 121.4/VT_{H} und 121.5/VT_{L} gemäß Fig. 32,
(3) wenigstens ein Einstell- oder Schaltsignal zur Beeinflussung der sendeseitigen Slewrate und/oder zur Beeinflussung der empfängerseitigen Auswertung von busaderbezogenen Referenzsignalen für steuerbare logische Pfade (121.17 [Blanking Differential BD], 121.18 [Blanking High BH], 121.19 [Blanking Low BL] gemäß Fig. 32) und/oder der Empfangsfehlerdiskrimination (126L [L_Error Detection Format], 126H [H_ Error Detection Format]) und/oder Slewrate-Anpassung (195.2 i.V. mit 170.2 [Set Siewrate], 195.3 [Slope and/or Timing to Slewrate Match] gemäß Fig. 32),
(4) wenigstens ein Einstell- oder Schaltsignal zur Verwirklichung der Schalt- und/oder Selektorfunktionen S₅ bis S₈ gemäß Fig. 33
bereitstellen kann, wie in **Fig. 39** illustriert.

Eine so fortgebildete Vorrichtung erlaubt eine unbeschränkte Beeinflussungsmöglichkeit der vom Bus-Empfänger diskriminierbaren Buspegel, und zwar entweder einen von beiden alternativ oder aber beide zugleich. Des weiteren deckt diese Funktionalität alle sendeseitigen, empfangsseitigen oder kombiniert sende- und empfangsseitigen Beeinflussungen wie beschrieben ab.

In jedem Falle kann eine praktisch realisierte Funktionalität der Potentialsteuervorrichtung 199, 199' sowohl lineare Verstärkermittel als auch digital/analog wirkende oder analog/digital wirkende Konversionsmittel sowie eine eigene Referenzspannungsquelle umfassen, die entweder vom Ausgang 20.2.2 oder aus dem Potential V_{T} oder dem Potential VBATT versorgbar sein kann (197 oder 194). Dabei können die digital/analog und/oder analog/digital wirkenden Konversionsmittel über die Schnittstellenlogik 199.1 - mit der Funktion eines Interface - mehr oder weniger eng mit z.B. dem eine Verbindung mit einem Microcontroller herstellenden Interface 166 verbunden realisiert sein.

Eine Netzmanagement- oder Diagnose-Software kann diese Vorrichtungs-Details nutzen, um einerseits eine gezielte Fehlkommunikation (d.h. innerhalb eines eigentlich fehlerhaften Pegelfensters) eines mit der Vorrichtung ausgestatteten Beobachtungs-Teilnehmers mit einem anderen Busteilnehmer - nämlich einem massefehlerhaften - herbeizuführen und ihn auf diese Weise zu identifizieren, und um andererseits zwecks Verifikation nicht massefehlerbehaftete Busteilnehmer von einer Normalkommunikation sukzessive auszuschließen. In diesem Zusammenhang kann die oben in Verbindung mit **Figen. 10 & 11 & 37** erwähnte Unterbrechbarkeit des Sendezugriffes im RECEIVE ONLY-Mode in allen nicht fehlerbehafteten Busteilnehmern vorteilhaft genutzt werden, um Buspegelbeeinflussungen durch Potentialeinströmungen auf den Bus von anderen Busteilnehmern (im Falle eines CANs z.B. durch das Aussenden von Acknowledge-Bits oder Error-Frames) auszublenden.

Optional kann der Vorrichtung auch noch ein Speicherbereich zugeordnet sein, in welchem die Konfigurationen des Empfangsblockes 120" etwa gemäß **Fig. 33** oder ganz spezifische Selektionen wirksamer Vorrichtungselemente etwa gemäß **Figen. 14 - 18** und **Figen. 34 - 37** in Form entsprechender Daten abgelegt sein. Für die Festlegung für den Betrieb einer ganz spezifischen Selektion von betreibbaren Vorrichtungselementen etwa gemäß **Figen. 14 - 18** und **Figen. 34 - 37** kann die Vorrichtung auch Schaltkreismittel einschließen, die eine solche Festlegung nur einmal zulassen.

Wie schon erwähnt kann die Funktionalität der Potentialsteuervorrichtung 199, 199' gleichwohl sowohl mit einem dem Bus-Transceiver zuzuordnenden Steuerungsinterface 124 mehr oder weniger verbunden oder in diesem gänzlich aufgelöst sein und vice versa. Andererseits kann der Funktionalitätsumfang der Potentialsteuervorrichtung 199, 199' aufgrund der analog/digitalen und/oder digital/analogen Konversionsmittel in 199, 199' auch mehr oder weniger Teil oder sogar identisch mit einem die Verbindung zu einem externen Microcontroller herstellenden Steuerungsinterface 166 sein. Zum umfänglichen Verständnis können die **Figen. 40 & 41** beitragen, die in der zugrundeliegenden und eingangs genannten Prioritätsanmeldung eingehend beschrieben sind.

**Fig. 42,** die der o.g., zeitgleichen Parallelanmeldung entnommen ist, zeigt einen mit darüberhinaus zusätzlichen Merkmalen ausgestatteten Bus-Transceiver 100', der z.B. als integrierte Halbleiterschaltung ausgeführt werden.

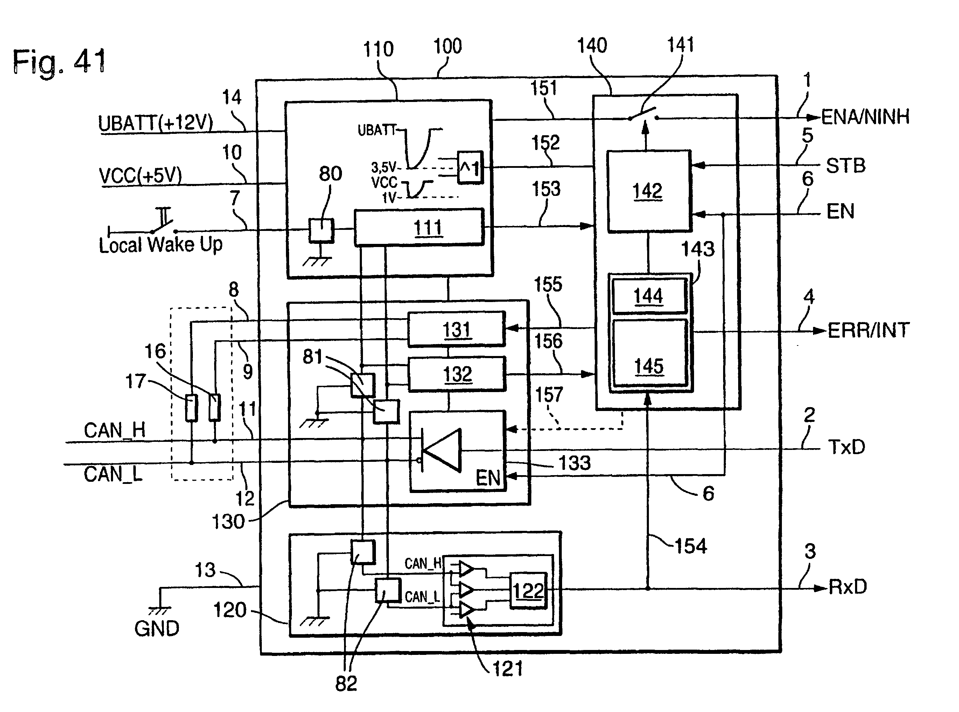

Seine Funktionsblöcke 110, 120 und 130 weisen über dem in **Fig. 41** gezeigten noch zusätzliche Mittel 170.1 bzw. 170.2 bzw. 170.3 zur Beeinflussung bzw. Steuerung bzw. Einstellung wenigstens der Empfangsmittel 120 und der Sendemittel 130, u.U. auch von Weckerkennungsmitteln 111 im Block 110 auf. Ferner können die Anschlußpfade 159 und 160 für die Signale TxD und RxD und - unter gewissen Bedingungen - auch der Pfad 154 durch einen Block 170 mit der Funktion eines Slewrate Controllers geführt sein. Des weiteren ist bezüglich des Lokal-Anschlusses 7 den Weckerkennungsmitteln 111 ein Schutzfilter 80 vorgeschaltet.

Entsprechende Filterelemente 81 und 82 sind den beiden CAN_H/CAN_L-Eingängen des Weck-Erkennungs-Blocks 111 und dem Busfehler-Erkennungsblock 132 bzw. den beiden Eingängen des Empfänger-Frontends 121 im Empfangsblock 120 vorgelagert, letztwelchem Fehlerbehandlungs- und Logikmittel 122 nachgeschaltet sind. Die vorgenannten Filterelemente unterscheiden sich von dem Schutzfilter 80 dadurch, daß sie von blockzugeordneten Slewrate-Einstellmitteln 170.2 bzw. 170.3 steuerbar sind. Die Slewrate-Einstellmittel 170.3 können über einen optionalen Pfad 180 auch unmittelbar auf die Endstufe 133 wirken. Auf diesem Wege ist dann ein aktiver Einfluß auf die Slewrate des Senders in 130 möglich. Ein Slewrate Controller 170 kann über den optionalen Pfad 158 vom Steuerungsblock 140 angesteuert werden. Außerdem kann er optional über wenigstens einen weiteren Anschluß 171 angesteuert werden. Des weiteren kann der Funktionsblock 142, welcher die Betriebsarten des Halbleiterschaltkreises 100' gemäß der Vorgabe vom Microcontroller einstellt, um einen weiteren Eingang 172 für ein Testsignal (TEST) bzw. Slewrate-Einstell-Signal (SRC) erweitert sein.

Die Detailfunktion dieser Erweiterung ist folgende.

Der Slewrate-Steuerungsblock 170 wirkt beispielsweise in Abhängigkeit von einem an seinem Eingang 171 anliegenden SR-Signal oder - wie weiter unten erläutert - in Abhängigkeit von bzw. in Abhängigkeitsverbund mit dem Signal TEST/SRC - optional auch im Verbund mit Signalen EN und STB - über nicht figürlich dargestellte Verbindungen auf die blockzugeordneten Slewrate-Einstellmittel 170.1, 170.2 und 170.3 und letztere hier beispielhaft auf die Sendeendstufe 133. Dadurch wird einerseits die Slewrate der Endstufe entsprechend verändert bzw. eingestellt bzw. umgeschaltet, und andererseits wird das Slewfollow-Verhalten der Blöcke 110, 120 und 130 verändert bzw. eingestellt bzw. umgeschaltet. Im einfachsten Falle werden entsprechende Frequenzbandbeschneidungen der Eingangssignale vom Bus CAN_H/CAN_L an den Bus-Eingängen der Blöcke 110, 120 und 130 wirksam geschaltet.

Diese steuerbare Slewrate-Beeinflussung macht einen solchen Bus-Transceiver 100' tauglich für verschiedene Übertragsungsgeschwindigkeiten und Bus-Bitzeiten. Dadurch kann ein solcher Transceiver 100' in verschiedenen Systemen mit weit voneinander abwei-chenden Bus-Grenzfrequenzen eingesetzt werden. Beispielsweise kann ein solcher Schaltkreis sowohl FAST-CANs z.B. in Verbindung mit dem Motormanagement von Brennkraftmaschinen in Verkehrsmitteln genau so bedienen wie SLOW-CANs beispielsweise in Innenräumen solcher Verkehrsmittel.

Des weiteren ist durch die Steuerung der Slewrate die hochfrequente Störsignalunterdrückung unmittelbar beeinflußbar, und zwar sowohl sende- als auch empfangsmäßig. Je kleiner die Bit-Slewrate auf dem Bus CAN_H/CAN_L, desto stärker ist die durch Sendebetrieb verursachte elektromagnetische Störausstrahlung des Busnetzes und seiner Abzweigungen. Je kürzer die erkenn- bzw. diskriminierbare Slew-Rate des Empfänger-Frontends 121 oder des Weck-Erkennungs-Blocks 111, desto größer ist die Gefahr eines unerwünschten Lese- oder Weckfehlers verursacht durch elektromagnetisch einwirkende hochfrequente Störspektren.

Daraus folgt für die Charakterisierung der Filter 81 und 82, daß es sich hierbei nicht nur um steuerbare Tiefpässe, sondern gleichwohl auch um echte, vorzugsweise DC-gekoppelte, analog oder digital wirkende Slewrate-Filter handeln kann, die die Signal-Slewrate oder Bit-Zeiten auf dem Bus bis an die jeweilige Grenzslewrate bzw. an Grenzbitzeiten heranreichend auszunutzen erlauben. Gleichwohl kann es sich dabei auch um Bitzeit-Filter handeln, die - zur Optimierung der Störungsunterdrückung - auf die Kommunikations-Baudrate des Busses einstellbar sind. Wie weiter unten in Verbindung mit **Fig. 29** verständlich können solche Bitzeitfilter von einem Steuerungsinterface 124 der Transceiver-Funktion digital einstellbar sein.

Auf diese Weise ist auch noch ein hoher Störabstand im Busumfeld beispielsweise in Kraftfahrzeugen oder elektrischen Schienenfahrzeugen erzielbar, in welchen in zunehmendem Maße die Speisung von Motoren und Verbrauchern mittels starker, getakteter Ströme geschieht. Durch Resonanzüberhöhungen in der induktivitäts- und kapazitätsbehafteten Verkabelung der Versorgungsleitungen solcher Verbraucher können sich hochfrequente elektromagnetische Störfelder je nach räumlicher Konfiguration des jeweiligen Feldes und Verlauf einer Busleitung in Bezug auf letztere mehr oder weniger stark auswirken. Die vorgenannten Merkmale bieten eine Möglichkeit um die Auswirkung derlei Störungen auf die Kommunikation zu verringern (aktiver Störungsschutz).

Bei einer bevorzugten Programmierung bzw. Einstellung des Schaltkreises kann die Slewrate für Wecksignale und die Slewrate für Kommunikationssignale ungleich bemessen sein.

Des weiteren kann z.B. in einer Betriebsart SLEEP die Slewrate auch auf einen Wert eingestellt werden, der niedriger als in allen anderen Betriebsarten ist. In diesem Zusammenhang soll die Verbindung 158 bedeuten, daß optional auch der Steuerungsblock 140 Einfluß auf die Slewrate-Steuerung nehmen kann. Durch diese Maßnahme wird eine entsprechende Unempfindlichkeit eines entsprechenden Busnetzes, dessen Teilnehmer jeweils mit einem solchen "SLEEP-SLEW"-Halbleiterschaltkreis 100' ausgerüstet sind, gegenüber unerwünschten Weck-Störungen in der Betriebsart SLEEP erreicht. Da der Schaltkreis 100' so konzipiert ist, daß er in der Betriebsart SLEEP einen geringstmöglichen Strom Versorgungsstrom verbraucht, können die Filterelemente 81 und 82 so ausgebildet sein, daß sie bei Abschaltung der internen Stromversorgung der Sende- und/oder Empfangsmittel 130 bzw. 120 automatisch die kleinste Slewrate bewirken, die in diesem Sinne dann in der Betriebsart SLEEP immer wirksam ist (Hochsteuern der Slewrate bzw. automatischer Rückfall auf die SLEEP-Slewrate mit besonders hohem Störabstand).

Die steuerbare Slewrate-Beinflussung macht den Transceiver-Kern des Schaltkreises 100' darüber hinaus tauglich als Test-Sender und Test-Empfänger für softwarebasierte Tests eines Bus-Netzwerks, einschließlich solcher mit Test-Baudraten und Test-Bitzeiten. Auch in diesem Zusammenhang soll die Verbindung 158 bedeuten, daß optional auch der Steuerungsblock 140 Einfluß auf die Slewrate-Beeinflussung nehmen kann.

Auf das Zusammenwirken für Bus-Diagnosezwecke dieser Slewrate-Beeinflussung mit weiteren Funktionen innerhalb einer oben beschriebenen SPI-Struktur eines Elektronikmoduls 200 wurde in Verbindung mit **Fig. 12** bereits eingegangen.

Der Transceiver 100' kann bezüglich der Sende- und Empfangsmittel 130, 133 bzw. 120 bevorzugt so ausgebildet werden, daß diese Mittel tolerant gegenüber allen möglichen Fehlerzuständen im.und am Busleitungsnetz sind, sofern alle Busteilnehmer bezüglich des Busleitungsnetzes sich kompatibel verhalten, was beispielsweise erfüllt sein kann, wenn alle denselben Transceiver 100' verwenden.

In der vorlaufenden DE-Anmeldung P 196 11 945.6 sind außer den Betriebsarten SLEEP, STANDBY, RECEIVE ONLY und NORMAL eines einfacheren Transceivers noch weitere angedacht. Realisiert ist der Erweiterungsfall vorliegend. Über den Eingang 172 kann dem Block 142 ein weiteres Signal - hier mit SRC/SWM bezeichnet - zugeführt werden, das die Bedeutung der Signale EN und STB bedarfsweise umdefiniert. Dabei steht SRC für Slewrate Control, und SWM für Single Wire Mode.

Durch das dritte SRC-Signal können mittels der Bits EN und STB beispielsweise Test-Flags in 142 gesetzt bzw. gelöscht werden, die innerhalb 100' Test-Slewrates addressieren können. Im Zusammenhang mit Fortbildungen für Testfähigkeit kann der Slewrate-Controller 170 auch zwischenspeichernde und/oder digitale Verzögerungsmittel für wenigstens einen von Sende-/und Empfangspfad an 2 bzw. 3 beinhalten. Im Rahmen der Erfindung können solche zusätzlichen digitalen Mittel auch mit einem repetitiven Signal SR am Eingang 171 zusammenwirken, um so unter einer auf Gleichverteilung der Busintelligenz abgestellten Busmanagements das automatische Austesten des Busses unter Beteiligung aller Teilnehmer auf Vorliegen bzw. Einhaltung definierter übertragungs- und Störabstandsgüten zu ermöglichen, wie oben in Verbindung mit **Figen. 12 & 46** ausgeführt.

Ein wesentlicher Aspekt der Erfindung ist, auch solche busnahen Testmittel in einer Halbleitertechnologie auszuführen, die eine hohe Widerstandsfähigkeit gegen Beschädigung durch grobe Störeinflüsse bietet, um genau dann, wenn ein Bus-Fehler bzw. Bus-Gütefehler infolge irgendwelcher Störeinflüsse tatsächlich aufgetreten ist, den fehlerhaften Bus noch vollautomatisch austestbar zu erhalten.

Die Figurenzeichnung bedeutet keinerlei Beschränkung der Erfindung. Alle bezüglich eines Ausführungsbeispiels offenbarten Einzelmerkmale sind selbstverständlich auf alle übrigen Ausführungsbeispiele übertragbar, insbesondere mit deren Einzelmerkmalen kombinierbar, ohne daß dadurch der Rahmen der Erfindung verlassen wird.

In der vorangegangenen Beschreibung wurde/n als eine Möglichkeit eine Implementierung der Erfindung für einen CAN-Bus beschrieben und deshalb auch auf diesem Gebiet eingeführte Bezeichnungen verwendet. Gleichwohl überspannt die Erfindung auch anders standardisierte zweidrähtige Busse. Sie ist deshalb in entsprechend ausgestatteten Busteilnehmern - beispielsweise nach J1850- oder ähnlichen Standards - genau so vorteilhaft einsetzbar.

Dem ist in der Zeichnung dadurch Rechnung getragen, daß für Busdrähte sowohl eine neutrale Bezeichnung mit BUS_H und BUS_L als auch eine auf eine beispielhafte CAN-Implementierung lesbare mit CAN_H und CAN_L getroffen ist. Auch in den Ansprüchen wird dem Rechnung getragen durch Verwendung der allgemeineren Bezeichnungen BUS_H und BUS_L und BUS_H/BUS_L, je nachdem, ob ein einzelner Busdraht, oder der Bus als System, oder beide Busdrähte im Sinne des Busleitungsnetzes gemeint sind.

### Betextungsanhang

In Fig. 8 stehen die folgenden Zahlen für
- 801 =: Nennbetrieb
- 802 =: Test
- 803 =: Befehl vom Testgerät über CAN
- 804 =: Befehl vom Testgerät über CAN
- 805 =: Potential-Test Passiv
- Lastströme einschalten
- keine Botschaft senden
- "Senden nicht möglich"
   "Empfangen"
- 806 =: Befehl vom Testgerät über CAN
- 807 =: Potential-Test Aktiv
- Lastströme einschalten
- keine Botschaft senden
- "Senden"
   "Empfangen"
- 808 =: Befehl vom Testgerät über CAN

In Fig. 9 stehen die folgenden Zahlen für
- 901 =: Nennbetrieb
- 902 =: Test
- 903 =: Befehl vom Anwender
- 904 =: Initialisierung Potential-Test
alle Prüflinge -> Zustand Test
(Potential-Test Passiv)
- 905 =: Initialisierung abgeschlossen
- 906 =: Potential-Test
- Prüfling -> Potential-Test Aktiv
- rampenförmige Potentialverschiebung einregeln
- Bereiche der Potentialverschiebung mit fehlerfreier Kommunikation erfassen
- Bereiche der Potentialverschiebung mit nicht fehlerfreier Kommunikation erfassen
- Potentialverschiebung in Bereich der fehlerfreien Kommunikation zum Prüfling legen
- Prüfling -> Potential-Test Aktiv
- 907 =: alle Prüflinge
- 908 =: alle Prüflinge getestet
- 909 =: Ende Potential-Test
alle Prüflinmge → Nennbetrieb
- 910 =: Test abgeschlossen
- 911 =: Bewertung
- 912 =: Bewertung abgeschlossen

## Patentansprüche

1. Verfahren zur Bestimmung von Potentialverschiebungen zwischen Busteilnehmer repräsentierenden oder solchen zugeordneten Elektronikmodulen (ECU) in einem Drahtbusnetz oder der Übereinstimmungsgüte ihrer Kommunikationsbetriebspegel im Netzverbund, wobei das Busmedium aus wenigstens einem Draht (BUS_H; BUS_L; BUS_H und BUS_L) besteht, der mit den Elektronikmodulen (ECU) galvanisch verbunden ist, und wobei die Elektronikmodule (ECU) über eine Potentialschiene (GND) untereinander in Verbindung stehen, welche wenigstens im Falle eindrahtiger Betriebsweise des Busmediums als Bezugspotentialschiene für die Buskommunikation dient, **gekennzeichnet durch** folgende Schritte,
1/ es wird ein Busteilnehmer als Prüfteilnehmer bestimmt, der physikalisch und im Hinblick auf system-spezifisch mögliche Potentialfehler in der Lage ist, mit jedem der übrigen Busteilnehmer als potentiellem Fehlerteilnehmer zu kommunizieren,
2/ der Prüfteilnehmer sendet wenigstens eine Bus-Botschaft aus, um alle zu prüfenden Busteilnehmer in einen Betriebsmodus "Keine Anwendungsbotschaften senden" zu versetzen,
3/ der Prüfteilnehmer sendet wenigstens eine Bus-Botschaft aus, um alle zu prüfenden Busteilnehmer in einen Betriebsmodus "nur Empfangen, Senden nicht möglich" (RECEIVE ONLY) zu versetzen, wodurch diese zu Beobachtungsteilnehmern werden,
4/ der Prüfteilnehmer sendet eine Bus-Botschaft aus, um aus der Menge der Beobachtungsteilnehmer einen bestimmten Teilnehmer als Fehlerteilnehmer in den Betriebsmodus "Senden und Empfangen" (NORMAL) zu versetzen,
5/ der Prüfteilnehmer sendet zyklisch eine Prüf-Botschaft aus,
6/ der potentielle Fehlerteilnehmer in der Betriebsart NORMAL quittiert die Prüf-Botschaft wie folgt:
6.a/ wird eine Prüf-Botschaft vom Fehlerteilnehmer fehlerfrei empfangen, sendet der Fehlerteilnehmer über den Bus eine Gut-Quittung an den Prüfteilnehmer zurück,
6.b/ wird ein Prüf-Botschaft vom Fehlerteilnehmer fehlerhaft empfangen, sendet der Fehlerteilnehmer über den Bus eine Schlecht-Quittung an den Prüfteilnehmer zurück,
6-c/ wird eine Prüf-Botschaft vom Fehlerteilnehmer nicht empfangen, sendet der Fehlerteilnehmer keine Quittung auf den Bus,
7/ der Prüfteilnehmer wertet eine Gut-Quittung als Wahrheitsstatus für eine Fehlerfreiheit der Datenübertragung und eine Schlecht-Quittung oder eine überhaupt fehlende Quittung als Wahrheitsstatus für eine Fehlerhaftigkeit der Datenübertragung,
8/ der Prüfteilnehmer verschiebt einen ersten Quellenpegel, an den der eine zur Prüfung benutzte Busdraht dominant getastet wird,
9/ der Prüfteilnehmer erfasst den Bereich der Potentialverschiebung besagten einen Quellenpegels, in welchem die Prüf-Botschaft gemäß den Schritten 6.a/ und 7/ fehlerfrei empfangen wird, und den Bereich der Potentialverschiebung besagten einen Quellenpegels, in dem die Prüf-Botschaft gemäß den Schritten 6.b/ und 6.c/ nicht oder fehlerhaftempfangen wird,
10/ der Prüfteilnehmer stellt bezüglich eines zuvor prüfungshalber benutzen Busdrahtes eine Potentialverschiebung des diesem Busdraht dominant zugeordneten Quellenpegels in den Bereich ein, in dem die Prüf-Datenübertragung zuvor fehlerfrei möglich war,
11/ nach Beendigung der Prüfung eines Fehlerteilnehmers sendet der Prüfteilnehmer eine Bus-Botschaft aus, um den Fehlerteilnehmer in den Betriebsmodus "Nur Empfang - Senden nicht möglich" (RECEIVE ONLY) zu versetzen, wodurch dieser wieder ein Beobachtungsteilnehmer wird,
12/ die Schritte 4/ bis 11/ werden für spezifisch interessierende oder alle Beobachtungsteilnehmer wiederholt,
13/ die Prüfergebnisse werden bewertet,
14/ das Busnetz wird vom Prüfteilnehmer in seinen Nennbetrieb zurückversetzt.

2. Verfahren nach Anspruch 1,
**dadurch gekennzeichnet,**
**dass** die Schritte 2/ und 3/ untereinander vertauscht sind.

3. Verfahren nach Anspruch 1;
**dadurch gekennzeichnet,**
**dass** die Schritte 13/ und 14/ untereinander vertauscht sind.

4. Verfahren nach Anspruch 1,
**dadurch gekennzeichnet,**
**dass** die Schritte 5/ bis 9/ gleichzeitig erfolgen.

5. Verfahren nach Anspruch 1,
**dadurch gekennzeichnet,**
**dass** die Verschiebung des einen Quellenpegels gemäß Schritt 8/ rampenförmig über der Zeit erfolgt.

6. Verfahren nach Anspruch 1,
**dadurch gekennzeichnet,**
**dass** die Verschiebung des einen Quellenpegels gemäß Schritt 8/ schrittweise monoton erfolgt.

7. Verfahren nach Anspruch 1,
**dadurch gekennzeichnet,**
**dass** die Verschiebung des ersten Quellenpegels gemäß Schritt 8/ in Abwechslung mit der Verschiebung eines weiteren, zweiten Quellenpegels nach Maßgabe durch ein vorgegebenes Verschiebeschrittmuster erfolgt.

8. Verfahren nach Anspruch 1,
**gekennzeichnet durch** den zusätzlichen Schritt
15.a/ Der Prüfteilnehmer sendet nach Schritt 1/ und vor Schritt 4/ eine Bus-Botschaft aus, um einen als Fehlerteilnehmer aufzurufenden Busteilnehmer in einen Betriebsmodus "Teilnehmer-Lastströme eingeschaltet" zu versetzen.

9. Verfahren nach Anspruch 1,
**gekennzeichnet durch** den zusätzlichen Schritt
15.b/ Der Prüfteilnehmer sendet nach Schritt 1/ und vor Schritt 4/ eine Bus-Botschaft aus, um alle Busteilnehmer in einen Betriebsmodus "Teilnehmer-Lastströme eingeschaltet" zu versetzen.

10. Verfahren nach einem der Ansprüche 1 bis 9, **gekennzeichnet durch** den zusätzlichen Schritt
16/ Während aller auf den der Schritt 1/ bis zum Schritt 4/ folgenden Schritte zwecks Aussendung einer Bus-Botschaft verschiebt der Prüfteilnehmer einen Quellenpegel, an dem der eine zur Kommunikation benutzte Busdraht dominant getastet wird.

11. Verfahren nach Anspruch 1,
**dadurch gekennzeichnet,**
- **dass** der Prüfteilnehmer ein dauernd um Bus liegender Busteilnehmer ist und
- **dass** das Verfahren von diesem Busteilnehmer nach jeder neuen Inbetriebnahme des Busnetzes als dem normalen Busbetrieb unterlagert bezüglich aller Busteilnehmer durchgeführt wird.

12. Verfahren nach Anspruch 11,
**dadurch gekennzeichnet,**
**dass** die anlässlich der Überprüfung aller Busteilnehmer nach jeder Inbetriebnahme des Busnetzes gewonnenen Bewertungsergebnisse im Prüfteilnehmer oder einem von diesem auswählbaren Busteilnehmer gespeichert werden.

13. Verfahren nach Anspruch 1,
**dadurch gekennzeichnet,**
**dass** das Drahtbusnetz ein Zweidrahtbusnetz ist.

14. Verfahren nach Anspruch 13,
**dadurch gekennzeichnet,**
**dass** Prüfteilnehmer zwecks Prüfung beide Busdrähte ansteuert.

15. Verfahren nach Anspruch 14,
**dadurch gekennzeichnet,**
**dass** der Schritt 8/ mit dem Schritt 5/ zeitweise botschaftsverkettet schrittweise geschieht und jede Prüf-Botschaft eine Erwartungszahl an den zu prüfenden Fehlerteilnehmer enthält.

16. Verfahren nach Anspruch 15,
**dadurch gekennzeichnet,**
**dass** die Verkettung bitblockbasiert ist.

17. Vorrichtung zur Bestimmung von Potentialverschiebungen zwischen Busteilnehmer repräsentierenden oder solchen zugeordneten Elektronikmodulen (ECU) in einem Drahtbusnetz oder der Übereinstimmungsgüte ihrer Kommunikationsbetriebspegel im Netzverbund, wobei
- das Busmedium aus wenigstens einem Draht (BUS_H; BUS_L; BUS_H und BUS_L) besteht und die Elektronikmodule (ECU) galvanisch mit dem Busmedium verbunden sind und ferner über eine Potentialschiene (GND) untereinander in Verbindung stehen, welche im Falle eindrahtiger Betriebsweise des Busmediums als Bezugspotentialschiene (GND) für die Buskommunikation dient, und wobei jedes Elektronikmodul (ECU) einen Mikroprozessor oder Microcontroller (21) sowie Transceiver-Mittel (100, 100') zur Verwirklichung einer Sende- und Empfangskopplung des Mikroprozessors oder Microcontrollers (21) an das Busmedium umfasst,
**dadurch gekennzeichnet,**
**dass** sie
- mit Mitteln zur Durchführung der Schritte eines Verfahrens nach Anspruch 1 ausgestattet ist,
- als Bestandteil der Transceiver-Mittel (100, 100')
- Mittel zur Sperrung der Sendemittel bei Empfangsbetrieb (RECEIVE ONLY) sowie
- mit dem Mikroprozessor oder Microcontroller (21) in Verbindung stehende und mit den Transceiver-Mitteln (100, 100') verbundene oder verbindbare (195, 195'; 166.5; 266), kooperative Potentialsteuermittel (199A; 199; 199'; 199.1, 1991) umfasst und
- mit diesen in Bezug auf Teile der Sende- und/oder Empfangsmittel (130 und/oder 120, 120'; 120") der Transceiver-Mittel (100, 100') eine steuerbare (266, 266'; 166.5, 195) Spannungsquelle (Q_{SG}; Q_{SL}; Q_{SH}; Q_{SHH}; Q_{VCC}; Q_{Ua}; V_{TH}; V_{TL}; 121.7; 1301, 1302) verwirklicht, die einen im Sendefall dominanten Quellenpegel und/oder einen im Empfangsfall diskriminanten Signalpegel zu beeinflussen erlaubt.

18. Vorrichtung nach Anspruch 17,
**dadurch gekennzeichnet,**
**dass** die Potentialsteuermittel (199A; 199, 199') von einem Mikroprozessor oder Microcontroller (21) digital ansteuerbar sind.

19. Vorrichtung nach Anspruch 17,
**dadurch gekennzeichnet,**
**dass** die Potentialsteuermittel (199A; 199, 199') so beschaffen sind, dass beim Senden ein Quellenpegel, der den dominanten Zustand auf dem betreffenden Busdraht (BUS_H, BUS_L) bestimmt, monoton inkrementell, dekrementell oder in- und dekrementell verschoben werden kann.

20. Vorrichtung nach Anspruch 17,
**dadurch gekennzeichnet,**
**dass** bei Beeinflussbarkeit von zwei im Sendefalle dominanten Quellenpegeln beide voneinander unabhängig einstellbar oder veränderbar sind.

21. Vorrichtung nach Anspruch 17,
**dadurch gekennzeichnet,**
**dass** zwei im Sendefalle dominante Quellenpegel so einstellbar oder verschiebbar sind, dass dabei der Abstand beider Pegel im wesentlichen beibehalten bleibt.

22. Vorrichtung nach Anspruch 17,
**dadurch gekennzeichnet,**
**dass** sie einen signaldedizierten Anschluss (13; GND) als Bezugspotentialschiene der Empfangsmittel (120, 120', 120 ") der Transceiver-Mittel (100, 100') aufweist.

23. Vorrichtung nach Anspruch 17,
**dadurch gekennzeichnet,**
**dass** sie einen besonderen Anschluss(13.1, System GND, 218) als Bezugspotentialschiene der Mittel (199A; 199, 199') zur Einstellung oder Veränderung beim Senden einer der beiden dominanten Quellenpegel umfasst.

24. Vorrichtung nach Anspruch 17,
**dadurch gekennzeichnet,**
**dass** sie einen besonderen Anschluss (13.2, Remote GND/Sense, 217) aufweist, über welchen die Potentialsteuermittel (199A; 199, 199') mit einem Bezugspotential (Remote GND, Sense, Reference) im Umfeld des die Transceiver-Mittel (100, 100') tragenden Elektronikmoduls wirkverbindbar (196; 217) sind.

25. Vorrichtung nach Anspruch 24,
**dadurch gekennzeichnet,**
**dass** sie in dem Pfad besagter Wirkverbindung Schutzmittel (198) gegen Überspannung und/oder Falschpolung und/oder hochfrequente Signaleinspeisung umfasst.

26. Vorrichtung gemäß Anspruch 17,
**dadurch gekennzeichnet,**
**dass** sie eine in den bezugspotentialnahen Versorgungsanschluss
der Sendemittel (133; 133L, 133H) eingeschleifte, einstellbare Offset-Spannungsquelle (Q_{SG}) realisiert und die Sendemittel, (133; 133L, 133H) konstantspannungsversorgt (20; CD).

27. Vorrichtung gemäß Anspruch 26,
**dadurch gekennzeichnet,**
**dass** den konstantspannungsversorgten Sendemitteln (133; 133L, 133H) analog wirkende Teile der Empfangsmittel (120', 120"; 121.20) stromversorgungsmäßig parallel (20; CD) geschaltet sind und besagte Offset-Spannungsquelle (Q_{SG}) somit auch empfangsseitig wirksam ist.

28. Vorrichtung gemäß Anspruch 17,
**dadurch gekennzeichnet,**
**dass** sie eine in den bezugspotentialnahen Versorgungsanschluss
der den Busdraht BUS_L ansteuernden Schaltendstufe (133L) der Sendemittel (133) eingeschleifte erste einstellbare Offset-Spannungsquelle (Q_{SL}) und eine in einen potentialmäßig entgegengesetzten Versorgungsanschluss der den Busdraht BUS_H ansteuernden Schaltendstufe (133H) der Sendemittel (133) eingeschleifte zweite einstellbare Offset-Spannungsquelle (Q_{SH}) realisiert.

29. Vorrichtung gemäß Anspruch 17,
**dadurch gekennzeichnet,**
**dass** sie eine in den bezugspotentialnahen Versorgungsanschluss der den Busdraht BUS_L ansteuernden Schaltendstufe (133L) der Sendemittel (133) eingeschleifte erste einstellbare Offset-Spannungsquelle (Q_{SL}) und eine in einen potentialmäßig entgegengesetzten Versorgungsanschluss der den Busdraht BUS_H ansteuernden Schaltendstufe (133H) der Sendemittel (133) eingeschleifte zweite und dritte einstellbare Offset-Spannungsquelle (Q_{SH}, Q_{SHH}) realisiert, wobei letztere auf unterschiedlich hohe Versorgungspotentiale bezogen oder an unterschiedlich hohe Versorgungspotentiale angeschlossen sind.

30. Vorrichtung gemäß Anspruch 29,
**dadurch gekennzeichnet,**
**dass** die zweite und dritte Offset-Spannungsquelle (Q_{SH}, Q_{SHH}) alternativ aktivierbar sind.

31. Vorrichtung gemäß Anspruch 28 oder 30,
**dadurch gekennzeichnet,**
**dass** die bezugspotentialbezogene Offset-Spannungsquelle (Q_{SL}) und die wirksame, bezugspotentialferne Offset-Spannungsquelle (Q_{SH}/ Q_{SHH}) nur in zeitlicher Aufeinanderfolge abwechselnd aktivierbar sind.

32. Vorrichtung gemäß Anspruch 29,
**dadurch gekennzeichnet,**
**dass** sie Mittel (199.5, 199.7, 199.8, 199.2X) umfasst, welche eine Wirksamschaltung der zweiten und dritten Offset-Spannungsquelle (Q_{SH} und Q_{SHH}) in Abhängigkeit vom Sendesignal (TxD) erlauben.

33. Vorrichtung gemäß einem der Ansprüche 26 bis 32,
**dadurch gekennzeichnet,**
**dass** die Potentialsteuermittel (199, 199') Mittel zur autonomen Veränderung (199.7 i.V. mit 199.2; 199.2X) der Einstellung einer Offset-Spannungsquelle (Q_{SG}, Q_{SL}/ Q_{SH}, Q_{SHH}) über der Zeit umfassen.

34. Vorrichtung gemäß Anspruch 33,
**dadurch gekennzeichnet, dass** diese Veränderung in Abhängigkeit vom sendeseitigen Datensignal (TxD) möglich ist.

35. Vorrichtung gemäß Anspruch 33,
**dadurch gekennzeichnet,**
**dass** den Mitteln zur autonomen Veränderung der Einstellung einer Offset-Spannungsquelle (Q_{SG}, Q_{SL}, Q_{SH}, Q_{SHH}) ein von dem Mikroprozessor oder Microcontroller (21) beziehbares (201.1; 166, 166.5, 199.1) Taktsignal (SPI CLOCK) zuführbar ist.

36. Vorrichtung gemäß Anspruch 17 oder 19,
**dadurch gekennzeichnet,**
**dass** die Potentialsteuermittel (199A; 199, 199') Regelungsmittel umfassen, welche es erlauben, die Potentialsteuerung nach Maßgabe durch eine von dem Mikroprozessor oder Microcontroller (21) empfangbare Wertvorgabe in Abhängigkeit von einem an einem Busdraht (BUS_H, BUS_L) abnehmbaren Potential ( U_{BUS_H}, U_{BUS_L}) vorzunehmen.

37. Vorrichtung gemäß Anspruch 17 oder 19,
**dadurch gekennzeichnet,**
**dass** sie- unabhängig von den Sendemitteln (133; 133H, 133L) - mit einem Busdraht (BUS_H, BUS-L) verbundene oder verbindbare Ersatzmittel (2019, RL', DL') umfasst, welche eine durch das Sendesignal (TxD) getastete Aufschaltung auf den wenigstens einen Busdraht (BUS_H, BUS_L) eines geregelten Potentials (Ua) erlauben.

38. Vorrichtung gemäß Anspruch 37,
**dadurch gekennzeichnet,**
**dass** sie Messmittel (1991EL) umfasst, welche die Erfassung einer durch die Ersatzmittel (2019, RL', DL') verursachten Fehlergröße (U_{ERR}) zum Zwecke ihrer Kompensation durch Regelaufschaltung (2010L') oder rechnerische Berücksichtigung (2022; 21) bei der Sollwertvorgabe (166.5, 199.21;) für die Regelung (Ua) durch den Mikroprozessor oder Microcontroller (21) leisten.

39. Vorrichtung gemäß Anspruch 17 oder 19,
**dadurch gekennzeichnet,**
**dass** sie unabhängig von den Sendemitteln (133; 133H, 133L) - mit einem Busdraht (BUS_L) verbundene oder verbindbare Ersatzmittel (2019, RL', DL') umfasst, über welche eine durch das Sendesignal (TxD) getastete Aufschaltung auf den Busdraht (BUS_L) eines nicht geregelten Potentials (Ua) nach Maßgabe durch einen von dem Mikroprozessor oder Microcontroller (21) vorgebbaren (201.1, 166, 166.5, 199.2) Digitalwert möglich ist.

40. Vorrichtung nach einem der Ansprüche 37 bis 39,
**dadurch gekennzeichnet,**
**dass** zwecks Leitendsteuerung eines der Ersatzmittel (2019) diesem das Sendesignal (TxD) von der betreffenden Aderendstufe (133L) über einen Umschalter (SWL) zuführbar ist, der die Endstufe (133L) von dem Busdraht (BUS_L) trennt.

41. Vorrichtung gemäß Anspruch 36,
**dadurch gekennzeichnet,**
**dass** die Regelungsmittel einen mit einem Busdraht (BUS_H, BUS_L) wirkverbundenen (2018) Sampler (2015) und ein Halteglied oder einen haltenden Regler (1991H) umfassen.

42. Vorrichtung gemäß Anspruch 41,
**dadurch gekennzeichnet,**
**dass** es sich bei dem Sampler (2015) um einen solchen mit zwei Diodenstrecken (DS1, DS2) handelt, wobei die zweite Diodenstrecke (DS2) zur Kompensation von Temperatureinflüssen und/oder einer abtaststromflussbedingten Fehlerspannung längs der ersten Diodenstrecke (DS1) vorgesehen ist.

43. Vorrichtung gemäß Anspruch 17,
**dadurch gekennzeichnet,**
**dass** die Potentialsteuermittel (199, 199') so beschaffen sind, dass sie die Beeinflussung eines rezessiv diskriminanten Signalpegels durch Beeinflussung (121.4, 121.5; CVTH, CVTL) einer Schwellenspannung (VT_{H}, VT_{L}) im Empfänger (120") erlauben.

44. Vorrichtung gemäß Anspruch 17,
**dadurch gekennzeichnet, dass** sie für die Empfangsmittel (120") auf eine Bezugspotentialschiene (FTG; 121.13) bezogene Mittel (121.4, 121.5) zur Vorgabe zweier Schwellwerte (VT_{H}, VT_{L}) aufweist, und dass diese Bezugspotentialschiene wirkverbunden ist mit einem Bezugspotentialanschluss oder wahlweise wirkverbindbar (57) ist mit mindestens zwei alternativen Bezugspotentialanschlüssen (13, 13.1, 13.2) des Elektronikmoduls.

45. Vorrichtung gemäß Anspruch 17,
**dadurch gekennzeichnet,**
**dass** die Beeinflussung durch eine in dem bezugspotentialnahen (GND) Versorgungsstrompfad (DG: Fußpunkt 121.15 -> 195.5) analog wirkender Teile der Empfangsmittel (120"; 121.1, 121.2, 121.3; 121.20) liegende einstellbare Offset-Spannungsquelle (Q_{SG}: 121.7) möglich ist.

46. Vorrichtung gemäß den Ansprüchen 44 und 45,
**dadurch gekennzeichnet,**
**dass** die Bezugspotentialschiene (FTG; 121.13) der Schwellwertvorgabemittel (121.4, 121.5 ) mit dem bezugspotentialnahen (GND) Versorgungsfußpunkt (121.15) der analog wirkenden Teile (121.10) der Empfangsmittel (120") Verbindbar (S₆) ist.

47. Vorrichtung gemäß Anspruch 17,
**dadurch gekennzeichnet, dass** die Empfangsmittel (120") auf einen Versorgungsfußpunkt (121.15) bezogene Pegeldiskriminationsmittel (121.1, 121.2, 121.3) aufweisen, und dass dieser Versorgungsfußpunkt wirkverbunden ist mit einem Bezugspotentialanschluss oder wahlweise wirkverbindbar (S₈) ist mit zwei alternativen Bezugspotentialanschlüssen (13, 13.1, 13.2) des Elektronikmoduls.

48. Vorrichtung gemäß Anspruch 17,
**dadurch gekennzeichnet,**
**dass** sie Digital/Analog-Wandlungsmittel (199.2, 199.2X) und/oder Analog/Digital-Wandlungsmittel (199.3) umfasst.

49. Vorrichtung gemäß Anspruch 17,
**dadurch gekennzeichnet,**
**dass** sie Digital/Analog-Wandlungsmittel (199.2X) umfasst, die sämtliche Bezugswerte, Steuer- und Schaltsignale für allfällig im Sende- und/oder Empfangsbetrieb der Transceiver-Mittel (100') vorzunehmenden Potentialbeeinflussungen zu erzeugen vermögen.

50. Vorrichtung gemäß einem der Ansprüche 28 bis 33 oder gemäß Anspruch 35,
**dadurch gekennzeichnet,**
**dass** eine auf ein höheres Versorgungspotential (VCC_{A}, V_{T}, VBATT) bezogene Offset-Spannungsquelle (Q_{SH} oder Q_{SHH}) durch eine auf ein niedrigeres Versorgungspotential (GND) bezogene, entsprechend offsetfähig variable Versorgungsspannungsquelle (Q_{VCC'}) ersetzt ist.

51. Vorrichtung gemäß Anspruch 17,
**dadurch gekennzeichnet,**
**dass** sie Bestandteil eines Elektronikmoduls ist, welches für nur eindrähtigen Empfang und/oder nur eindrähtige Sendeweise ausgebildet, beschaltbar oder ansteuerbar (142, 157, 172/SWM) ist.

52. Vorrichtung gemäß Anspruch 17,
**dadurch gekennzeichnet,**
**dass** es sich bei dem Elektronikmodul um einen integrierten Halbleiterschaltkreis handelt.

53. Vorrichtung gemäß Anspruch 17,
**dadurch gekennzeichnet, dass** sie Bestandteil eines integrierten Halbleiterschaltkreises ist, welcher außer der Vorrichtung besagte Mittel (100, 100') zur Verwirklichung der Transceiver-Mittel für den Mikroprozessor oder Microcontroller (21) an das Busmedium trägt.

54. Vorrichtung nach Anspruch 53,
**dadurch gekennzeichnet,**
**dass** die mit der Vorrichtung kooperativen Transceiver-Mittel (100, 100') für eine Kommunikation nach CAN-Standard und zum Anschluss an ein CAN-Busleitungsnetz (CAN_H/CAN_L) ausgebildet ist.

55. Vorrichtung nach Anspruch 53,
**dadurch gekennzeichnet,**
**dass** die Transceiver-Mittel umfassen:
- Empfangsmittel (120, 120', 120") mit einem Eingang (11, 12) zum Anschluss eines Busdrahtes (BUS_H, BUS_L) und einen Ausgang (3) zum Anschluss an den Empfangseingang (Rx) des Mikroprozessors oder Microcontrollers (21) und
- Sendemittel (130; 133; 133H, 133L) mit einem Eingang (2) zum Anschluss an den Sendeausgang (Tx) des Mikroprozessors oder Microcontrollers (21) und einem Ausgang (11, 12) zum Anschluss an einen Busdraht (BUS_H, BUS_L);
- **dass** die Transceiver-Mittel in den zwei verschiedenen Betriebsarten
- "Senden und Empfang / NORMAL",
- "kein Senden - nur Empfang / RECEIVE ONLY" betreibbar sind, und dass sie einen Eingangsport (6, 5; 201, 201.1, 166) zum Empfang eines Selektionssignales des Mikroprozessors oder Microcontrollers (21) zur Auswahl einer dieser zwei Betriebsarten aufweist.

56. Vorrichtung nach Anspruch 53,
**dadurch gekennzeichnet, dass** die Transceiver-Mittel umfassen:
- Empfangsmittel (120, 120', 120") mit zwei Eingängen zum Anschluss an die beiden Busdrähte (BUS_H, BUS_L) und einem Ausgang (3) zum Anschluss an den Empfangseingang (Rx) des Mikroprozessors oder Microcontrollers (21) und Sendemittel (133) mit einem Eingang (2) zum Anschluss an den Sendeausgang (Tx) des Mikroprozessors oder Microcontrollers (21 und zwei Ausgängen (11, 12) zum Anschluss an die beiden Busdrähte (BUS_H, BUS_L);
- Mittel, die beim Auftreten eines die normale Kommunikationsweise über beide Busdrähte beeinträchtigenden Busfehlers sowohl die Empfangsmittel (120) als auch die Sendemittel (133) für die beste noch bestehende Möglichkeit einer Notkommunikation über den Bus einzustellen und/oder umzukonfigurieren und/oder zu adaptieren vermögen;
- Busfehler-Erkennungsmittel (132) und Busfehler-Auswertungsmittel (144) zur Aufbereitung wenigstens eines an den Microcontroller (21) abgebbaren (4; 24) Fehler- oder Unterbrechungssignals (ERR/INT);
- mit den Busfehler-Erkennungsmitteln (132) kooperative Bus-Abschluss-Umschaltmittel (131), welche jedes von zwei an zwei Eingängen (8, 9) der Transceiver-Mittel anschließbaren Abschlusselementen (16, 17) an einen ihm zugeordneten Busdraht (BUS_H, BUS_L) anzuschalten vermögen (16 an BUS_H, 17 an BUS_L).

57. Vorrichtung nach einem der Ansprüche 37 bis 39,
**dadurch gekennzeichnet,**
**dass** die wesentlichen Teile der Vorrichtung in einem mobilen Prüfgerät (PG) angeordnet sind, welches einerseits mit einem Busdraht (BUS_H, BUS_L) und andererseits mit einem Abschlusswiderstand im Elektronikmodul und dem Ausgang einer Sendeendstufe (133L, 133H) der Transceiver-Mittel des Elektronikmoduls Verbindbar (BL, TL, EL) ist.

58. Vorrichtung nach Anspruch 57,
**dadurch gekennzeichnet,**
**dass** die Vorrichtung einen Umschalter (SWL, SWH) umfasst, mittels dessen die eine Endstufe (133H, 133L) der Sendemittel (130) des Elektronikmoduls (ECU) wahlweise mit dem wenigstens einen Busdraht (BUS_H, BUS_L; BL) oder mit einem entsprechenden Ansteuereingang eines Ersatzmittels (2019) Verbindbar ist.

59. Vorrichtung nach Anspruch 53,
**dadurch gekennzeichnet,**
**dass** der integrierte Halbleiterschaltkreis in einer Hochvolt-Technologie hergestellt ist.

60. Vorrichtung nach einem der Ansprüche 16 bis 59,
**dadurch gekennzeichnet,**
**dass** sie ausgebildet ist in oder bei einem der folgenden:
- Verkehrsmittel,
- Steuergerät der Automatisierungstechnik.

## Claims

1. Method for the determination of potential shifts between electronic modules (ECU) representing bus subscribers or ones associated therewith in a wire bus network, or the matching quality of their communication operating level in network connection, such that the bus medium consists of at least one wire (BUS_H; BUS_L; BUS_H and BUS_L), which is in conductive connection with the electronic modules (ECU) and such that the electronic modules (ECU) are connected together via a potential rail (GND), which at least in the case of single-wire operation of the bus medium, serves as the reference potential rail for the bus communication, **characterised by** the following steps:
1/ a bus subscriber is determined as the testing subscriber, which is physically and in relation to system-specific possible potential errors capable of communicating with each of the other bus subscribers as a potentially faulty subscriber,
2/ the testing subscriber emits at least one bus message, to reset all the other bus subscribers to be tested to a "Do not send application messages" operating mode,
3/ the testing subscriber emits at least one bus message, to reset all the bus subscribers to be tested to a "Receive only, sending not possible" (RECEIVE ONLY) operating mode, whereby these become observer subscribers,
4/ the testing subscriber emits a bus message to reset one particular subscriber out of all the observer subscribers as the defective subscriber to the "send and receive" (NORMAL) operating mode,
5/ the testing subscriber emits a test message cyclically,
6/ the potentially faulty subscriber in the NORMAL operating mode reacts to the test message as follows:
6.a/ if a test message is received by the faulty subscriber without error, the defective subscriber returns a "good" acknowledgement to the testing subscriber via the bus,
6.b/ if a test message is received by the faulty subscriber erroneously, the faulty subscriber returns a "bad" acknowledgement to the testing subscriber via the bus,
6.c/ if a test message is not received at all by the faulty subscriber, the faulty subscriber emits no acknowledgement to the bus,
7/ the testing subscriber evaluates a "good" acknowledgement as the truth status for error-free data transfer and a "bad" acknowledgement or a lack of any acknowledgement as the truth status for faulty data transfer.
8/ the testing subscriber resets a first source level, at which the one bus wire used for testing is dominantly keyed.
9/ the testing subscriber detects the range of the potential shift of the said source level, in which the test message is received without error in accordance with steps 6.a/ and 7/, and the range of the potential shift of the said source level, in which the test message is received in accordance with steps 6.b/ and 6.c/ erroneously or not at all,
10/ the testing subscriber establishes, in relation to a bus wire previously used for test purposes, a potential shift of the source level dominantly associated with this bus wire, to a range in which the test data transfer was previously possible without error,
11/ after the testing of a faulty subscriber has ended, the testing subscriber emits a bus message to reset the faulty subscriber to the "Receive only, sending not possible" (RECEIVE ONLY) operating mode, whereby it again becomes an observer subscriber,
12/ steps 4/ to 11/ are repeated for specific subscribers of interest or for all the observer subscribers,
13/ the test results are evaluated,
14/ the bus network is restored to its nominal operating mode by the testing subscriber.

2. Method according to Claim 1,
**characterised in that**
steps 2/ and 3/ are interchanged.

3. Method according to Claim 1,
**characterised in that**
steps 13/ and 14/ are interchanged.

4. Method according to Claim 1,
**characterised in that**
steps 5/ to 9/ take place simultaneously.

5. Method according to Claim 1,
**characterised in that**
the setting of the source level in accordance with step 8/ takes place by ramp-shaped variation in time.

6. Method according to Claim 1,
**characterised in that**
the setting of the source level in accordance with step 8/ takes place in monotonic steps.

7. Method according to Claim 1,
**characterised in that**
the setting of the first source level in accordance with step 8/ takes place in alternation with the setting of a further, second source level according to a predetermined setting step pattern.

8. Method according to Claim 1,
**characterised by** the additional step:
15.a/ After step 1/ and before step 4/ the testing subscriber emits a bus message to set a bus subscriber to be addressed as a faulty subscriber to a "subscriber load current switched on" operating mode.

9. Method according to Claim 1,
**characterised by** the additional step:
15.b/ After step 1/ and before step 4/ the test subscriber emits a bus message to set all the bus subscribers to a "subscriber load current switched on" operating mode.

10. Method according to any of Claims 1 to 9,
**characterised by** the additional step:
16/ During all the steps following step 1/ to step 4/, for the purpose of emitting a bus message the testing subscriber sets a source level at which the one bus wire used for communication is dominantly keyed.

11. Method according to Claim 1,
**characterised in that**
- the testing subscriber is a bus subscriber permanently connected to the bus, and
- the method is implemented by this bus subscriber after each new start-up of the bus network, underlying the normal bus operation and with reference to all the bus subscribers.

12. Method according to Claim 11,
**characterised in that**
the evaluation results obtained from the testing of all the bus subscribers after each start-up of the bus network, are stored in the testing subscriber or in a bus subscriber that can be selected by it.

13. Method according to Claim 1,
**characterised in that**
the bus network is a two-wire bus network.

14. Method according to Claim 1,
**characterised in that**
for testing purposes the testing subscriber controls both bus wires.

15. Method according to Claim 14,
**characterised in that**
step 8/ takes place with step 5/ in steps message-linked in time, and each test message comprises an expected number of the faulty subscriber to be tested.

16. Method according to Claim 15,
**characterised in that**
the linking is based on bit blocks.

17. Device for the determination of potential shifts between electronic modules (ECU) representing bus subscribers or ones associated therewith in a wire bus network, or the matching quality of their communication operating level in network connection, such that:
- the bus medium consists of at least one wire (BUS-H; BUS-L; BUS-H and BUS-L) and the electronic modules are in conductive connection with the bus medium and are in addition connected to one another by a potential rail (GND), which in the case of single-wire operation of the bus medium serves as the reference potential rail (GND) for the bus communication, and such that each electronic module (ECU) comprises a microprocessor or microcontroller (21) and transceiver means (100, 100') for creating a sending and receiving coupling of the microprocessor or microcontroller (21) to the bus medium,
**characterised in that**
- it is equipped with means to implement the steps according to Claim 1,
- and as part of the transceiver means (100, 100'),
- it comprises means to block the sending means during receiving (RECEIVE ONLY) operation, and
- cooperative potential control means (199A; 199; 199'; 199.1; 1991) which are in connection with the microprocessor or microcontroller (21) and which are or can be connected to the transceiver means (100, 100'), and
- together with these in relation to parts of the sending and/or receiving means (130 and/or 120, 120'; 120") of the transceiver means (100, 100') it forms a controllable (266, 266'; 166.5, 195) voltage source (Q_{SG}; Q_{SL}; Q_{SH}; Q_{VCC}; Q_{Ua}; V_{TH}; V_{TL}; 121.7; 1301, 1302), which allows a source level that is dominant in the sending case and/or a discriminating signal level in the receiving case to be influenced.

18. Device according to Claim 17,
**characterised in that**
the potential control means (199A; 199, 199') can be digitally controlled by a microprocessor or microcontroller (21).

19. Device according to Claim 17,
**characterised in that**
the potential control means (199A; 199, 199') provided are such that during sending, a source level, which determines the dominant condition at the bus wire (BUS-H, BUS-L) concerned, can be monotonically shifted incrementally, decrementally, or incrementally and decrementally.

20. Device according to Claim 17,
**characterised in that**
when, in the sending case, two dominant source levels can be influenced, both can be adjusted or varied independently of one another.

21. Device according to Claim 17,
**characterised in that**
two source levels that are dominant in the sending case can be so adjusted or varied that the distance between the two levels remains essentially constant.

22. Device according to Claim 17,
**characterised in that**
it comprises a signal-dedicated terminal (13; GND) as the reference potential rail of the receiving means (120, 120', 120") of the transceiver means (100, 100').

23. Device according to Claim 17,
**characterised in that**
it comprises a special terminal (13.1, GND system, 218) as the reference potential rail of the means (199A; 199, 199') for adjusting or varying the two dominant source levels during sending.

24. Device according to Claim 17,
**characterised in that**
it comprises a special connection (13.2, Remote GND/Sense, 217) via which the potential control means (199A; 199, 199') can be actively connected to a reference potential (Remote GND, Sense, Reference) in the environment of the electronic module carrying the transceiver means (100, 100').

25. Device according to Claim 24,
**characterised in that**
it comprises in the path of the said active connection protection means (198) against overvoltage and/or erroneous pole reversal and/or high-frequency signal input.

26. Device according to Claim 17,
**characterised in that**
it realises an adjustable offset-voltage source (Q_{SG}) looped into the supply terminal at near-reference potential of the sending means (133; 133L, 133H) and the sending means (133; 133L, 133H) supplies a constant voltage (20; CD).

27. Device according to Claim 26,
**characterised in that**
the parts of the receiving means (120', 120"; 121.20) that act analogously to the sending means (133; 133L, 133H) supplied with constant voltage are connected in parallel in terms of current supply (20; CD) and the said offset-voltage source (Q_{SG}) is therefore also active on the receiving side.

28. Device according to Claim 17,
**characterised in that**
it realises a first adjustable offset-voltage source (Q_{SL}) looped into the supply terminal at near-reference potential of the final switching stage (133L) of the sending means (133), which controls the bus wire (BUS_L) and a second adjustable offset-voltage source (Q_{SH}) looped into a supply terminal, of opposite potential, of the final switching stage (133H) of the sending means (133), which controls the bus wire BUS_H.

29. Device according to Claim 17,
**characterised in that**
it realises a first adjustable offset-voltage source (Q_{SL}) looped into the supply terminal at near-reference potential of the final switching stage (133L) of the sending means (133), which controls the bus wire BUS_L, and second and third adjustable offset-voltage sources (Q_{SH}, Q_{SHH}) looped into a supply terminal, of opposite potential, of the final switching stage (133H) of the sending means (133), which controls the bus wire BUS_H, such that the latter are at supply potentials of different levels or are connected to supply potentials of different levels.

30. Device according to Claim 29,
**characterised in that**
the second and third offset-voltage sources (Q_{SH}, Q_{SHH}) can be activated alternatively.

31. Device according to Claims 28 or 30,
**characterised in that**
the reference-potential-related offset voltage source (Q_{SL}) and the active offset-voltage sources (Q_{SH}, Q_{SHH}) at potentials different from the reference potential, can only be activated in alternation in a time sequence.

32. Device according to Claim 29,
**characterised in that**
it comprises means (199.5, 199.7, 199.8, 199.2X) which allow effective switching of the second and third offset-voltage sources (Q_{SH} and Q_{SHH}) as a function of the sending signal (TxD).

33. Device according to any of Claims 26 to 32,
**characterised in that**
the potential control means (199, 199') comprise means for the autonomous variation (199.7 in combination with 199.2; 199.2X) of the setting of an offset-voltage source (Q_{SG}, Q_{SL}, Q_{SH}, Q_{SHH}) with time.

34. Device according to Claim 33,
**characterised in that**
the said variation can take place as a function of the data signal (TxD) from the sender side.

35. Device according to Claim 33,
**characterised in that**
the means for autonomous variation of the setting of an offset-voltage source (Q_{SG}. Q_{SL}, Q_{SH}, Q_{SHH}) can be fed with a timing signal (SPI CLOCK) which can be drawn (201.1; 166, 166.5, 199.1) from the microprocessor or microcontroller (21).

36. Device according to Claims 17 or 19,
**characterised in that**
the potential control means (199A; 199, 199') comprise regulating means which make it possible to undertake the potential control in accordance with a value that can be received by the microprocessor or microcontroller (21) as a function of a potential (U_{BUS_H}, U_{BUS_L}) that can be taken from a bus wire (BUS_H, BUS_L).

37. Device according to Claims 17 or 19,
**characterised in that**
independently of the sending means (133; 133H, 133L), it comprises replacement means (2019, RL', DL') that are or can be connected to a bus wire (BUS_H, BUS_L), which allow a regulated potential (Ua), keyed by the sending signal (TxD), to be switched to the at least one bus wire (BUS_H, BUS_L).

38. Device according to Claim 37,
**characterised in that**
it comprises measurement means (1991EL) which determine an error magnitude (U_{ERR}) caused by the replacement means (2019, RL', DL') for the purpose of compensating it by a control modulation (2010L') or by making a computed allowance (2022; 21) when the nominal value is specified (166.5, 199.21) for the regulation (Ua) by the microprocessor or microcontroller (21).

39. Device according to Claims 17 or 19,
**characterised in that**
independently of the sending means (133; 133H, 133L), it comprises replacement means (2019, RL', DL') that are or can be connected to a bus wire (BUS_L), which allow a non-regulated potential (Ua), keyed by the sending signal (TxD), to be switched to the bus wire (BUS_L) in accordance with a digital value which can be specified (201.1, 166, 166.5, 199.2) by the microprocessor or microcontroller (21).

40. Device according to any of Claims 37 to 39,
**characterised in that**
for the purpose of controlling the leading end of one of the replacement means (2019), the sending signal (TxD) can be fed to it from the lead output stage (133L) concerned via a commutator (SWL) which separates the output stage (133L) from the bus wire (BUS_L).

41. Device according to Claim 36,
**characterised in that**
the control means comprise a sampler (2015) actively connected (2015) to a bus wire (BUS_H, BUS_L) and a holding member or holding regulator (1991H).

42. Device according to Claim 41,
**characterised in that**
the sampler (2015) is one with two diode paths (DS1, DS2), such that the second diode path (DS2) is provided for the compensation of temperature influences and/or an error voltage caused by the sampling current flow along the first diode path (DS1).

43. Device according to Claim 17,
**characterised in that**
the potential control means (199, 199') are designed to allow a recessive discriminating signal level to be influenced by influencing (121.4, 121.5; CVTH, CVTL) a threshold voltage (VT_{H}, VT_{L}) in the receiver (120").

44. Device according to Claim 17,
**characterised in that**
for the receiver means (120") it comprises means (121.4, 121.5) related to a reference potential rail (FTG; 121.13) for the specification of two threshold values (VT_{H}, VT_{L}), and this reference potential rail is actively connected to a reference potential connection or, optionally, can be actively connected (57) to at least two alternative reference potential connections (13, 13.1, 13.2) of the electronic module.

45. Device according to Claim 17,
**characterised in that**
an influence can be exerted by an adjustable offset-voltage source (Q_{SG}:121.7) located in the near-reference potential (GND) supply current path (DG: base-point 121.15 → 195.5) through parts of the receiving means (120"; 121.1, 121.2, 121.3; 121.20) acting in analog mode.

46. Device according to Claims 44 and 45,
**characterised in that**
the reference potential rail (FTG; 121.13) of the threshold value specification means (121.4, 121.5) can be connected (S₆) to the near-reference potential (GND) supply base-point (121.15) of the parts (121.10) of the receiving means (120") acting in analog mode.

47. Device according to Claim 17,
**characterised in that**
the receiving means (120") comprise level discrimination means (121.1, 121.2, 121.3) related to a supply base-point (121.15), and this supply base-point is in active connection with a reference potential terminal or, optionally, can be actively connected (S₈) to two alternative reference potential terminals (13, 13.1, 13.2) of the electronic module.

48. Device according to Claim 17,
**characterised in that**
it comprises digital/analog conversion means (199.2, 199.2X) and/or analog/digital conversion means (199.3).

49. Device according to Claim 17,
**characterised in that**
it comprises digital/analog conversion means (199.2X), which enable all the reference values, control and switching signals for all possible effects on potential during sending and/or receiving operation of the transceiver means (100') to be produced.

50. Device according to any of Claims 28 to 33 or according to Claim 35,
**characterised in that**
an offset-voltage source (Q_{SH} or Q_{SHH}) related to a higher supply potential (VCC_{A}, V_{T}, VBATT) is replaced by a supply voltage source (Q_{VCC'}) related to a lower supply potential (GND) and which has a correspondingly variable offset capability.

51. Device according to Claim 17,
**characterised in that**
it is part of an electronic module which is designed and can be switched or controlled (142, 157, 172/SWM) for only single-wire reception and/or only single-wire sending.

52. Device according to Claim 17,
**characterised in that**
the said electronic module is an integrated semiconductor circuit.

53. Device according to Claim 17,
**characterised in that**
it is part of an integrated semiconductor circuit, which besides the device, comprises the said means (100, 100') for realising the transceiver means for the microprocessor or microcontroller (21) in the bus medium.

54. Device according to Claim 53,
**characterised in that**
the transceiver means (100, 100') that cooperate with the device are designed for communication in accordance with CAN-standard and for connection to a CAN-bus line network (CAN_H/CAN_L).

55. Device according to Claim 53,
**characterised in that**
the transceiver means comprise:
- receiving means (120, 120', 120") with an input (11, 12) for the connection of a bus wire (BUS_H, BUS_L) and an output (3) for connection to the receiving input (Rx) of the microprocessor or microcontroller (21), and
- sending means (130; 133; 133H, 133L) with an input (2) for connection to the sending output (Tx) of the microprocessor or microcontroller (21) and an output (11, 12) for connection to a bus wire (BUS_H, BUS_L);
- such that the transceiver means can be operated in the two different operating modes:
- "send and receive/NORMAL",
- "no sending - reception only/RECEIVE ONLY", and such that it comprises an input port (6, 5; 201, 201.1, 166) for the reception of a selection signal of the microprocessor or microcontroller (21) for selecting one of these two operating modes.

56. Device according to Claim 53,
**characterised in that**
the transceiver means comprise:
- receiving means (120, 120', 120") with two inputs for connection to the two bus wires (BUS_H, BUS_L) and an output (3) for connection to the receiving input (Rx) of the microprocessor or microcontroller (21), and sending means (133) with an input (2) for connection to the sending output (Tx) of the microprocessor or microcontroller (21) and two outputs (11, 12) for connection to the two bus wires (BUS_H, BUS_L);
- means which, if there occurs a bus fault that compromises the normal communication via the two bus wires, are capable of adjusting and/or reconfiguring and/or adapting both the receiving means (120) and the sending means (133) for the best possibility that still exists for an emergency communication via the bus;
- bus fault recognition means (132) and bus fault evaluation means (144) for producing at least one error or interruption signal (ERR/INT) that can be transmitted to the microcontroller (21);
- bus cutoff commutation means (131) that cooperate with the bus fault recognition means (132), and which enable each of two cutoff elements (16, 17) that can be connected to two inputs (8, 9) of the transceiver means, to be connected to a bus wire (BUS_H, BUS_L associated therewith (16 to BUS_H, 17 to BUS_L).

57. Device according to any of Claims 37 to 39,
**characterised in that**
the essential parts of the device are accommodated in a mobile testing unit (PG), which can be connected (BL, TL, EL) on the one hand to a bus wire (BUS_H, BUS_L) and on the other hand to a terminal resistance in the electronic module and to the output of an output sending stage (133L, 133H) of the transceiver means of the electronic module.

58. Device according to Claim 57,
**characterised in that**
the device comprises a commutator (SWL, SWH), by means of which the one output stage (133H, 133L) of the sending means (130) of the electronic module (ECU) can be optionally connected with the at least one bus wire (BUS_H, BUS_L; BL) or with a corresponding control input of a replacement means (2019).

59. Device according to Claim 53,
**characterised in that**
the integrated semiconductor circuit is made in a high-voltage technology mode.

60. Device according to any of Claims 16 to 59,
**characterised in that**
it is built into or with one of the following:
- vehicles,
- control equipment for automation technology.

## Revendications

1. Procédé pour déterminer des décalages de potentiel entre des modules électroniques (ECU) dans un réseau à bus filaire, qui représentent des participants au bus ou qui sont associés à ceux-ci, ou pour déterminer la qualité de concordance de leurs niveaux d'exploitation de communication dans l'interconnexion de réseaux, le support de bus se composant d'au moins un fil (BUS H ; BUS L ; BUS H et BUS L), qui fait l'objet d'une liaison galvanique avec les modules électroniques (ECU), et les modules électroniques (ECU) étant en liaison réciproque par l'intermédiaire d'un rail de potentiel (GND) qui sert, au moins dans le cas d'un mode de fonctionnement à un seul fil du support de bus, comme rail de potentiel de référence pour la communication par bus, **caractérisé par** les étapes suivantes :
1/ un participant au bus qui, du point de vue physique et en ce qui concerne les défauts de potentiel possibles de manière spécifique au système, est capable de communiquer en tant que participant déficient potentiel avec chacun des autres participants au bus, est désigné comme participant d'essai,
2/ le participant d'essai émet au moins un message de bus pour placer tous les participants au bus à contrôler dans un mode d'exploitation "Ne pas émettre de messages d'utilisation",
3/ le participant d'essai émet au moins un message de bus pour placer tous les participants au bus à contrôler dans un mode d'exploitation "Réception seule, émission impossible" (RECEIVE ONLY), ceux-ci devenant ainsi des participants d'observation,
4/ le participant d'essai émet un message de bus pour placer parmi la quantité de participants d'observation un participant déterminé en tant que participant déficient dans le mode d'exploitation "Emettre et recevoir" (NORMAL),
5/ le participant d'essai émet de manière cyclique un message de contrôle,
6/ le participant déficient potentiel se trouvant dans le mode d'exploitation NORMAL valide le message de contrôle comme suit :
6.a/ si le participant déficient reçoit un message de contrôle sans erreur, le participant déficient émet en retour par l'intermédiaire du bus un récépissé de conformité au participant d'essai,
6.b/ si le participant déficient reçoit un message de contrôle avec une erreur, le participant déficient émet en retour par l'intermédiaire du bus un récépissé de non-conformité au participant d'essai,
6.c/ si le participant déficient ne reçoit pas de message de contrôle, le participant déficient n'émet pas de récépissé sur le bus,
7/ le participant d'essai interprète un récépissé de conformité comme état de vérité pour une absence d'erreur sur la transmission de données et un récépissé de non-conformité ou une absence de récépissé comme état de vérité pour la présence d'une erreur sur la transmission de données.
8/ le participant d'essai décale un premier niveau de source sur lequel est modulé de manière dominante le fil unique de bus utilisé pour le contrôle,
9/ le participant d'essai saisit la zone du décalage de potentiel du niveau de source unique indiqué, dans laquelle le message de contrôle est reçu sans erreur conformément aux étapes 6.a/ et 7/ et la zone du décalage de potentiel du niveau de source unique indiqué, dans laquelle le message de contrôle n'est pas reçu ou est reçu avec une erreur conformément aux étapes 6.b/ et 6/c.
10/ le participant d'essai impose, pour un fil de bus utilisé auparavant à titre de contrôle, un décalage de potentiel du niveau de source associé de manière dominante à ce fil de bus dans la zone dans laquelle la transmission de données d'essai était possible sans erreurs auparavant,
11/ après l'achèvement du contrôle d'un participant déficient, le participant d'essai émet un message de bus pour placer le participant déficient dans le mode de fonctionnement "Réception seule, émission impossible" (RECEIVE ONLY), celui-ci devenant de ce fait à nouveau un participant d'observation,
12/ les étapes 4/ à 11/ sont répétées pour tous les participants d'observation spécifiquement intéressants ou pour tous les participants d'observation,
13/ les résultats des contrôles sont exploités,
14/ le participant d'essai remet le réseau de bus dans son fonctionnement nominal.

2. Procédé selon la revendication 1, **caractérisé en ce que** les étapes 2/ et 3/ sont permutées entre elles.

3. Procédé selon la revendication 1, **caractérisé en ce que** les étapes 13/ et 14/ sont permutées entre elles.

4. Procédé selon la revendication 1, **caractérisé en ce que** les étapes 5/ à 9/ ont lieu simultanément.

5. Procédé selon la revendication 1, **caractérisé en ce que** le décalage de l'unique niveau de source selon l'étape 8/ a lieu sous forme linéaire dans le temps.

6. Procédé selon la revendication 1, **caractérisé en ce que** le décalage de l'unique niveau de source selon l'étape 8/ a lieu pas à pas en mode monotone.

7. Procédé selon la revendication 1, **caractérisé en ce que** le décalage du premier niveau de source selon l'étape 8/ a lieu en alternance avec le décalage d'un autre deuxième niveau de source en fonction d'un modèle de pas de décalage prédéterminé.

8. Procédé selon la revendication 1, **caractérisé par** l'étape supplémentaire
15.a/ le participant d'essai émet après l'étape 1/ et avant l'étape 4/ un message de bus pour placer un participant au bus à appeler en tant que participant déficient dans un mode de fonctionnement "Courants de charge des participants connectés".

9. Procédé selon la revendication 1, **caractérisé par** l'étape supplémentaire
15.b/ le participant d'essai émet après l'étape 1/ et avant l'étape 4/ un message de bus pour placer tous les participants au bus dans un mode de fonctionnement "Courants de charge des participants connectés".

10. Procédé selon l'une quelconque des revendications 1 à 9, **caractérisé par** l'étape supplémentaire
16/ lors de toutes les étapes qui suivent l'étape 1/ jusqu'à l'étape 4/ pour l'émission d'un message de bus, le participant d'essai décale un niveau de source sur lequel le fil de bus unique utilisé pour la communication est modulé de manière dominante.

11. Procédé selon la revendication 1, **caractérisé**
- **en ce que** le participant d'essai est un participant au bus qui est raccordé en permanence au bus et
- **en ce que** le procédé est réalisé par ce participant au bus après chaque nouvelle mise en service du réseau de bus comme étant soumis au fonctionnement normal du bus par rapport à tous les participants au bus.

12. Procédé selon la revendication 11, **caractérisé en ce que** les résultats d'exploitation obtenus à l'occasion du contrôle de tous les participants au bus après chaque mise en service du réseau de bus sont mémorisés dans le participant d'essai ou dans un participant au bus que celui-ci peut sélectionner.

13. Procédé selon la revendication 1, **caractérisé en ce que** le réseau de bus filaire est un réseau de bus bifilaire.

14. Procédé selon la revendication 13, **caractérisé en ce que** pour réaliser les contrôles, le participant d'essai active les deux fils de bus.

15. Procédé selon la revendication 14, **caractérisé en ce que** l'étape 8/ avec l'étape 5/ a lieu temporairement pas à pas avec un enchaînement avec les messages et que chaque message de contrôle reçoit un chiffre espéré pour le participant déficient à contrôler.

16. Procédé selon la revendication 15, **caractérisé en ce que** l'enchaînement est basé sur des blocs de bits.

17. Dispositif pour déterminer des décalages de potentiel entre des modules électroniques (ECU) dans un réseau à bus filaire, qui représentent des participants au bus ou qui sont associés à ceux-ci, ou pour déterminer la qualité de concordance de leurs niveaux d'exploitation de communication dans l'interconnexion de réseaux, avec lequel le support de bus se compose d'au moins un fil (BUS H ; BUS L ; BUS H et BUS L) alors que les modules électroniques (ECU) font l'objet d'une liaison galvanique avec le support de bus et sont par ailleurs en liaison réciproque par l'intermédiaire d'un rail de potentiel (GND) qui, dans le cas d'un mode de fonctionnement à un seul fil du support de bus, sert de rail de potentiel de référence (GND) pour la communication par bus, et avec lequel chaque module électronique (ECU) comprend un microprocesseur ou un microcontrôleur (21) ainsi que des moyens émetteurs-récepteurs (100, 100') pour réaliser un couplage d'émission et de réception du microprocesseur ou du microcontrôleur (21) au support de bus, **caractérisé**
- **en ce qu'**il est muni de moyens pour la réalisation des étapes d'un procédé selon la revendication 1,
- **en ce qu'**en tant que partie constituante des moyens émetteurs-récepteurs (100, 100') il comprend des moyens pour le verrouillage des moyens d'émission lors du fonctionnement en réception (RECEIVE ONLY) ainsi que des moyens de commande du potentiel coopératifs (199A ; 199 ; 199' ; 199.1, 1991), qui sont en liaison avec le microprocesseur ou avec le microcontrôleur (21) et qui sont ou peuvent être reliés (195, 195' ; 166.5 ; 266) avec des moyens émetteurs-récepteurs (100, 100') et
- **en ce qu'**il met en oeuvre avec ceux-ci, par rapport à des parties des moyens d'émission et/ou de réception (130 et/ou 120, 120' ; 120") des moyens émetteurs-récepteurs (100, 100'), une source de tension (Q_{SG} ; Q_{SL} ; Q_{SH} ; Q_{SHH} ; Q_{VCC} ; Q_{Ua} ; V_{TH} ; V_{TL} ; 121.7 ; 1301, 1302) pouvant être commandée (266, 266' ; 166.5, 195), qui permet d'influencer un niveau de source dominant en cas d'émission et/ou un niveau de signal discriminant en cas de réception.

18. Dispositif selon la revendication 17, **caractérisé en ce que** les moyens de commande du potentiel (199A ; 199, 199') peuvent faire l'objet d'une activation digitale par un microprocesseur ou par un microcontrôleur (21).

19. Dispositif selon la revendication 17, **caractérisé en ce que** les moyens de commande du potentiel (199A ; 199, 199') sont constitués de telle façon que lors de l'émission un niveau de source, qui détermine l'état dominant sur le fil de bus correspondant (BUS_H, BUS_L), peut être déplacé en mode monotone incrémentiel, décrémentiel ou incrémentiel et décrémentiel.

20. Dispositif selon la revendication 17, **caractérisé en ce que**, dans le cas d'une possibilité s'exercer une influence sur deux niveaux de source dominants en cas d'émission, les deux peuvent être réglés ou modifiés indépendamment l'un de l'autre.

21. Dispositif selon la revendication 17, **caractérisé en ce que** deux niveaux de source dominants en cas d'émission peuvent être réglés ou déplacés de telle manière que l'espacement entre les deux niveaux est alors sensiblement maintenu.

22. Dispositif selon la revendication 17, **caractérisé en ce qu'**il comprend une connexion dédiée aux signaux (13 ; GND) en tant que rail de potentiel de référence des moyens de réception (120, 120', 120") des moyens émetteurs-récepteurs (100, 100').

23. Dispositif selon la revendication 17, **caractérisé en ce qu'**il comprend une connexion particulière (13.1, système GND, 218) comme rail de potentiel de référence des moyens (199A ; 199, 199') pour le réglage ou la modification lors de l'émission d'un des deux niveaux de source dominants.

24. Dispositif selon la revendication 17, **caractérisé en ce qu'**il comprend une connexion particulière (13.2, Remote GND/Sense, 217), par l'intermédiaire de laquelle les moyens de commande du potentiel (199A ; 199, 199') peuvent faire l'objet d'une liaison active (196 ; 217) avec un potentiel de référence (Remote GND, Sensé, Reference) dans le champ ambiant du module électronique portant les moyens émetteurs-récepteurs (100, 100').

25. Dispositif selon la revendication 24, **caractérisé en ce que**, dans le trajet de la liaison active mentionnée, il comprend des moyens de protection (198) contre les surtensions et/ou contre les inversions de polarité et/ou contre l'introduction de signaux à haute fréquence.

26. Dispositif selon la revendication 17, **caractérisé en ce qu'**il réalise une source de tension de décalage (Q_{SG}) réglable rebouclée dans la connexion d'alimentation proche du potentiel de référence des moyens d'émission (133 ; 133L, 133H) et assure une alimentation en tension constante (20 ; CD) des moyens d'émission (133 ; 133L, 133H).

27. Dispositif selon la revendication 26, **caractérisé en ce que** des parties agissant de manière analogue des moyens de réception (120', 120" ; 121.20) sont branchées en parallèle (20 ; CD) en ce qui concerne l'alimentation électrique avec les moyens d'émission (133 ; 133L, 133H) alimentés en tension constante et **en ce que** de ce fait la source de tension de décalage indiquée (Q_{SG}) est ainsi aussi active du côté de la réception.

28. Dispositif selon la revendication 17, **caractérisé en ce qu'**il réalise une première source de tension de décalage (Q_{SL}) réglable rebouclée dans la connexion d'alimentation proche du potentiel de référence de l'étage final de connexion (133L) des moyens d'émission (133) activant le fil de bus BUS_L et une deuxième source de tension de décalage (Q_{SH}) réglable rebouclée dans une connexion d'alimentation opposée en potentiel de l'étage final de connexion (133H) des moyens d'émission (133) activant le fil de bus BUS_H.

29. Dispositif selon la revendication 17, **caractérisé en ce qu'**il réalise une première source de tension de décalage (Q_{SL}) réglable rebouclée dans la connexion d'alimentation proche du potentiel de référence de l'étage final de connexion (133L) des moyens d'émission (133) activant le fil de bus BUS_L et une deuxième et une troisième sources de tension de décalage (Q_{SH}, Q_{SHH}) réglables rebouclées dans une connexion d'alimentation opposée en potentiel de l'étage final de connexion (133H) des moyens d'émission (133) activant le fil de bus BUS_H, ces dernières étant rapportées à des potentiels d'alimentation de valeurs différentes ou étant raccordées à des potentiels de valeurs différentes.

30. Dispositif selon la revendication 29, **caractérisé en ce que** la deuxième et la troisième sources de tension de décalage (Q_{SH}, Q_{SHH}) peuvent être activées en variante.

31. Dispositif selon la revendication 28 ou 30, **caractérisé en ce que** la source de tension de décalage (Q_{SL}) se rapportant au potentiel de référence et la source de tension de décalage (Q_{SH}, Q_{SHH}) active éloignée du potentiel de référence ne peuvent être activées que successivement et en alternance.

32. Dispositif selon la revendication 29, **caractérisé en ce qu'**il comprend des moyens (199.5, 199.7, 199.8, 199.2X) qui permettent une activation de la deuxième et de la troisième sources de tension de décalage (Q_{SH} et Q_{SHH}) en fonction du signal d'émission (TxD).

33. Dispositif selon l'une quelconque des revendications 26 à 32, **caractérisé en ce que** les moyens de commande du potentiel (199, 199') comprennent des moyens pour une modification autonome (199.7 en liaison avec 199.2 ; 199.2X) du réglage dans le temps d'une source de tension de décalage (Q_{SG}, Q_{SL}, Q_{SH}, Q_{SHH}).

34. Dispositif selon la revendication 33, **caractérisé en ce que** cette modification est possible en fonction du signal de données du côté émission (TxD).

35. Dispositif selon la revendication 33, **caractérisé en ce qu'**aux moyens pour la modification autonome du réglage d'une source de tension de décalage (Q_{SG}, Q_{SL}, Q_{SH}, Q_{SHH}) peut être amené un signal d'horloge ((SPI CLOCK) pouvant être prélevé (201.1 ; 166, 166.5, 199.1) sur le microprocesseur ou sur le microcontrôleur (21).

36. Dispositif selon la revendication 17 ou 19, **caractérisé en ce que** les moyens de commande du potentiel (199A ; 199, 199') comprennent des moyens de régulation permettant de réaliser la commande du potentiel en fonction d'une consigne de valeur pouvant être prélevée dans le microprocesseur ou dans le microcontrôleur (21) sur la base d'un potentiel (U_{BUS_H}, U_{BUS_L}) pouvant être prélevé sur un fil de bus (BUS_H, BUS_L).

37. Dispositif selon la revendication 17 ou 19, **caractérisé en ce qu'**il comprend, indépendamment des moyens d'émission (133 ; 133H, 133L), des moyens de remplacement (2019, RL', DL') reliés ou pouvant être reliés à un fil de bus (BUS_H, BUS_L), qui permettent une commutation modulée par le signal d'émission (TxD) sur l'au moins un fil de bus (BUS_H, BUS_L) d'un potentiel régulé (Ua).

38. Dispositif selon la revendication 37, **caractérisé en ce qu'**il comprend des moyens de mesure (1991EL), qui réalisent la saisie d'une valeur d'erreur (U_{ERR}) provoquée par les moyens de remplacement (2019, RL', DL') dans le but de la compenser par une commutation de régulation (2010L') ou par une prise en compte par le calcul (2022 ; 21) lors de la détermination de la valeur de consigne (166.5, 199.21 ;) pour la régulation (Ua) par le microprocesseur ou par le microcontrôleur (21).

39. Dispositif selon la revendication 17 ou 19, **caractérisé en ce qu'**il comprend, indépendamment des moyens d'émission (133 ; 133H, 133L), des moyens de remplacement (2019, RL', DL') reliés ou pouvant être reliés à un fil de bus (BUS_L), qui permettent une commutation modulée par le signal d'émission (TxD) sur le fil de bus (BUS_L) d'un potentiel non régulé (Ua), et ceci en fonction d'une valeur digitale pouvant être imposée (201.1, 166, 166.5, 199.2) par le microprocesseur ou par le microcontrôleur (21).

40. Dispositif selon l'une quelconque des revendications 37 à 39, **caractérisé en ce que**, pour la commande de conduction de l'un des moyens de remplacement (2019), le signal d'émission (TxD) peut être amené à celui-ci par l'étage final de brin correspondant (133L) par l'intermédiaire d'un commutateur (SWL), qui sépare l'étage final (133L) du fil de bus (BUS_L).

41. Dispositif selon la revendication 36, **caractérisé en ce que** les moyens de régulation comprennent un échantillonneur (2015) faisant l'objet d'une liaison active (2018) avec un fil de bus (BUS_H, BUS_L) et un élément de maintien ou un régulateur assurant un maintien (1991H).

42. Dispositif selon la revendication 41, **caractérisé en ce que**, dans le cas de l'échantillonneur (2015), il s'agit d'un échantillonneur avec deux trajets de diodes (DS1, DS2), le deuxième trajet de diodes (DS2) étant prévu pour la compensation d'influences de températures et/ou d'une tension d'erreur due au flux de courant de balayage le long du premier trajet de diodes (DS1).

43. Dispositif selon la revendication 17, **caractérisé en ce que** les moyens de commande du potentiel (199, 1991) sont configurés de telle manière qu'ils permettent d'exercer une influence sur un niveau de signal récessivement discriminant en influençant (121.4, 121.5 ; CVTH, CVTL) une tension de seuil (VT_{H}, VT_{L}) dans le récepteur (120").

44. Dispositif selon la revendication 17, **caractérisé en ce qu'**il comprend pour les moyens de réception (120") des moyens (121.4, 121.5) se rapportant à un rail de potentiel de référence (FTG ; 121.13) pour imposer deux valeurs de seuil (VT_{H}, VT_{L}) et **en ce que** ce rail de potentiel de référence fait l'objet d'une liaison active avec une connexion de potentiel de référence ou peut au choix être relié de manière active (57) avec au moins deux connexions de potentiels de référence en variante (13, 13.1, 13.2) du module électronique.

45. Dispositif selon la revendication 17, **caractérisé en ce que** la prise d'influence est possible par une source de tension de décalage réglable (Q_{SG} : 121.7) se trouvant dans le trajet de courant d'alimentation (DG : base 121.15 -> 195.5)) proche du potentiel de référence (GND) de parties des moyens de réception (120" ; 121.1, 121.2, 121.3 ; 121.20) agissant de manière analogue.

46. Dispositif selon les revendications 44 et 45, **caractérisé en ce que** le rail de potentiel de référence (FTG ; 121.13) des moyens de production de la valeur de seuil (121.4, 121.5) peut être relié (S₆) à la base d'alimentation (121.15) proche du potentiel de référence (GND) des parties agissant de manière analogue (121.10) des moyens de réception (120").

47. Dispositif selon la revendication 17, **caractérisé en ce que** les moyens de réception (120") comprennent des moyens de discrimination de niveaux (121.1, 121.2, 121.3) se rapportant à une base d'alimentation (121.15) et en cc que cette base d'alimentation fait l'objet d'une liaison active avec une connexion de potentiel de référence ou peut au choix faire l'objet d'une liaison active (S8) avec deux connexions de potentiels de référence en alternance (13, 13.1, 13.2) du module électronique.

48. Dispositif selon la revendication 17, **caractérisé en ce qu'**il comprend des moyens de conversion dans le sens digital/analogique (199.2, 199.2X) et/ou des moyens de conversion dans le sens analogique/digital (199.3).

49. Dispositif selon la revendication 17, **caractérisé en ce qu'**il comprend des moyens de conversion dans le sens digital/analogique (199.2X), qui peuvent produire toutes les valeurs de référence et tous les signaux de commande et de commutation pour les influences sur le potentiel à exercer éventuellement dans le mode d'émission et/ou de réception des moyens émetteurs-récepteurs (100').

50. Dispositif selon l'une quelconque des revendications 28 à 33 ou selon la revendication 35, **caractérisé en ce qu'**une source de tension de décalage (Q_{SH} ou Q_{SHH}) se rapportant à un potentiel d'alimentation plus élevé (VCC_{A}, V_{T}, VBATT) est remplacée par une source de tension d'alimentation variable capable de décalage correspondant (Q_{VCC'}) se rapportant à un potentiel d'alimentation plus faible (GND).

51. Dispositif selon la revendication 17, **caractérisé en ce qu'**il est une partie constituante d'un module électronique qui est conçu, commutable ou activable (142, 157, 172/SWM) pour une réception à seulement un fil et/ou pour un mode d'émission à seulement un fil.

52. Dispositif selon la revendication 17, **caractérisé en ce que** le module électronique est un circuit intégré à semi-conducteurs.

53. Dispositif selon la revendication 17, **caractérisé en ce qu'**il est une partie constituante d'un circuit intégré à semi-conducteurs qui, en dehors du dispositif, porte les moyens indiqués (100, 100') pour la réalisation des moyens émetteurs-récepteurs pour le microprocesseur ou pour le microcontrôleur (21) sur le support de bus.

54. Dispositif selon la revendication 53, **caractérisé en ce que** les moyens émetteurs-récepteurs (100, 100') coopérant avec le dispositif sont conçus pour une communication selon le standard CAN et pour une connexion à un réseau de ligne de bus CAN (CAN_H/CAN_L).

55. Dispositif selon la revendication 53, **caractérisé**
**en ce que** les moyens émetteurs-récepteurs comprennent :
- des moyens de réception (120, 120', 120") avec une entrée (11, 12) pour le raccordement d'un fil de bus (BUS-H, BUS_L) et avec une sortie (3) pour le raccordement à l'entrée de réception (Rx) du microprocesseur ou du microcontrôleur (21) et
- des moyens d'émission (130 ; 133 ; 133H, 133L) avec une entrée (2) pour le raccordement à la sortie d'émission (Tx) du microprocesseur ou du microcontrôleur (21) et avec une sortie (11, 12) pour le raccordement à un fil de bus (BUS-H, BUS_L),
**en ce que** les moyens émetteurs-récepteurs peuvent être utilisés dans les deux modes de fonctionnement différents, c'est-à-dire
- "Emission et réception : NORMAL",
- "Pas d'émission - seulement réception / RECEIVE ONLY"
et **en ce qu'**il comprend un port d'entrée (6, 5 ; 201, 201.1, 166) pour la réception d'un signal de sélection du microprocesseur ou du microcontrôleur (21) pour la sélection d'un de ces deux modes de fonctionnement.

56. Dispositif selon la revendication 53, **caractérisé en ce que** les moyens émetteurs-récepteurs comprennent :
- des moyens de réception (120, 120', 120") avec deux entrées pour le raccordement aux deux fils de bus (BUS-H, BUS_L) et une sortie (3) pour le raccordement à l'entrée de réception (Rx) du microprocesseur ou du microcontrôleur (21) et des moyens d'émission (133) avec une entrée (2) pour le raccordement à la sortie d'émission (Tx) du microprocesseur ou du microcontrôleur (21) et deux sorties (11, 12) pour le raccordement aux deux fils de bus (BUS-H, BUS_L) ;
- des moyens qui, en cas d'apparition d'une erreur de bus dégradant le mode de communication normal par l'intermédiaire des deux fils de bus, permettent par l'intermédiaire du bus de régler, et/ou de reconfigurer et/ou d'adapter aussi bien les moyens de réception (120) que les moyens d'émission (133) à la meilleure possibilité de communication de secours qui existe encore ;
- des moyens de reconnaissance des erreurs de bus (132) et des moyens d'exploitation des erreurs de bus (144) pour la préparation d'au moins un signal d'erreur ou d'interruption (ERR/INT) pouvant être transmis (4 ; 24) au microcontrôleur (21) et
- des moyens de commutation de clôture de bus (131) coopérant avec les moyens de reconnaissance des erreurs de bus (132), qui permettent de commuter chacun de deux éléments de clôture (16, 17) pouvant être raccordés à deux entrées (8, 9) des moyens émetteurs-récepteurs à un fil de bus (BUS-H, BUS_L) qui lui est associé (16 commuté sur le BUS-H, 17 commuté sur le BUS_L).

57. Dispositif selon l'une quelconque des revendications 37 à 39, **caractérisé en ce que** les pièces essentielles du dispositif sont disposées dans un équipement de contrôle mobile (PG), qui peut être relié (BL, TL, EL) d'une part avec un fil de bus (BUS-H, BUS_L) et d'autre part avec une résistance terminale dans le module électronique et la sortie d'un étage terminal d'émission (133L, 133 H) des moyens émetteurs-récepteurs du module électronique.

58. Dispositif selon la revendication 57, **caractérisé en ce que** le dispositif comprend un commutateur (SWL, SWH) , à l'aide duquel l'un des étages terminaux (133H, 133L) des moyens d'émission (130) du module électronique (ECU) peut être relié au choix avec l'au moins un fil de bus (BUS-H, BUS_L ; BL) ou avec une entrée d'activation correspondante d'un moyen de remplacement (2019).

59. Dispositif selon la revendication 53, **caractérisé en ce que** le circuit intégré à semi-conducteurs est réalisé avec une technologie à haut voltage.

60. Dispositif selon l'une quelconque des revendications 16 à 59, **caractérisé en ce qu'**il est réalisé dans l'un des domaines suivants :
- moyens de transport
- équipement de commande dans les systèmes d'automatisation.
